# EUROPEAN PATENT APPLICATION

(11) **EP 4 521 062 A1**
(43) Date of publication of application: **12.03.2025**
(21) Application number: 23209793.1
(22) Date of filing: 14.11.2023
(51) Int. Cl.: G01C 15/00, G01C 21/00, G06Q 50/16

(54) **AUTOMATED GENERATION OF BUILDING FLOOR PLANS HAVING ASSOCIATED ABSOLUTE LOCATIONS USING COORDINATION OF MULTIPLE DATA SETS**

(30) Priority: 07.09.2023 US 202318243652
(71) Applicant: MFTB Holdco, Inc., Seattle, Washington 98101 (US)
(72) Inventor: NARAYANA, Manjunath, Chino Hills, 91709 (US); KIM, Yongjoon, Minneapolis, 55414 (US); CIER, Sean P., Ravensdale, 98051 (US); KANG, Sing Bing, Redmond, 98052 (US)
(74) Representative: Reddie & Grose LLP

(57) **Abstract**

Techniques are described for using data capture devices at a building to automatically generate a building floor plan and to determine associated absolute location data for the generated floor plan, such as by associating separately captured GPS data or other absolute location data with the floor plan. In some situations, a building floor plan is automatically generated by analyzing visual data of images captured at multiple image acquisition locations by a camera device to determine room shapes of surrounding rooms, and GPS absolute location data is associated with the generated floor plan using additional data captured at other data capture locations at the building by a separate mobile device that moves independently from the camera device, such as by extending the absolute location data from the mobile device to the camera device's image acquisition location and its surrounding room shape.

## Description

### TECHNICAL FIELD

The following disclosure relates generally to techniques for automatically generating building floor plans and determining associated absolute locations for them based at least in part on mapping images captured in building interiors to location data captured separately from the images, and for subsequently using the generated building floor plan information in one or more manners, such as to improve navigation of the building.

### BACKGROUND

In various fields and circumstances, such as architectural analysis, property inspection, real estate acquisition and development, remodeling and improvement services, general contracting and other circumstances, it may be desirable to view information about the interior of a house, office, or other building without having to physically travel to and enter the building, including to determine actual as-built information about the building rather than design information from before the building is constructed. However, it can be difficult to effectively capture, represent and use such building interior information, including to display visual information captured within building interiors to users at remote locations (e.g., to enable a user to fully understand the layout and other details of the interior, including to control the display in a user-selected manner). In addition, while a floor plan of a building may provide some information about layout and other details of a building interior, such use of floor plans has some drawbacks in certain situations, including that floor plans can be difficult to construct and maintain, to accurately scale and populate with information about room interiors, to visualize and otherwise use (including in relation to its surroundings), etc.

### BRIEF DESCRIPTION OF THE DRAWINGS

Figure 1 includes a diagram depicting an exemplary building interior environment and computing system(s) for use in embodiments of the present disclosure, including to generate and present information representing an interior of the building.
Figures 2A-2V illustrate examples of automated operations for generating and presenting floor plan information for a building based on images taken in the building interior and additional captured data, such as to automatically determine and use absolute acquisition locations of such images.
Figure 3 is a block diagram illustrating a computing system suitable for executing an embodiment of a system that performs at least some of the techniques described in the present disclosure.
Figures 4A-4B illustrate an example embodiment of a flow diagram for a Building Floor Plan Generator and Location Determiner and Presenter (BFPGLDP) system routine in accordance with an embodiment of the present disclosure.
Figure 5 illustrates an example embodiment of a flow diagram for an Image/Data Capture and Analysis (IDCA) system routine in accordance with an embodiment of the present disclosure.
Figures 6A-6B illustrate an example embodiment of a flow diagram for a Mapping Information Generation Manager (MIGM) system routine in accordance with an embodiment of the present disclosure.
Figures 7A-7B illustrate an example embodiment of a flow diagram for a Building Information Viewer system routine in accordance with an embodiment of the present disclosure.

### DETAILED DESCRIPTION

The present disclosure describes techniques for using computing devices to perform automated operations related to automatically generating building floor plans using visual data of in-building images, determining associated absolute locations for the generated floor plans based at least in part on mapping the images to absolute location data captured separately from the images and then extending the absolute location data associated with the images to the surrounding building floor plan structural elements visible in the images, presenting the building floor plans using surrounding real-world data for the associated absolute locations of the building floor plans, and in some cases subsequently using the generated building floor plan information in one or more additional manners, such as to further improve navigation of a building and/or its surroundings. In at least some embodiments, the described techniques include automatically generating a building floor plan based at least in part on analyzing visual data of images captured at multiple image acquisition locations in a building by a camera device to determine room shapes of the rooms surrounding the image acquisition locations, and automatically determining and associating GPS (Global Positioning System) location data or other absolute location data with the generated floor plan based at least in part on additional data captured at other data capture locations at the building (*e.g.,* by a separate mobile data capturing device that moves independently from the camera device), such as to extend the absolute location data from other data capture locations to the image acquisition locations of the camera device and the associated surrounding room shapes. The images may, for example, include panorama images or other images (*e.g.,* rectilinear perspective images) that are acquired at image acquisition locations in or around a multi-room building (*e.g.,* a house, office, etc.) by one or more camera devices, referred to generally herein as 'target images'. Additional details are included below regarding the automated determination and use of acquisition location information for building images to determine associated absolute locations of a resulting generated floor plan for the building, and presentation and other use of the resulting generated floor plans, and some or all of the techniques described herein may be performed via automated operations of a Building Floor Plan Generator and Location Determiner and Presenter ("BFPGLDP") system in at least some embodiments, as discussed further below.

As noted above, target images and/or other acquired data for a building may be analyzed to generate a floor plan model and/or other mapping information for the building (*e.g.,* a two-dimensional model of the building's interior without wall height data, such as an orthographic overhead or top view; a three-dimensional model of the building's interior; a linked group of target images with pairwise inter-image directional information; etc.) in at least some embodiments, such as by using visual data and determined acquisition locations of acquired images to identify structural elements such as walls and doorways and windows and non-doorway wall openings, to determine the relative position of each image's acquisition location to such identified structural elements (*e.g.,* within a local coordinate system for that image), to determine room shapes based on the identified structural elements and to identify each image's acquisition location within one of the room shapes (*e.g.,* within a local coordinate system for that room), and to position such room shapes relative to each other to form at least a partial floor plan in a common local coordinate system for the floor plan, or to otherwise determine relative positions of acquisition locations of images without such a floor plan based at least in part on visual overlap between the images' visual data - in at least some such embodiments, the automated analysis and use of acquired images and/or other data is further performed without having or using any acquired depth data from any depth sensors or other distance-measuring devices about distances from an acquisition location to walls or other objects in the surrounding building, while in other embodiments such depth data may be acquired and used. Such generated floor plans and/or other mapping information may be further used in various manners in various embodiments, such as for controlling navigation of mobile devices (*e.g.,* autonomous vehicles), for display or other presentation on one or more client devices in corresponding GUIs (graphical user interfaces), etc. Additional details are included below related to generation of a floor plan for a building using acquired images for the building and optionally other acquired data for the building.

As noted above, automated operations of the BFPGLDP system may include automatically mapping target images (*e.g.,* target panorama images) acquired at a building (*e.g.,* in one or more rooms or other defined areas) to other absolute location data acquired at the building separately from the acquisition of the images, and using such mappings to determine associated absolute locations for a floor plan generated from the target images, such as to enable GPS location data or other absolute location data acquired at one or more other data capture locations at the building to be extended to an image acquisition location of the camera device when acquiring one or more target images and further to other locations around that image acquisition location that are determined at least in part from analysis of visual data of the one or more target images (*e.g.,* locations of a room shape of a surrounding room, such as locations of at least walls of that room). The absolute location data for a data capture location may have various forms and may be determined in various manners in various embodiments, with non-exclusive examples including acquiring absolute GPS location data for the capturing device from one or more GPS receivers on the capturing device and/or receiving or determining the absolute location data in other manners (*e.g.,* via other wireless transmissions, such as Bluetooth, NFC, etc.; via determined relative positions to other nearby objects with known absolute locations; using motion data for the capturing device from a known location, such as from one or more IMU (inertial measurement unit) sensors on the capturing device; etc.), as well as acquiring and using geographical directional data in some embodiments and situations (*e.g.,* from a compass sensor on the capturing device). While the mobile capturing device is referred to in the singular at times herein, it will be appreciated that multiple mobile capturing devices may be used in some embodiments and situations for a given building, such as different mobile devices that capture absolute location data at different times (*e.g.,* during different data acquisition sessions) and/or at different data capture locations (whether in the same or different rooms or other defined areas as one or more other mobile capturing devices) and/or of different types. In addition, such a mobile capturing device may have various forms in various embodiments, including as a mobile computing device (*e.g.,* a smart phone, a tablet or laptop computer, etc.) that includes computing capabilities and that may be used to perform at least some of the automated operations.

The determination of the position of an image acquisition location at which an image acquisition device acquires one or more target images based on other absolute location data of a mobile capturing device may be performed in various manners in various embodiments. In at least some embodiments and situations, GPS data or other absolute location data is acquired at multiple times (*e.g.,* periodically, substantially continuously, etc.) by a mobile capturing device separate from a camera or other image acquisition device that captures one or more target images at an image acquisition location, but that may be in proximity to the image acquisition device (*e.g.,* in the same room, carried by the same user, within a threshold distance, etc.) - in other embodiments and situations, some or all such absolute location data may instead be obtained by the image acquisition device but separately from the image acquisition activities and not directly associated with the acquired target images at the time of acquisition. In addition, for each of some or all such captured target images, the image acquisition device and/or other associated analysis device(s) may provide additional data, such as to in some embodiments and situations provide a linear stream of image acquisition events - non-exclusive examples of other data that may optionally be associated with each of some or all events and their associated target images include pose data for the image acquisition device and corresponding resulting target image acquired for that event, objects detected in visual data of the target image, metadata of one or more types for the target image acquisition (*e.g.,* model and/or type of the image acquisition device, type and/or version of software used on the image acquisition device, etc.), operator user actions associated with the target image acquisition, a location of the target image within a room shape or otherwise within a floor plan in a local coordinate system for that room shape or floor plan, etc. In some embodiments and situations, the mapping of the GPS data and/or other absolute location data to an acquired target image includes determining a time associated with the image acquisition (*e.g.,* from the event data associated with the image acquisition), and selecting or otherwise determining a GPS data point or other absolute location data point to initially inexactly represent the image's acquisition location - the determination of such a representative absolute location data point may, for example, include determining a centroid or other average of multiple absolute location data points that are obtained in a time window around the time of image acquisition (optionally weighted by time difference from the image acquisition time and/or by one or more other attributes), or selecting a single best representative absolute location data point from multiple absolute location data points that are obtained in a time window around the time of image acquisition (*e.g.,* a representative absolute location data point having a closest time before and/or after the image acquisition time), etc. After each of multiple target images captured at multiple acquisition locations for a building is initially associated with a GPS data point or other absolute location data point, the techniques may include further estimating a global best-fit transformation between the set of acquisition locations of the target images as represented in a common local coordinate system for a resulting generated floor plan, and their associated determined absolute location data points, such as by converting each absolute location data point to a location in the floor plan's local coordinate system, and performing one or more algorithms to determine a best-match rigid transformation between pairs of absolute location data points and local coordinate system data points, such as using the Kabsch algorithm and/or the Quaternion estimator algorithm and/or another algorithm that solves Wahba's problem - if compass heading information is further available for the captured target image's and/or the absolute location data points, the techniques may further use the heading information to estimate the orientation of target images individually in addition to a global orientation of the floor plan. In some embodiments and situations, the determining of the global transformation includes at least the following:
- Convert each representative GPS data point with a format of (latitude, longitude) to a format of (X, Y) in the local coordinate system of the floor plan;
- Let N be the number of target images. Then we have N of {(X_i, Y_i), (x_i, y_i)} pairs, i = 1, ..., N, where (X_i, Y_i) is an estimated target image location in the local coordinate system of the floor plan, and (x_i, y_1) in an absolute location data point (*e.g.,* latitude, longitude) associated with that estimated target image location; and
- Estimate the rigid transformation using N of {(X_i, Y_i), (x_i, y_i)} pairs by one or more of several approaches, such as those discussed above.

In addition, the determination of such a rigid transformation or other global transformation between image acquisition locations in local coordinates for a floor plan and associated absolute location data points may include additional operations in some embodiments and situations. For example, the acquired GPS data points or other absolute location data points may be processed before they are initially associated with target images, such as by performing smoothing operations to reduce noisy data (*e.g.,* eliminate or discount outliers). In addition, after an initial determination of an absolute location data point to be associated with a target image and after any optional smoothing or other initial processing is performed, additional processing may be performed to refine the resulting initial rigid transformation, such as using iterative closest point (ICP) or other refinement techniques to improve the rigid transformation determination - for example, doing so may include preparing two sets of location data points (*e.g.,* a first set of GPS absolute location data points captured near the time of acquisition of target images, such as within a time window, and a second set of estimated target image acquisition location data points within a local coordinate system of the floor plan for the building, such as by applying the initial rigid transformation before the refining to each target image), matching each local coordinate location data point in the second set to the nearest absolute location data point in the first set, estimating the rigid transformation between the matched data points, and iterating the matching and estimating operations to further refine the rigid transformation until one or more ending criteria are satisfied. In addition, whether in addition to or instead of the smoothing or other initial processing and/or the refining, other additional operations may include one or more of the following: using first and second sets of location data points as described above to perform point-set registration techniques to find the best global transformation; using a variety of types of data as input to a trained deep learning system that outputs a global transformation, such as input data that includes some or all of the types of data discussed above with respect to the initial rigid transformation determination in combination with additional data such as one or more of the entire floorplan shape, room shapes, positions of doorways and/or windows and/or non-doorway wall openings, etc.; using detected motion trajectory information for the separate data capturing device(s) to align captured absolute location data with doorways and/or external structure of a building, such as to determine an absolute location of an external doorway based on identifying a transition from outside a building to inside a building (*e.g.,* from analysis of visual data being captured, from an input of a human operator at a time of the transition, etc.) and selecting associated absolute location data for that time, to detect and align linear exterior motion with external walkways or a driveway, etc.; using additional human operator activity data to improve GPS signal quality, such as to have a human operator user explicitly capture GPS absolute location data at an external doorway to have a better baseline for interior locations that may have less accurate GPS data, to have the human operator user trace some or all of the outer boundary of a building to enable matching the shape of the generated floor plan to that boundary, to have the human operator user trace a specified external pattern before entering a building to improve GPS signal calibration for subsequent in-building GPS data points, etc.; using input from one or more human operators to provide an initial estimate of the absolute data locations for some or all target images and/or of the initial rigid transformation, and/or to provide a refinement of a determined rigid transformation and/or to provide a refinement of determined absolute location data for a floorplan; etc. Additional details are included below related to mapping images acquired at a building to absolute location data captured at the building separately from the images, and to types of captured additional data and mobile capturing devices.

As noted above, automated operations of the BFPGLDP system may further include automatically presenting a building floor plan having associated absolute location data using surrounding real-world data for the associated absolute location(s) of the building floor plan. As one non-exclusive example, a map of a surrounding area for a building having a generated floor plan with associated absolute location data may be displayed at various levels of zoom, with a 2D (two-dimensional) or 3D (three-dimensional) floor plan model of the building shown on the map at the absolute location(s) determined for that floor plan - in such embodiments, as the level of zoom increases and the available space on the screen for the floor plan permits, various internal aspects of the building may be displayed on the floor plan, such as walls, doorways, non-doorway wall openings, stairways, windows, fixtures (*e.g.,* light and plumbing fixtures), built-in and installed elements (*e.g.,* islands, fireplaces, cabinets, counters, etc.), appliances, furniture, etc., including to show different types of internal aspects at different zoom levels (*e.g.,* just structural aspects at one zoom level, adding additional internal aspects of one or more types at each of one or more additional zoom levels, etc.), and including to optionally use different colors, patterns, icons, bounding boxes or other visual elements to emphasize or deemphasize particular aspects of interest. In addition, if the building is part of a larger structure (*e.g.,* a unit in a multi-unit structure) and/or has associated nearby structures (*e.g.,* detached garage, shed, detached accessory dwelling unit, etc.), the floor plan model is displayed relative to the other structure(s) or structure parts to reflect those real-world relationships. In some embodiments, such a 2D or 3D floor plan model is shown on the map in place of any other visual representation of the building, while in other embodiments the floor plan model is overlaid on top of an image or other visual representation of the building (*e.g.,* to fit the floor plan to the exterior boundary of the building as is visible in an overhead or street-level image of the building that is part of the map or overlaid on the map). In addition, when a building has multiple stories, the information from the multiple stories may be presented in various manners, such as to show internal aspects of the different stories simultaneously but using differing visual aspects to distinguish them (*e.g.,* different colors, patterns, etc.), to show different stories sequentially (*e.g.,* automatically, such as a fixed amount of time per story; as directed by manual instructions, etc.) or as selected by a user, to show (or highlight) different stories at different zoom levels (*e.g.,* show the top story at the initial zoom level and expose lower stories as the zoom level increases), etc. Furthermore, such a displayed map may be interactive in at least some embodiments and situations, such as to enable zooming and/or scrolling operations through GUI (graphical user interface) manipulations such as via mouse and/or keyboard and/or touch screen inputs, including actions such as finger pinches. In addition, various details about surrounding areas outside of the building's floor plan may be displayed on the map in various manners, such as to highlight neighborhood information or other nearby information of one or more types (*e.g.,* to include pointers or other directional information for external locations such as schools, hospitals, highways, parks, etc.) - in some embodiments and situations, some or all of the neighborhood/nearby information may be overlaid on the visual representation of the floor plan on the map or otherwise included on the floor plan's visual representation, as well as to include information on the floor plan's visual representation such as the location of adjacent roads, trees, other buildings, etc. (*e.g.,* based on information extracted from the map or otherwise available, such as from public data sources or other data sources), such as to provide a 'site-plan' visualization. Furthermore, the types of additional information displayed may in some embodiments and situations be varied with the zoom level and/or based on user selection or preferences, and other types of information from external surrounding locations may similarly be added to the floor plan model and/or its visual representation (*e.g.,* as displayed information visible through windows, with directional information inside the floor plan model to particular external surrounding locations, etc.), a compass rose or other indication of geographical north and/or one or more other directions may similarly be added to the floor plan model and/or its visual representation, etc. Additional details are included below related to presenting a building floor plan with associated absolute location data using surrounding real-world data.

The described techniques provide various benefits in various embodiments, including to allow partial or complete floor plans of multi-room buildings and other structures to be automatically generated concurrently with the acquisition of one or more target image(s) acquired for the building or other structure, and/or to allow such a partial or complete floor plan to be augmented with information about associated absolute location data, including in some embodiments without having or using information from depth sensors or other distance-measuring devices about distances from images' acquisition locations to walls or other objects in a surrounding building or other structure. Non-exclusive examples of such benefits include the following: the ability to provide feedback during capture of one or more target images acquired for a building or other structure to an operator of the camera device (*e.g.*, to display or otherwise provide an operator user with a determined room shape for an enclosing room, such as part of a partial or complete floor plan for the building or other structure; to cause movement to a different image acquisition location that provides improved visual data, such as to move near a window in order to obtain visual data of objects external to the building that have known location data; etc.), including to optionally allow the user to determine one or more other areas of the building at which to acquire one or more further target images (*e.g.,* for a partial floor plan, to acquire additional target images in other areas of the building that are not yet represented in the partial floor plan), and such as in a near-time or real-near-time manner relative to the acquisition of the target image (*e.g.,* with initial information determined on a mobile computing device used immediately, such as displayed on the mobile computing device to the user, while also being further supplied to one or more other computing devices such as remote server computing systems for refinement or other updating); the ability to provide other types of feedback to a user or other transporter of a mobile device, such as to move to a different data capture location that provides improved additional data (*e.g*., to move near a window or outside a doorway in order to obtain stronger GPS signals and/or visual data of objects external to the building that have known location data; to move to a specified area proximate to the camera device, such as within visual range of the camera device or a specific area of such a range, such as centered in the visual coverage of the camera device at a specified range, to enable the mobile device or its transporter to be visible to the camera device, such as for the purpose of determining inter-location pose data between the camera device's image acquisition location and a data capture location of the mobile device at the specified area; etc.); etc. Furthermore, the described automated techniques allow such floor plan generation and association with absolute location data to be determined more quickly than previously existing techniques, and in at least some embodiments with greater accuracy, including by using information acquired from the actual building environment (rather than from plans on how the building should theoretically be constructed), as well as enabling the capture of changes to structural elements that occur after a building is initially constructed. Such described techniques further provide benefits in allowing improved automated navigation of a building by mobile devices (*e.g.,* semi-autonomous or fully autonomous vehicles), including to significantly reduce computing power and time used to attempt to otherwise learn a building's layout and/or location. In addition, in some embodiments the described techniques may be used to provide an improved GUI in which a user may more accurately and quickly obtain information about a building's interior (*e.g.,* for use in navigating that interior) and/or exterior and/or surrounding areas, including in response to search requests, as part of providing personalized information to the user, as part of providing value estimates and/or other information about a building to a user, etc. Various other benefits are also provided by the described techniques, some of which are further described elsewhere herein.

As noted above, the generation of a partial or complete floor plan for a building may include analyzing the visual data of one or more target images captured by a camera device at one or more image acquisition locations in a room of the building (or other defined area at the building) to determine at least some of the walls of that room that are visible in that visual data and to combine multiple pieces of determined wall data to form a room shape for the surrounding room (or other shape of another defined area) - such a determination of the walls may, for example, include modeling the walls as planar surfaces and/or as groupings of 3D data points, and the resulting determined room shape may be a 3D (three-dimensional) and/or 2D (two-dimensional) room shape based at least in part on the walls and their inter-wall borders, as well as similarly modeling some or all of the floor and/or ceiling (*e.g.,* for 3D room shapes) in at least some embodiments and situations. For example, the described techniques may, in at least some embodiments, include using one or more trained neural networks or other techniques to estimate a 3D room shape shown in one or more such target images - as non-exclusive examples, such 3D room shape estimation may include one or more of the following: using a trained convolutional neural network or other analysis technique to take the target image(s) as input and to estimate a 3D point cloud of the walls and other surfaces of the enclosing room from the visual contents of the target image and/or to estimate a piecewise planar representation (*e.g.,* 3D walls and other planar surfaces) of the enclosing room from the visual contents of the target image(s); using a trained neural network or other analysis technique to take the target image(s) as input and to estimate wireframe structural lines of the enclosing room from the visual contents of the target image (*e.g.,* structural lines to show one or more of borders between walls, borders between walls and ceiling, borders between walls and floor, outlines of doorways and/or other inter-room wall openings, outlines of windows, etc.); using a trained neural network or other analysis technique to detect wall structural elements (*e.g.,* windows and/or sky-lights; passages into and/or out of the room, such as doorways and other openings in walls, stairs, hallways, etc.; borders between adjacent walls; borders between walls and a floor; borders between walls and a ceiling; corners (or solid geometry vertices) where at least three surfaces or planes meet; etc.) in the visual contents of the target image(s) and to optionally detect other fixed structural elements (*e.g.,* countertops, bath tubs, sinks, islands, fireplaces, etc.) and to optionally generate 3D bounding boxes for the detected elements; etc. While the camera device is referred to in the singular at times herein, it will be appreciated that multiple camera devices may be used in some embodiments and situations for a given building, such as different camera devices that acquire different target images at different times (*e.g*., during different image acquisition sessions and/or at different image acquisition locations, whether in the same or different rooms or other defined areas as one or more other camera devices), different camera devices that acquire different target images at the same time (*e.g.,* during the same image acquisition session and at different or the same image acquisition locations, whether in the same or different rooms or other defined areas as one or more other camera devices), etc.

In addition, in some embodiments and situations, the analysis of the visual data of one or more target images captured by one or more camera devices at one or more image acquisition locations in a room (or other defined area) may be combined with additional room shape data that is determined from analysis of other data captured by one or more mobile devices at one or more other data capture locations in that room (or other defined area), with non-exclusive examples including the following: analyzing additional visual data of additional images captured by the mobile device to determine information about at least some walls of a surrounding room (and optionally some or all of the floor and/or the ceiling), optionally in combination with IMU data to generate a 3D point cloud of at least some of the room shape; analyzing depth data captured by the mobile device using one or more sensors that measure depth or otherwise determine distances to walls or other surrounding objects; etc. In at least some embodiments, the operations of the mobile device may be based at least in part on performing a SLAM (Simultaneous Localization And Mapping) and/or SfM (Structure from Motion) and/or MVS (multiple-view stereovision) analysis, such as by using motion data from IMU sensors on the mobile computing device in combination with visual data from one or more image sensors on the mobile computing device, including in at least some such embodiments to use the additional data captured by the mobile computing device to generate an estimated three-dimensional ("3D") shape of the enclosing room (*e.g.,* based on a 3D point cloud with a plurality of 3D data points and/or estimated planar surfaces of walls and optionally the floor and/or ceiling) - in some such embodiments, these automated operations are performed without using any depth sensors or other distance-measuring devices about distances from the mobile computing device to walls or other objects in the surrounding room, while in other embodiments the mobile computing device (or other additional associated mobile device) may capture depth data to walls of the surrounding room and use that captured depth data as part of determining the position of the mobile computing device. The automated determination of the position for the mobile computing device may further be performed in some embodiments as part of generating a travel path of the mobile computing device through the enclosing room (*e.g.,* using one or more of a SLAM, SfM and/or MVS analysis), whether instead of or in addition to generating a 3D shape of the enclosing room - in other embodiments, the automated determination of the position for the mobile computing device may be based at least in part on other analyses, such as via Wi-Fi triangulation, Visual Inertial Odometry ("VIO"), etc. Additional details are included below related to determining room shapes and to combining room shapes to form a partial or complete building floor plan.

As noted above, a building floor plan having associated room shape information for some or all rooms of the building may be generated and used in at least some embodiments, and may have various forms in various embodiments, such as a 2D (two-dimensional) floor map model of the building (*e.g.,* an orthographic top view or other overhead view of a schematic floor map that does not include or display height information) and/or a 3D (three-dimensional) or 2.5D (two and a half-dimensional) floor map model of the building that does display height information. Furthermore, in some embodiments, a target image (and optionally additional images) may be acquired outside of one or more buildings, such as in one of multiple separate areas of one or more properties (*e.g.,* for a house, a garden, patio, deck, back yard, side yard, front yard, pool, carport, dock, etc.) that each has a previously or concurrently determined area shape (*e.g.,* a 3D shape, a 2D shape, etc.) - if so, the shape of a surrounding area of the image may similarly be automatically determined and included as part of a building floor plan using the techniques described herein.

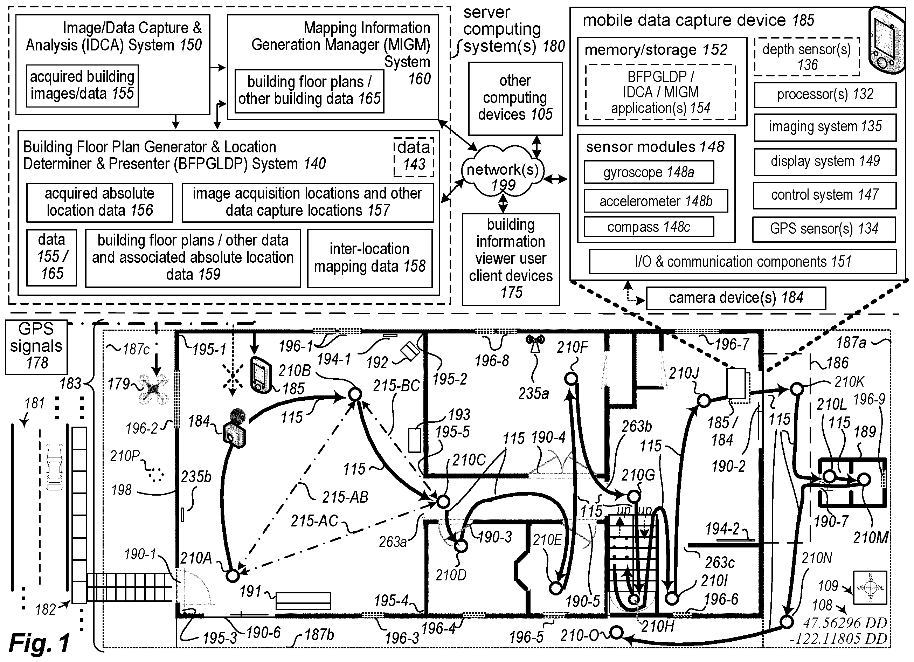

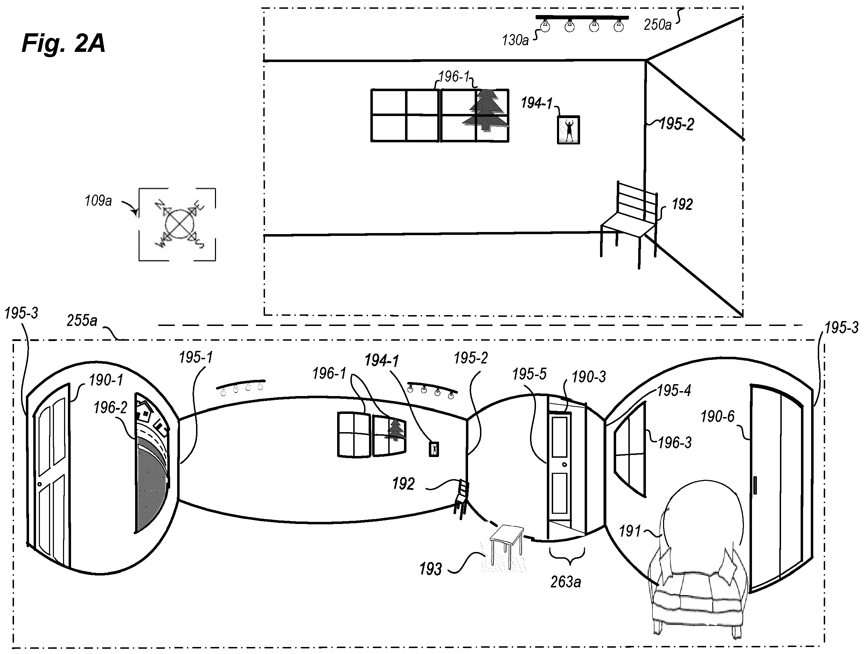

As noted above, in at least some embodiments and situations, some or all of the target images acquired for a building may be panorama images that are each acquired at one of multiple acquisition locations in or around the building, such as to generate a panorama image at each such acquisition location from one or more of a video captured at that acquisition location (*e.g.,* a 360° video taken from a smartphone or other mobile device held by a user turning at that acquisition location), or multiple images captured in multiple directions from the acquisition location (*e.g.,* from a smartphone or other mobile device held by a user turning at that acquisition location; from automated rotation of a device at that acquisition location, such as on a tripod at that acquisition location; etc.), or a simultaneous capture of all the image information for a particular acquisition location (*e.g*., using one or more fisheye lenses), etc. It will be appreciated that such a panorama image may in some situations be represented in a spherical coordinate system and provide up to 360° coverage around horizontal and/or vertical axes (*e.g.*, 360° of coverage along a horizontal plane and around a vertical axis), while in other embodiments the acquired panorama images or other images may include less than 360° of vertical coverage (*e.g.,* for images with a width exceeding a height by more than a typical aspect ratio, such as at or exceeding 21:9 or 16:9 or 3:2 or 7:5 or 4:3 or 5:4 or 1:1, including for so-called 'ultrawide' lenses and resulting ultrawide images). In addition, it will be appreciated that a user viewing such a panorama image (or other image with sufficient horizontal and/or vertical coverage that only a portion of the image is displayed at any given time) may be permitted to move the viewing direction within the panorama image to different orientations to cause different subset images (or "views") to be rendered within the panorama image, and that such a panorama image may in some situations be represented in a spherical coordinate system (including, if the panorama image is represented in a spherical coordinate system and a particular view is being rendered, to convert the image being rendered into a planar coordinate system, such as for a perspective image view before it is displayed). Furthermore, acquisition metadata regarding the capture of such panorama images may be obtained and used in various manners, such as data acquired from IMU sensors or other sensors of a mobile device as it is carried by a user or otherwise moved between acquisition locations - non-exclusive examples of such acquisition metadata may include one or more of acquisition time; acquisition location, such as GPS coordinates or other indication of location; acquisition direction and/or orientation; relative or absolute order of acquisition for multiple images acquired for a building or that are otherwise associated; etc., and such acquisition metadata may further optionally be used as part of determining the images' acquisition locations in at least some embodiments and situations, as discussed further below. Additional details are included below regarding automated operations of device(s) implementing an Image/Data Capture and Analysis (IDCA) system involved in acquiring images and optionally acquisition metadata, including with respect to Figures 1 and 2A-2B and elsewhere herein.

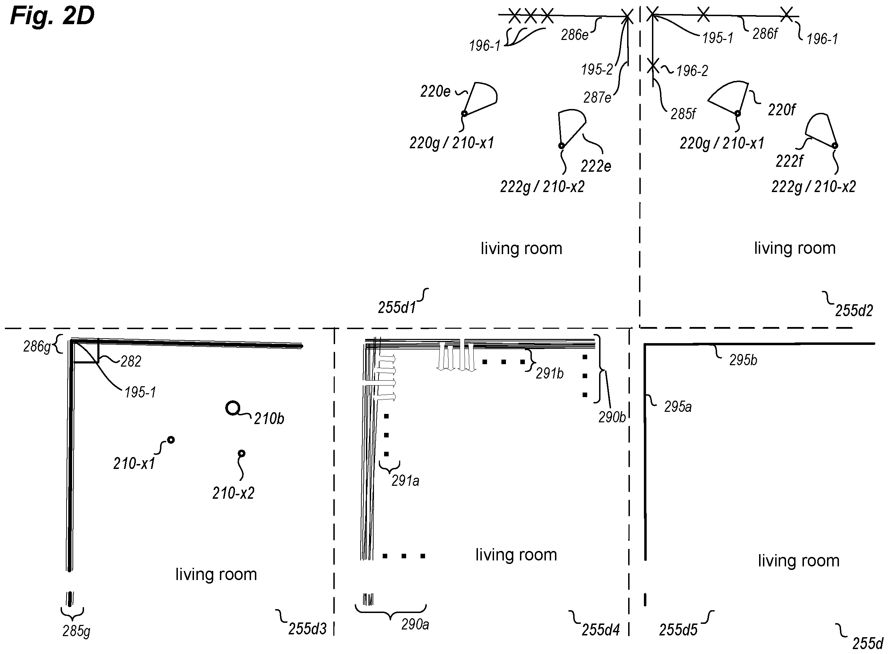

As is also noted above, shapes of rooms of a building may be automatically determined in various manners in various embodiments. For example, in at least some embodiments, a Mapping Information Generation Manager (MIGM) system may analyze various images acquired in and around a building in order to automatically determine room shapes of the building's rooms (*e.g.,* 3D room shapes, 2D room shapes, etc.) and to automatically generate a floor plan for the building. As one example, if multiple images are acquired within a particular room, those images may be analyzed to determine a 3D shape of the room in the building (*e.g.,* to reflect the geometry of the surrounding structural elements of the building) - the analysis may include, for example, automated operations to `register' the camera positions for the images in a common frame of refence so as to 'align' the images and to estimate 3D locations and shapes of objects in the room, such as by determining features visible in the content of such images (*e.g.*, to determine the direction and/or orientation of the capture device when it took particular images, a path through the room traveled by the capture device, etc., such as by using SLAM techniques for multiple video frame images and/or other SfM techniques for a 'dense' set of images that are separated by at most a defined distance (such as 6 feet) to generate a 3D point cloud for the room including 3D points along walls of the room and at least some of the ceiling and floor of the room and optionally with 3D points corresponding to other objects in the room, etc.) and/or by determining and aggregating information about planes for detected features and normal (orthogonal) directions to those planes to identify planar surfaces for likely locations of walls and other surfaces of the room and to connect the various likely wall locations (*e.g.,* using one or more constraints, such as having 90° angles between walls and/or between walls and the floor, as part of the so-called 'Manhattan world assumption') and form an estimated room shape for the room. After determining the estimated room shapes of the rooms in the building, the automated operations may, in at least some embodiments, further include positioning the multiple room shapes together to form a floor plan and/or other related mapping information for the building, such as by connecting the various room shapes, optionally based at least in part on information about doorways and staircases and other inter-room wall openings identified in particular rooms, and optionally based at least in part on determined travel path information of a mobile computing device between rooms. Similar techniques may be used for determining inter-location pose information for images captured at multiple locations, as discussed in greater detail elsewhere herein. Additional details are included below regarding automated operations of device(s) implementing an MIGM system involved in determining room shapes and combining room shapes to generate a floor plan, including with respect to Figures 1 and 2D and elsewhere herein.

For illustrative purposes, some embodiments are described below in which specific types of information are acquired, used and/or presented in specific ways for specific types of structures and by using specific types of devices - however, it will be understood that the described techniques may be used in other manners in other embodiments, and that the invention is thus not limited to the exemplary details provided. As one non-exclusive example, while house floor plans may be generated in some example that do not include detailed measurements for particular rooms or for the overall houses, it will be appreciated that other types of floor plans or other mapping information may be similarly generated in other embodiments, including for buildings (or other structures or layouts) separate from houses. As another non-exclusive example, while floor plans for houses or other buildings may be used for display to assist viewers in navigating the buildings, generated mapping information may be used in other manners in other embodiments. As yet another non-exclusive example, while some embodiments discuss obtaining and using additional data from a mobile computing device that is separate from a camera device that captures a target image, in other embodiments the one or more devices used in addition to the camera device may have other forms, such as to use a mobile device that acquires some or all of the additional data but does not provide its own computing capabilities (*e.g.,* an additional 'non-computing' mobile device), multiple separate mobile devices that each acquire some of the additional data (whether mobile computing devices and/or non-computing mobile devices), etc. In addition, the term "building" refers herein to any partially or fully enclosed structure, typically but not necessarily encompassing one or more rooms that visually or otherwise divide the interior space of the structure - non-limiting examples of such buildings include houses, apartment buildings or individual apartments therein, condominiums, office buildings, commercial buildings or other wholesale and retail structures (*e.g.,* shopping malls, department stores, warehouses, etc.), etc. The term "acquire" or "capture" as used herein with reference to a building interior, acquisition location, or other location (unless context clearly indicates otherwise) may refer to any recording, storage, or logging of media, sensor data, and/or other information related to spatial and/or visual characteristics and/or otherwise perceivable characteristics of the building interior or subsets thereof, such as by a recording device or by another device that receives information from the recording device. As used herein, the term "panorama image" may refer to a visual representation that is based on, includes or is separable into multiple discrete component images originating from a substantially similar physical location in different directions and that depicts a larger field of view than any of the discrete component images depict individually, including images with a sufficiently wide-angle view from a physical location to include angles beyond that perceivable from a person's gaze in a single direction (*e.g*., greater than 120° or 150° or 180°, etc.). The term "sequence" of acquisition locations, as used herein, refers generally to two or more acquisition locations that are each visited at least once in a corresponding order, whether or not other non-acquisition locations are visited between them, and whether or not the visits to the acquisition locations occur during a single continuous period of time or at multiple different times, or by a single user and/or device or by multiple different users and/or devices. In addition, various details are provided in the drawings and text for exemplary purposes, but are not intended to limit the scope of the invention. For example, sizes and relative positions of elements in the drawings are not necessarily drawn to scale, with some details omitted and/or provided with greater prominence (*e.g.,* via size and positioning) to enhance legibility and/or clarity. Furthermore, identical reference numbers may be used in the drawings to identify similar elements or acts.

Figure 1 includes an example block diagram of various computing devices and systems that may participate in the described techniques in some embodiments, such as with respect to an illustrated example of part of a building 198 (in this example, house 198 on property 183), and by the Building Floor Plan Generator and Location Determiner and Presenter ("BFPGLDP") system 140 executing at least in part on one or more server computing systems 180 in this example embodiment.

In the illustrated embodiment, the IDCA system 150 obtains target images 155 captured at each of one or more image acquisition locations in each of one or more buildings by one or more camera devices 184, such as 360° panorama images captured using one or more camera devices that are designed to simultaneously capture 360° of horizontal visual coverage or that otherwise have one or more lens used in the aggregate to capture 360° of horizontal visual coverage. The IDCA system further obtains additional data 155 captured at each of one or more other data capture locations in each of the one or more buildings by one or more mobile data capture devices 185 that move independently from the camera devices 184 (*e.g.,* are not mounted to or otherwise physically coupled together, such as to enable either device to be moved without moving the other device), with the illustrated mobile data capture device 185 in this example being a mobile computing device that includes computing capabilities - the additional captured data includes GPS location data (*e.g.,* using one or more GPS receiver sensors 134) and/or other absolute location data, and may further include, for example, geographical direction data (*e.g.,* using compass sensor 148c), device motion data (*e.g.,* using one or more sensor modules 148, such as part of IMU sensors), additional images (*e.g.,* using one or more imaging systems 135), etc.

The BFPGLDP system 140 obtains the images and other captured data 155 from the IDCA system 150 and uses it to determine absolute location data 156 for one or more positions in each of the buildings, although in other embodiments the system 140 may directly control the capture of some or all such data, whether in addition to or instead of the IDCA system. The BFPGLDP system 140 further uses the visual data of captured images to determine room shapes of surrounding rooms, optionally in combination with some of the additional captured data (*e.g.,* device motion data for the mobile data capture device), and combines the determined room shapes to generate associated building floor plans 165, such as by using corresponding functionality of the MIGM system 160, although in other embodiments the system 140 may directly control some or all such generation of building floor plans, whether in addition to or instead of the MIGM system. The BFPGLDP system 140 also automatically determines particular GPS location data or other absolute location data to associate with each generated floor plan 159, whether during or after the floor plan generation, including in at least some embodiments by automatically determining information 157 about the camera device(s)' image acquisition locations and the mobile data capture device(s)' data capture locations (*e.g.,* from analysis of the individual data captured by the camera device(s), from receipt of GPS data signal by the data capture device(s), etc.), and extending absolute location data for at least some of the data capture locations to at least some of the image acquisition locations, such as by determining and using mapping data 158 between image acquisition locations in a local coordinate system for a building floor plan and other data capture absolute locations (*e.g.,* between pairs of one such image acquisition location and one such data capture absolute location that are associated, such as based at least in part on respective acquisition times, etc.) - accordingly, the information 157 and 158 may be used to extend the absolute location data from a data capture location of the mobile data capture device to an image acquisition location of the camera device and its surrounding room shape.

In at least some embodiments and situations, the automated determinations by the BFPGLDP system 140 (and by the IDCA system and/or the MIGM system if the BFPGLDP system uses their functionality for data capture and floor plan generation, respectively) are performed concurrently with the data capture (*e.g.,* in a real-time or near-real-time manner, such as within milliseconds, seconds, minutes, etc. of the data capture), including to generate partial building floor plans (*e.g.,* to incrementally expand a floor plan with the room shape for each room in which the images and additional data are captured), and to optionally use such partial building floor plans and/or other acquired and generated data to provide feedback to one or more operator users of the camera device(s) and/or mobile data capture device(s), including in some embodiments and situations to display corresponding information in a GUI shown on a mobile data capture computing device. The BFPGLDP system 140 may optionally further use supporting information supplied by system operator users via computing devices 105 over intervening computer network(s) 199 in some embodiments and situations.

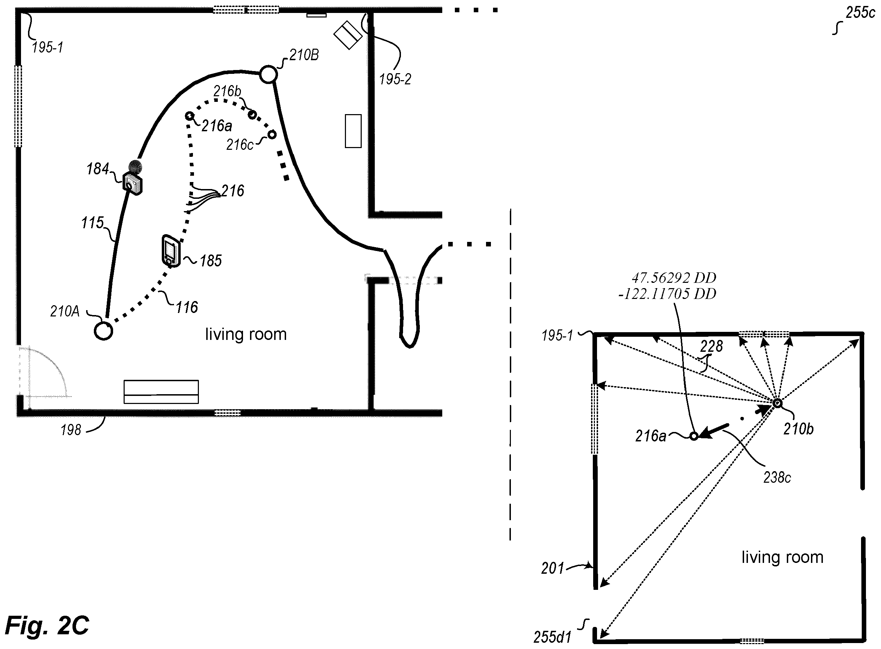

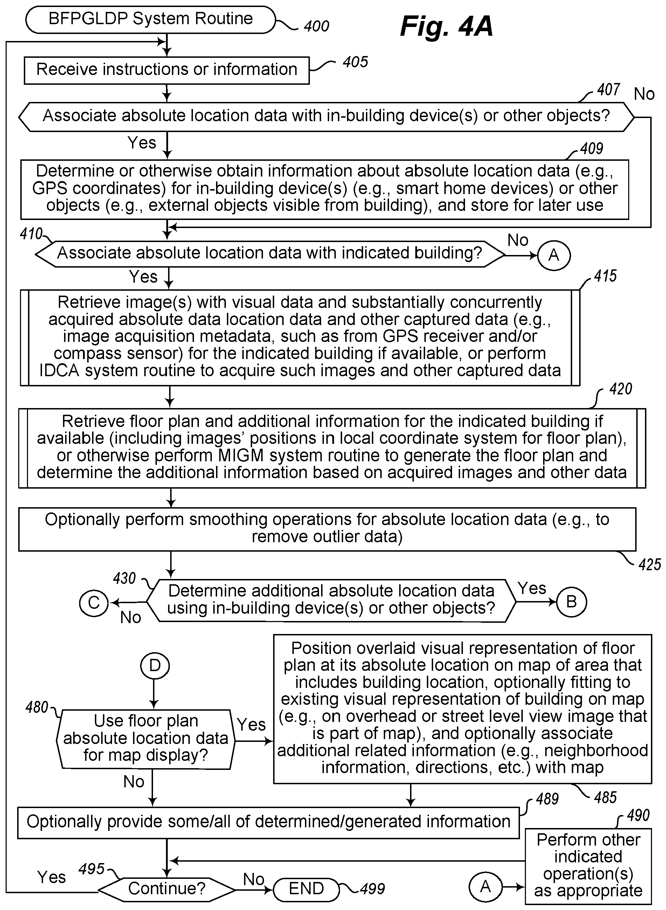

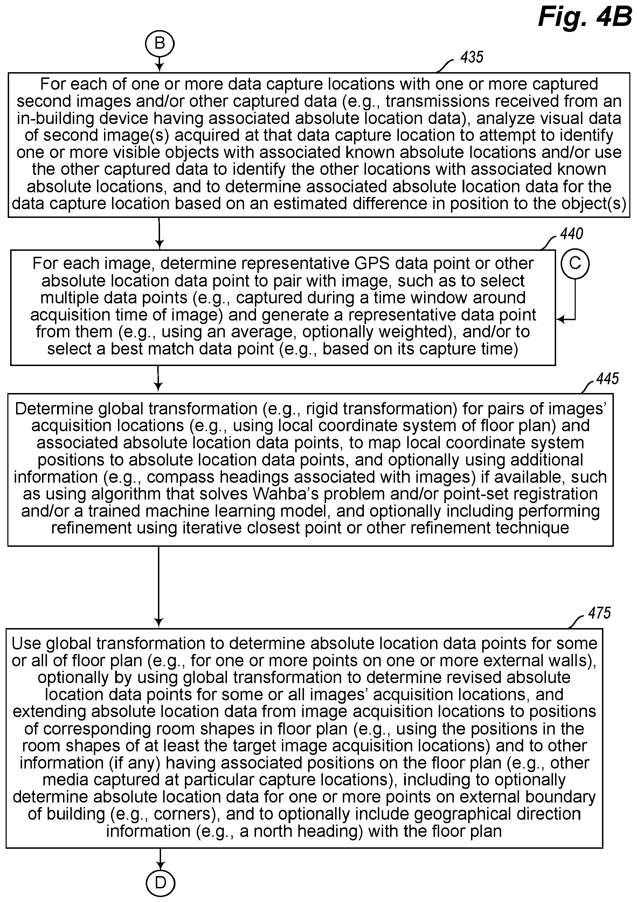

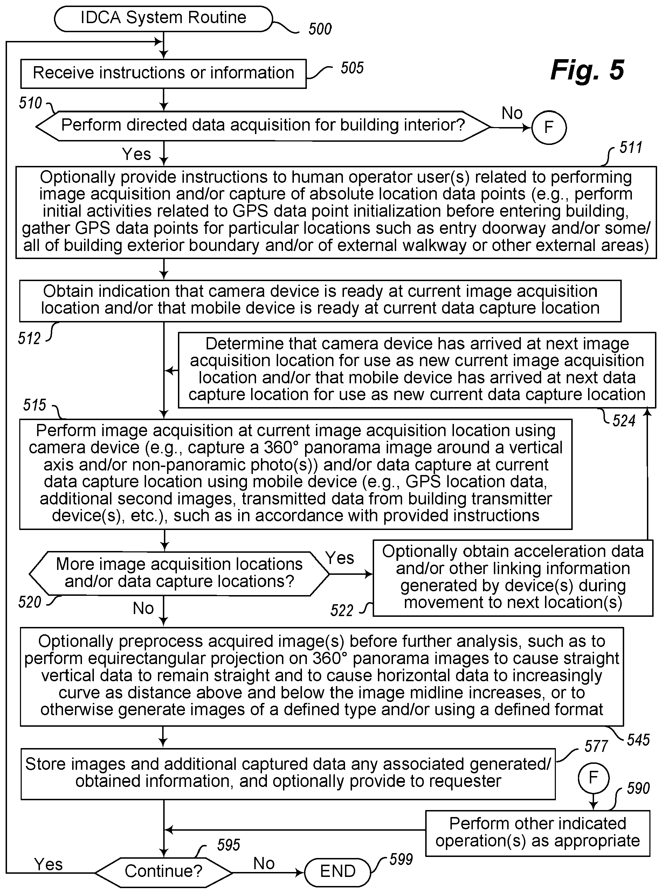

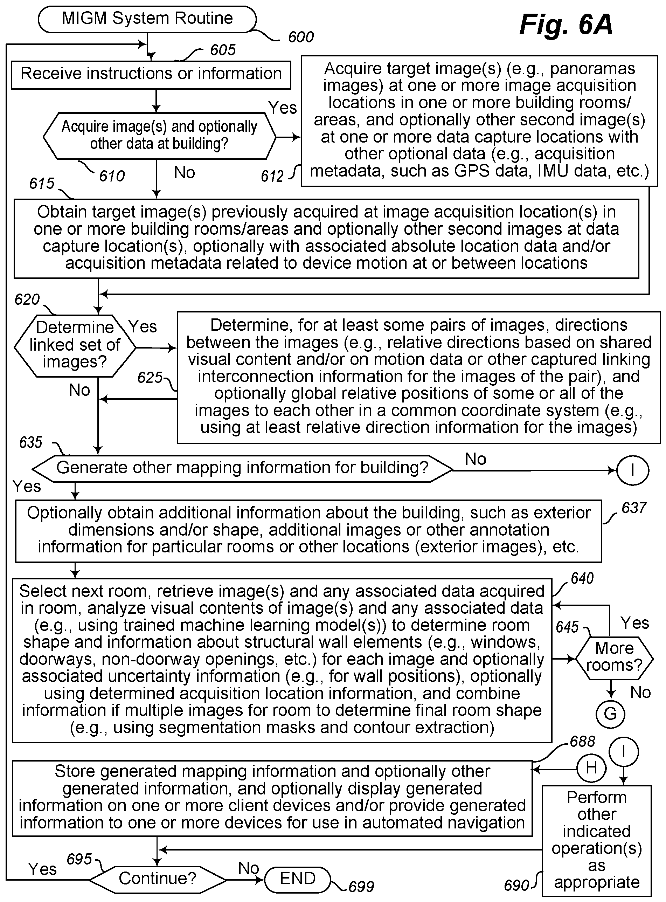

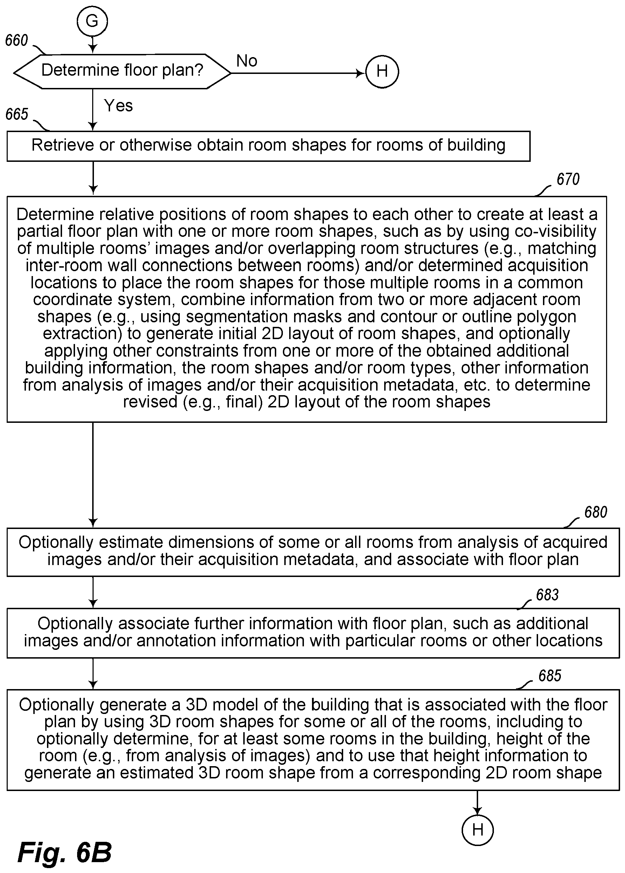

The IDCA system 150 and/or MIGM system 160 may in some embodiments execute on the same server computing system(s) 180 as the BFPGLDP system (*e.g.,* with all systems being operated by a single entity or otherwise being executed in coordination with each other, such as with some or all functionality of all the systems integrated together), and in some embodiments the IDCA system 150 and/or MIGM system 160 may operate on one or more other systems separate from the system(s) 180 (*e.g.,* on one or more mobile data capture devices 185 and/or other computing systems, not shown), whether instead of or in addition to the copies of those systems executing on the system(s) 180 (*e.g*., to have a copy of the MIGM system 160 executing on the device 185 to incrementally generate at least partial building floor plans as building images are acquired by the IDCA system 160 executing on the device 185 and/or by that copy of the MIGM system, while another copy of the MIGM system optionally executes on one or more server computing systems to generate a final complete building floor plan after all images are acquired; etc.). In the illustrated embodiment, client applications 154 for one or more of the BFPGLDP system and/or the IDCA system and/or the MIGM system may execute on the capture devices 185 (and in other embodiments and situations, some or all of the entire BFPGLDP system and/or the IDCA system and/or the MIGM system may execute on some or all mobile devices 185, such as in a distributed manner), and a BFPGLDP client application or other building information viewer system (not shown) may execute on one or more user client devices 175 to receive and present generated building floor plan information and optionally associated information (*e.g.,* a map of a surrounding area). In addition, building information may in some embodiments be obtained by the BFPGLDP system in manners other than via IDCA and/or MIGM systems (*e.g.,* if such IDCA and/or MIGM systems are not part of the BFPGLDP system), such as to receive building images and/or other data from other sources, and/or to generate floor plans without using the MIGM system. Other data 143 may also be optionally stored and used by the system 140, including about users of capture devices 185 and/or camera devices 184 and/or other client devices 175 (*e.g*., as part of associated accounts at the BFPGLDP system), such as preference-related data (*e.g.,* for use in personalizing information and/or functionality provided to the user, including feedback related to the data capture activities, presentation of generated information, etc.). Additional details related to the automated operations of the BFPGLDP system are included elsewhere herein, including with respect to Figures 2C-2V and Figures 4A-4B. Additional details related to the automated operation of the IDCA and MIGM systems are included elsewhere herein, including with respect to Figures 5 and 6A-6B, respectively.

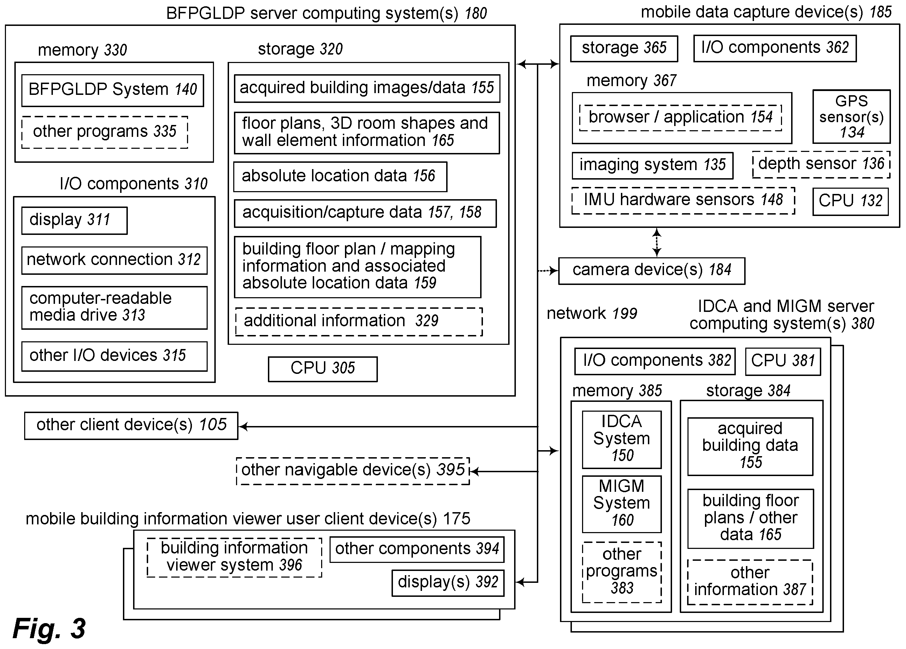

Various components of the mobile data capture computing device 185 are also illustrated in Figure 1, including one or more hardware processors 132 (*e.g.,* CPUs, GPUs, etc.) that execute software (*e.g.,* IDCA and/or MIGM and/or BFPGLDP application 154, optional browser or other software program(s), etc.) using executable instructions stored and/or loaded on one or more memory/storage components 152 of the device 185, and one or more imaging systems 135 of one or more types (*e.g.,* including one or more cameras with one or more lenses and one or more image sensors) to acquire visual data of additional images (not shown, such as rectilinear perspective images) - a device 185 may also in some embodiments receive some or all target images 155 from one or more separate associated camera devices 184 (*e.g.,* via a temporary wired/cabled connection, via Bluetooth or other inter-device wireless communications, etc.) and provide storage and/or transmission functionality for those target images, whether in addition to or instead of images acquired by the mobile device 185, and such as with the mobile device 185 optionally acting as a mobile companion device for the camera device and optionally having a wireless transmitter and/or receiver to use in exchanging wireless transmissions with a corresponding wireless receiver and/or transmitter on or associated with the camera device 184. The illustrated embodiment of mobile device 185 further includes one or more sensor modules 148 that include a gyroscope 148a, accelerometer 148b and compass 148c in this example (*e.g.,* as part of one or more IMUs, or inertial measurement units, on the mobile device, not shown separately), one or more control systems 147 managing I/O (input/output) and/or communications and/or networking for the device 185 (*e.g.,* to receive instructions from and present information to the user) such as for other device I/O and communication components 151 (*e.g.,* network interfaces or other connections, keyboards, mice or other pointing devices, microphones, speakers, GPS receivers, etc.), a display system 149 (*e.g.,* including one or more displays, optionally with touch-sensitive screens), a GPS (or Global Positioning System) receiver/sensor 134 or other position determination sensor (not shown in this example), optionally one or more depth-sensing sensors or other distance-measuring components 136 of one or more types, optionally other components (*e.g.,* one or more lighting components), etc. Other devices/systems 105, 175 and 180 and/or camera devices 184 may each include various hardware components and stored information in a manner analogous to mobile device 185, which are not shown in this example for the sake of brevity, and as discussed in greater detail below with respect to Figure 3. In addition, in other embodiments and situations at least some mobile data capture devices may lack some of the illustrated components, such as to lack computing capabilities.

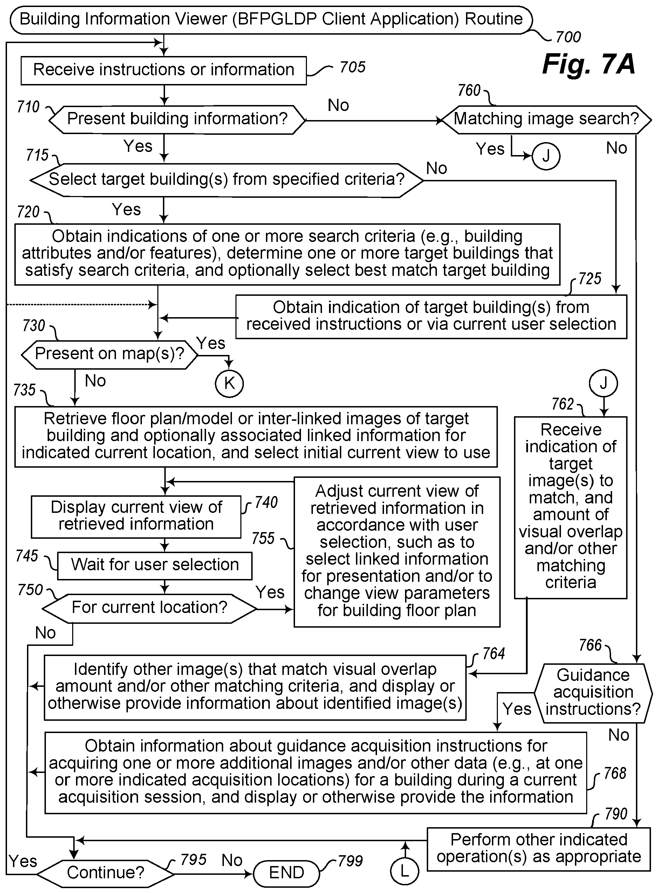

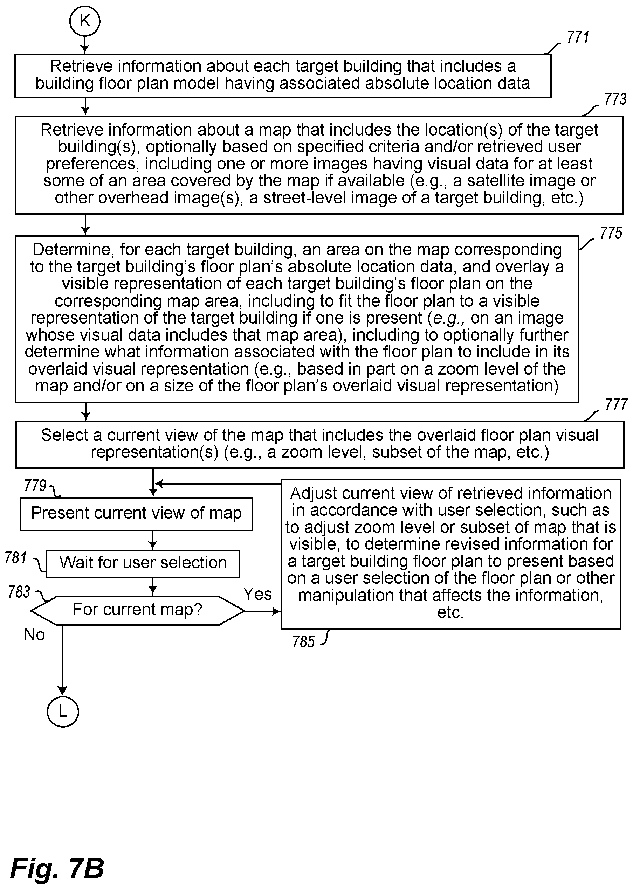

One or more users (*e.g.,* end-users, not shown) of one or more mobile client devices 175 may further interact over one or more computer networks 199 with the BFPGLDP system 140 (and optionally the IDCA system 150 and/or MIGM system 160), and/or with some or all of the BFPGLDP system executing on that device 175 (not shown), such as to participate in acquiring additional images in or around a building using one or more cameras of the device 175 or otherwise providing user-supplied information, presenting or otherwise displaying received building data, etc. Such mobile devices 175 may each execute a BFPGLDP client application or other building information viewer system (not shown) that is used to interact with the BFPGLDP system to request and receive building information, to present such received building information and/or other received information on that mobile device (*e.g.,* as part of a GUI displayed on that mobile device), and further optionally receive and respond to interactions by one or more users with the presented information (*e.g.,* with displayed user-selectable controls, such as part of the generated visual data enhancements), as discussed in greater detail elsewhere herein, including with respect to Figures 7A-7B. Interactions by the user(s) may include, for example, displaying maps with one or more 2D or 3D building floor plan models overlaid at positions corresponding to their associated absolute locations, specifying criteria to use in providing building information (*e.g.,* criteria about building attributes of interest to a user), obtaining and optionally requesting information for one or more indicated buildings (*e.g.,* at which the user's mobile device is located, such as by supplying one or more additional images acquired at a building) and interacting with corresponding provided building information - non-exclusive examples of interactions with displayed or otherwise presented information includes the following: to view building information, such as part of provided descriptive building data; to select user-selectable controls that are provided with provided building data, such as included in visual data enhancements overlaid on a target image, including to interact with one or more displayed visual indicators and/or textual descriptions associated with a particular building object or other building attribute, such as to obtain further data related to that building object or other building attribute; to change between a floor plan view and a view of a particular image at an acquisition location within or near the floor plan; to change the horizontal and/or vertical viewing direction from which a corresponding view of a panorama image is displayed, such as to determine a portion of a panorama image to which a current user viewing direction is directed; to zoom and/or otherwise manipulate a displayed map and/or a building floor plan model overlaid on the map; etc.). In addition, a floor plan (or portion of it) may be linked to or otherwise associated with one or more other types of information, including for a floor plan of a multi-story or otherwise multi-level building to have multiple associated sub-floor plans for different stories or levels that are interlinked (*e.g.,* via connecting stairway passages), for a two-dimensional ("2D") floor plan of a building to be linked to or otherwise associated with a three-dimensional ("3D") rendering of the building, etc. Also, while not illustrated in Figure 1, in some embodiments the client devices 175 (or other devices, not shown) may receive and use information about buildings (*e.g.,* identified floor plans and/or other mapping-related information) in additional manners, such as to control or assist automated navigation activities by those devices (*e.g.,* by autonomous vehicles or other devices), whether instead of or in addition to display of the identified information.

In the depicted computing environment of Figure 1, the network 199 may be one or more publicly accessible linked networks, possibly operated by various distinct parties, such as the Internet. In other implementations, the network 199 may have other forms. For example, the network 199 may instead be a private network, such as a corporate or university network that is wholly or partially inaccessible to non-privileged users. In still other implementations, the network 199 may include both private and public networks, with one or more of the private networks having access to and/or from one or more of the public networks. Furthermore, the network 199 may include various types of wired and/or wireless networks in various situations. In addition, the client devices 175 and server computing systems 180 may include various hardware components and stored information, as discussed in greater detail below with respect to Figure 3.

As noted above, the IDCA system may perform automated operations involved in generating multiple 360° panorama images at multiple associated image acquisition locations (*e.g.,* in multiple rooms or other locations within a building or other structure and optionally around some or all of the exterior of the building or other structure), such as using visual data acquired via one or more camera devices 184, and for use in generating and providing a representation of an interior of the building or other structure. For example, in at least some such embodiments, such techniques may include using one or more such camera devices (*e.g*., a camera having one or more fisheye lenses and/or other lenses and mounted on a rotatable tripod or otherwise having an automated rotation mechanism; a camera having sufficient fisheye lenses and/or other lenses to acquire 360° horizontally without rotation; a camera of a smartphone or separate device held by or mounted on a user or the user's clothing and using one or more non-fisheye lenses, such as wide-angle rectilinear lenses and/or telephoto lenses and/or macro lenses and/or standard lenses; etc.) to acquire data from a sequence of multiple acquisition locations within multiple rooms of a house (or other building), and to optionally further acquire data involved in movement of the capture device (*e.g.,* movement at an acquisition location, such as rotation; movement between some or all of the acquisition locations, such as for use in linking the multiple acquisition locations together; etc.), in at least some cases without having distances between the acquisition locations being measured or having other measured depth information to objects in an environment around the acquisition locations (*e.g.,* without using any depth-sensing sensors). After an acquisition location's information is acquired, the techniques may include producing a 360° panorama image from that acquisition location with 360° of horizontal information around a vertical axis (*e.g.,* a 360° panorama image that shows the surrounding room in an equirectangular format), and then providing the panorama images for subsequent use by the MIGM and/or BFPGLDP systems.

In addition, a floor plan (or portion of it) may be linked to or otherwise associated with one or more additional types of information, such as one or more associated and linked images or other associated and linked information, including for a two-dimensional ("2D") floor plan of a building to be linked to or otherwise associated with a separate 2.5D model floor plan rendering of the building and/or a 3D model floor plan rendering of the building, etc., and including for a floor plan of a multi-story or otherwise multi-level building to have multiple associated sub-floor plans for different stories or levels that are interlinked (*e.g.,* via connecting stairway passages) or are part of a common 2.5D and/or 3D model. Accordingly, non-exclusive examples of an end-user's interactions with a displayed or otherwise generated 2D floor plan of a building may include one or more of the following: to change between a floor plan view and a view of a particular image at an acquisition location within or near the floor plan; to change between a 2D floor plan view and a 2.5D or 3D model view that optionally includes images texture-mapped to walls of the displayed model; to change the horizontal and/or vertical viewing direction from which a corresponding subset view of (or portal into) a panorama image is displayed, such as to determine a portion of a panorama image in a 3D coordinate system to which a current user viewing direction is directed, and to render a corresponding planar image that illustrates that portion of the panorama image without the curvature or other distortions present in the original panorama image; etc. In addition, while not illustrated in Figure 1, in some embodiments the client devices 175 (or other devices, not shown) may receive and use generated floor plans and/or other generated mapping-related information in additional manners, such as to control or assist automated navigation activities by those devices (*e.g*., by autonomous vehicles or other devices), whether instead of or in addition to display of the generated information.

Figure 1 further depicts an exemplary building environment in which data may be acquired for use in the described techniques, such as by camera devices 184 moving through the building and acquiring 360° target panorama images and/or other target images and by other data capture devices 185 moving through the building and acquiring additional data that is used to determine GPS location data or other absolute location data - the data may be captured by the IDCA system for use by the MIGM system (*e.g.,* under control of the BFPGLDP system) to generate and provide one or more corresponding building floor plans (*e.g.,* multiple incremental partial building floor plans) and/or to further use such building information as part of automated building information generation operations. In particular, Figure 1 illustrates one story of a multi-story house (or other building) 198 with an interior that was acquired at least in part via multiple target panorama images, such as by one or more associated camera devices 184 as they are moved through the building interior to a sequence of multiple acquisition locations 210 (*e.g.,* starting at acquisition location 210A, moving to acquisition location 210B along travel path 115, moving to acquisition location 210C along that travel path, etc., and ending at acquisition location 210-0 or 210P outside of the building), and with additional data (*e.g.,* absolute location data, additional images, etc.) captured by one or more mobile data capture devices 185 that separately move through the building to multiple other data capture locations. An embodiment of the IDCA system may automatically perform or assist in the acquiring of the data representing the building interior (as well as to further analyze the acquired data to generate 360° target panorama images to provide a visual representation of the building interior), and an embodiment of the MIGM system may analyze the visual data of the acquired images and optionally other acquired data to generate one or more building floor plans for the house 198 (*e.g.,* multiple incremental building floor plans), such as based at least in part on determined directions and optionally distances between multiple image acquisition locations (*e.g.,* directions and optionally distances 215-AB, 215-AC and 215-BC between acquisition location pairs 210A and 210B, 210A and 210C, and 210B and 210C, respectively). While such a mobile data capture device may include various hardware components, such as an included camera, one or more sensors (*e.g.,* a gyroscope, an accelerometer, a compass, etc., such as part of one or more IMUs, or inertial measurement units, of the mobile device; an altimeter; light detector; etc.), a GPS receiver, one or more hardware processors, memory, a display, a microphone, etc., the mobile device may not in at least some embodiments have access to or use equipment to measure the depth of objects in the building relative to a location of the mobile device, such that relationships between additional images and their associated data capture locations in such embodiments may be determined in part or in whole based on elements in different additional images but without using any data from any such depth sensors, while in other embodiments such depth data may be used. In addition, while GPS coordinate data 108 (*e.g.,* for a specified location on the property and/or at the building, such as the northwest corner 195-1 of the building 198, the northwest corner of the property, etc., and shown using decimal degrees format in this example) and directional indicator 109 are shown in Figure 1 for reference of the reader relative to the example house 198, the camera device and/or IDCA system may not use such absolute directional information in at least some embodiments, such as to instead determine relative directions and distances between acquisition locations 210 without regard to actual geographical directions in such embodiments, while in other embodiments such absolute directional information may be obtained and used.

In operation, a camera device 184 arrives at a first acquisition location 210A within a first room of the building interior (in this example, in a living room accessible via an external door 190-1), and acquires a target image with a view of a portion of the building interior that is visible from that acquisition location 210A (*e.g.*, some or all of the first room, and optionally small portions of one or more other adjacent or nearby rooms, such as through doorway wall openings, non-doorway wall openings, hallways, stairways or other connecting passages from the first room). Similarly, mobile device 185 arrives at one or more different data capture locations in the first room at which it acquires additional data, such as GPS location data and optionally additional images, such as is discussed further with respect to Figure 2C. The image acquisition may be performed in various manners as discussed herein, and may include visual data about a number of structural elements or other objects that are visible from the acquisition location - in the example of Figure 1, such objects within the building 198 include the walls, floors, ceilings, doorways 190 (including 190-1 through 190-6, such as with swinging and/or sliding doors), windows 196 (including 196-1 through 196-8), borders between walls and other walls/ceilings/floors such as for inter-wall corners or edges 195 (including corner 195-1 in the northwest corner of the building 198, corner 195-2 in the northeast corner of the first room, corner 195-3 in the southwest corner of the first room, corner 195-4 in the southeast corner of the first room, corner 195-5 at the northern edge of the inter-room passage between the first room and a hallway, etc.), furniture 191-193 (*e.g.,* a couch 191; chair 192; table 193; etc.), pictures or paintings or televisions or other hanging objects 194 (such as 194-1 and 194-2) hung on walls, light fixtures (not shown in Figure 1), various built-in appliances or other fixtures or other structural elements (not shown in Figure 1), and the visual data may further show non-doorway wall openings 263a and 263b and 263c, etc. If additional visual data is captured by the mobile device in the living room, it may similarly show some or all such objects but from one or more other data capture locations than the acquisition locations 210A and 210B and having a different corresponding perspective. An operator user may also optionally provide a textual or auditory label identifier to be associated with an acquisition location and/or a surrounding room, such as "living room" for one of acquisition locations 210A or 210B or for the room including acquisition locations 210A and/or 210B, and/or a descriptive annotation with one or more phrases or sentences about a room and/or one or more objects in the room, while in other embodiments the IDCA and/or MIGM system may automatically generate such identifiers and/or annotations (*e.g.,* by automatically analyzing images and/or video and/or other recorded information for a building to perform a corresponding automated determination, such as by using machine learning; based at least in part on input from IDCA and/or MIGM system operator users; etc.) or the identifiers may not be used.

After the first acquisition location 210A has been acquired, the camera device 184 may be moved or move under its own power to a next acquisition location (such as acquisition location 210B), and the mobile device 185 may similarly be moved or move under its own power to a next data capture location, optionally recording images and/or video and/or other data from the hardware components (*e.g.,* from one or more IMUs, from the camera, from the GPS sensors, etc.) during movement between locations. At the next acquisition location, the camera device(s) 184 may similarly acquire a 360° target panorama image and/or other type of target image from that acquisition location, and the mobile device(s) 185 may similarly capture additional data from one or more next data capture locations. This process may repeat for some or all rooms of the building 198 and in some cases parts of the property 183 external to the building, as illustrated for additional acquisition locations 210C-210P in this example, including in this example to acquire target panorama image(s) and associated additional other data on an external deck or patio or balcony area 186, on a larger external back yard or patio area 187a, in a separate side yard area 187b, near or in an external additional accessory structure area 189 (*e.g.*, a garage, shed, accessory dwelling unit, greenhouse, gazebo, car port, etc.) that may have one or more rooms and/or one or more doorways (*e.g.,* doorway 190-7) and/or one or more windows (*e.g*., window 196-9), in a front yard 187c outside the external doorway 190-1 (*e.g.*, during a different acquisition session than used to acquire some or all of the other target images, such as with images for acquisition locations 210A to 210-0 being acquired in a single image acquisition session in a substantially continuous manner that occurs within a period of time such as 5 minutes or 15 minutes or 30 minutes), and in other embodiments and situations from further acquisition locations (not shown) on an adjoining street or road 181 and/or sidewalk 182, from one or more overhead locations (*e.g.,* from a drone 179, and/or airplane, satellite, etc., not shown), etc. The acquired images for each acquisition location may also be further analyzed, including in some embodiments to render or otherwise place each panorama image in an equirectangular format, whether at the time of image acquisition or later, as well as further analyzed by the MIGM and/or BFPGLDP systems in the manners described herein.

As the mobile device moves through the building, it may receive GPS signals 178 at some or all data capture locations and associate corresponding GPS location data with each such data capture location, although in some embodiments and situations the mobile device may not be able to receive the GPS signals at some data capture locations and may instead perform other actions to determine absolute location data for such data capture locations - for example, in some embodiments and situations, the mobile device may further interact with one or more devices 235 in the home as part of determining absolute location data, such as to receive a wireless transmission from a device 235a having an associated absolute location (*e.g.,* a Bluetooth beacon, a Wi-Fi transmitter, etc.), to identify in visual data of the mobile device's second image(s) a device or other visible information 235b (*e.g.,* a marker on a wall) having an associated absolute location, etc., and to further use such location data as part of determining the absolute location data for one or more data capture locations of the mobile device, whether in addition to or instead of using GPS location data. In at least some such embodiments, however, the camera device does not have a GPS receiver and does not receive any of the GPS signals, or may instead receive some GPS signals but not with sufficient data to determine its own GPS location with a sufficient degree of accuracy (*e.g.,* below a defined distance or uncertainty threshold). In at least some embodiments, one or more additional devices may also be present at the building (*e.g.,* a drone device 179 inside or outside the building) that also receives the GPS signals 178 and optionally acquires further visual data, and if so, the further visual data and associated GPS location data (or other absolute location data) captured at further locations by such one or more additional devices may be used in combination with the camera device(s) and mobile device(s) to determine room shapes and to extend absolute location data to image acquisition locations and/or to floor plans (*e.g.,* to room shapes within floor plans), such as to further use triangulation as part of determining absolute location data for image acquisition locations in the manners described herein.

Various details are provided with respect to Figure 1, but it will be appreciated that the provided details are non-exclusive examples included for illustrative purposes, and other embodiments may be performed in other manners without some or all such details.

Figures 2A-2V illustrate examples of automatically generating a building floor plan based at least in part on analyzing visual data of target images captured at multiple acquisition locations in a building by a camera device to determine room shapes of the rooms surrounding the acquisition locations, and for determining and associating GPS location data or other absolute location with the generated floor plan based at least in part on additional data captured at other locations at the building by a separate mobile device that moves independently from the camera device (such as by extending absolute location data from data capture locations to other nearby image acquisition locations of the camera device and to surrounding room shapes visible in the acquired images), and for presenting generated building floor plans overlaid on maps and in other manners.

In particular, Figure 2A illustrates an example target image 250a, such as a non-panorama perspective image acquired by the camera device 184 in a northeasterly direction from image acquisition location 210B in the living room of house 198 of Figure 1 (or a northeasterly facing subset view formatted in a rectilinear manner of a 360-degree panorama image 255a taken from that image acquisition location) - the directional indicator 109a is further displayed in this example to illustrate the northeasterly direction in which the image is taken. In the illustrated example, the displayed image includes several visible elements (*e.g.,* light fixture 130a), furniture (*e.g.,* chair 192-1), two windows 196-1, and a picture 194-1 hanging on the north wall of the living room. No inter-room passages into or out of the living room (*e.g.,* doorways or other wall openings) are visible in this image. However, multiple room borders are visible in the image 250a, including horizontal borders between a visible portion of the north wall of the living room and the living room's ceiling and floor, horizontal borders between a visible portion of the east wall of the living room and the living room's ceiling and floor, and the inter-wall vertical border 195-2 between the north and east walls.

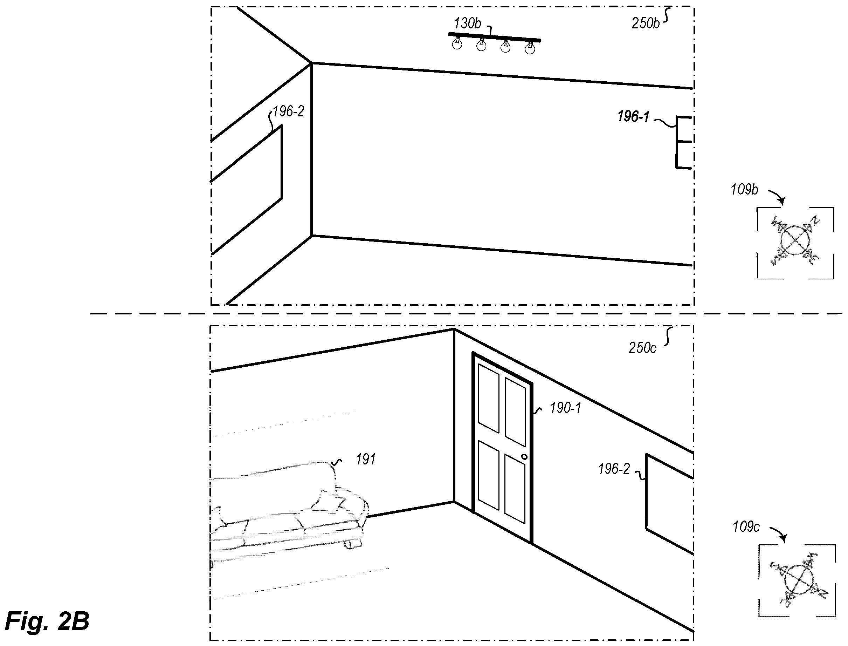

Figure 2A further illustrates an example target image 255a, such as 360° panorama image 255a captured by the camera device 184 from image acquisition location 210B, which displays the entire living room in an equirectangular format - since the panorama image does not have a direction in the same manner as perspective image 250a, the directional indicator 109 is not displayed for image 255a, although pose information for the panorama image may include one or more associated directions (*e.g.,* a starting and/or ending direction for the panorama image, such as if acquired via rotation). A portion of the visual data of panorama image 255a corresponds to the first perspective image 250a (shown in approximately the center portion of the image 255a), while the left portion of the image 255a and the far-right portion of the image 255a contain visual data corresponding to those of other perspective images 250b and 250c shown in Figure 2B - thus, for example, starting from image 255a, various perspective images may be rendered that include some or all of images 250a-250c (and optionally a large quantity of other images). This example panorama image 255a includes windows 196-1, 196-2 and 196-3, furniture 191-193, doorways 190-1 and 190-6, and non-doorway wall opening 263a to the hallway room (with the opening showing part of a doorway 190-3 visible in the adjacent hallway). Image 255a further illustrates a variety of room borders in a manner similar to that of perspective images 250a, but with the horizontal borders being displayed in an increasingly curved manner the farther they are from a horizontal midline of the image - the visible borders include vertical inter-wall borders 195-1 through 195-4, vertical border 195-5 at the north/left side of the hallway opening, vertical borders at the south/right side of the hallway opening, and horizontal borders between the walls and the floor and between the walls and the ceiling.

Figure 2B continues the example of Figure 2A, and illustrates a second perspective image 250b captured by the camera device 184 in a northwesterly direction from acquisition location 210B in the living room of house 198 of Figure 1 (with the directional indicator 109b further displayed to illustrate the northwesterly direction in which the image is taken), and a third perspective image 250c captured by the camera device 184 in a southwesterly direction in the living room of house 198 of Figure 1 from acquisition location 210B (with the directional indicator 109c further displayed to illustrate the southwesterly direction in which the image is taken) - as previously noted, the images 250b and 250c may instead be rendered from corresponding subset portions of panorama image 255a. In the example image 250b, a small portion of one of the windows 196-1 continues to be visible, along with a portion of window 196-2 and a new lighting fixture 130b, and horizontal and vertical room borders are visible in image 250b in a manner similar to that of Figure 2A. In the example image 250c, a portion of window 196-2 continues to be visible, as is a couch 191 and visual horizontal and vertical room borders, and a wall opening passage into/out of the living room is further shown (which in this example is a doorway 190-1 to enter and leave the living room, shown in Figure 1 as a door to the exterior of the house). It will be appreciated that a variety of other perspective images may be captured from acquisition location 210B and/or other acquisition locations and displayed in a similar manner.

Figure 2C illustrates further information 255c for a portion of the house 198 of Figure 1, including the living room and limited portions of the further rooms to the east of the living room. As discussed with respect to Figures 1 and 2A-2B, in some embodiments, target panorama images may be captured at various locations in the house interior, such as at locations 210A and 210B in the living room along a path 115 traveled by the camera device 184, with corresponding visual data of one or more such resulting target panorama images subsequently used to determine a room shape of the living room, as discussed further in subsequent figures. In addition, in at least some embodiments, absolute location data (*e.g.,* GPS location data) and optionally additional data (*e.g.,* compass geographical direction data, IMU-based motion data, additional images, etc.) may be captured by the mobile data capturing device 185 at one or more data capture locations along a path 116 - in this example, the mobile device 185 travels along a different path 116 in the living room, including a sequence of possible data capture locations 216 along the path at which one or more additional images and absolute location data may be captured, with some particular such data capture locations 216a-c indicated, although in other embodiments and situations the path 116 may be the same or substantially the same as path 115. In some embodiments, at least some additional images may be captured as the mobile device 185 moves along the path, such as if the mobile device is capturing video with a sequence of video frame images (*e.g.,* at 30 or 60 frames a second) or other sequences of images (*e.g.,* continuous or near-continuous images) and corresponding absolute location data (*e.g.,* GPS location data). In this example, the locations 216 along the path 116 are shown as being separated by short distances (*e.g.,* a foot, an inch, a fraction of an inch, etc.), although it will be appreciated that video capture may be substantially continuous - thus, in at least some embodiments, only a subset of such captured video frame images (or other images from a sequence of continuous or near-continuous images) may be selected and used for further analysis, such as images that are separated by defined distances and/or that are separated by a defined amount of time between their capture (*e.g.,* a second, a fraction of a second, multiple seconds, etc.) and/or based on other criteria.

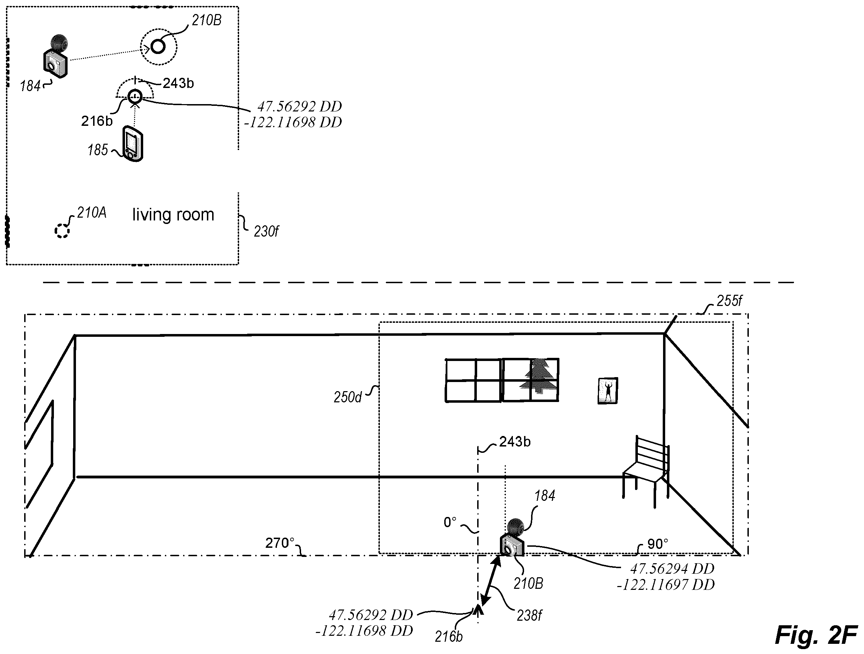

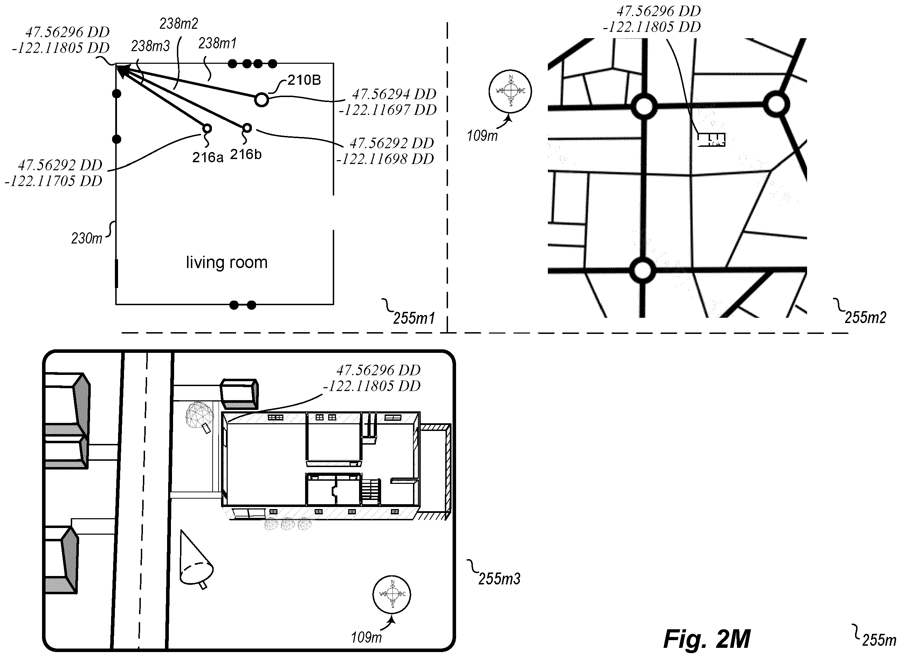

Figure 2C further illustrates information 201 with an example of how absolute location data from a selected data capture location 216 may be extended to a target image acquired at an image acquisition location 210 - in this example, image acquisition location 210B has been associated with data capture location 216a (*e.g.,* based on having the same or similar acquisition times), such as if data capture location 216a is selected from a group of data capture locations that are captured during a time window around the time of acquisition of the target image at image acquisition location 210B (*e.g.,* from a group of data capture locations that include at least 216a-216c). In this example, a distance 238c exists between locations 210B and 216a, such that a simplistic assignment of the GPS data for location 216a (in this example, 47.56292 DD, -122.11705 DD) without further refinement may result in an error of multiple feet to the actual absolute location of the image acquisition location 210B (in this example, 47.56294 DD, -122.11697 DD, as shown in Figure 2F). However, by determining a rigid transformation for multiple image acquisition locations across the building, the BFPGLDP system may eliminate or significantly reduce such translational errors, and further refinement activities may further improve the accuracy, as discussed in greater detail elsewhere herein. Such extension of the absolute location data from data capture location 216a to image acquisition location 210B may be further extended to some or all of the surrounding room shape that is visible in the target images acquired at image acquisition locations 210A and 210B, such as to determine the absolute location of northwest corner 195-1 of the living room (and of the building 198 - in this example, 47.56296 DD, -122.11805 DD, as shown in Figure 2M). Such a room shape may be determined based at least in part on the visual data of the target panorama image 255a captured at image acquisition location 210B and the additional visual data of a target panorama image captured at image acquisition location 21 0A, as discussed further with respect to subsequent figures. For example, example lines of sight 228 from location 210B to various example features in the room are shown, and similar example lines of sight (not shown) from location 210A to the same or other features may be determined and used in the room shape determination. The visual data of one or more such target panorama images acquired by the camera device may be further analyzed as part of determining an estimated room shape of the room, such as based on identifying planar surfaces corresponding to walls and wall structural elements (*e.g.,* windows, doorways, inter-wall borders, etc.), as discussed in greater detail elsewhere herein.

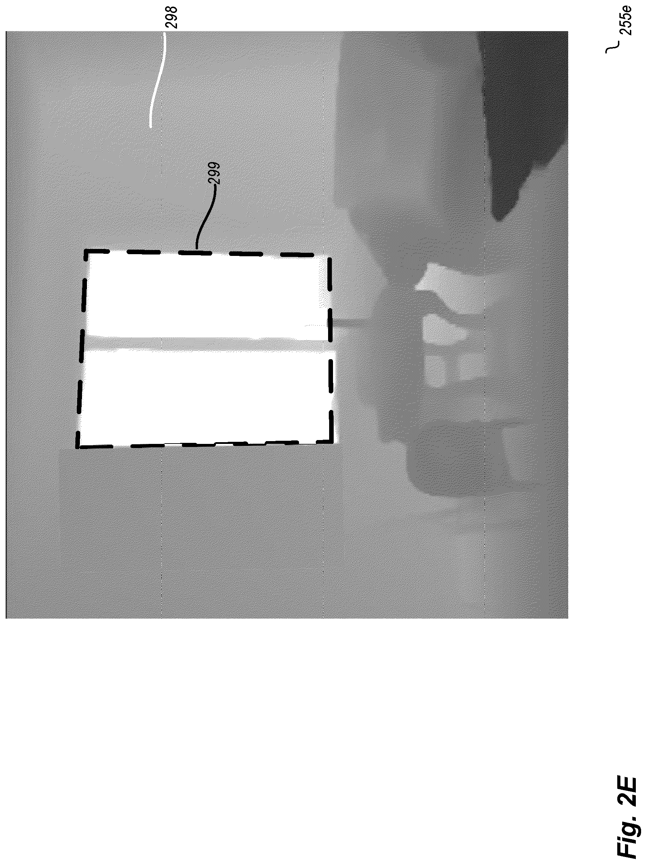

Figure 2D continues the examples of Figures 2A-2C, and illustrates additional information 255d (including information 255d1-255d5) as an example of analyzing multiple target images captured along the path 115 by the camera device for use in determining a room shape of the surrounding room. In particular, visual data from multiple target images captured in the room may be combined as part of determining an estimated room shape of the room, optionally in combination with concurrently captured IMU data - for example, analysis of multiple images from locations along path 115 may be performed using SLAM and/or MVS and/or SfM techniques to provide a variety of information about features of the living room, including information about a 3D point cloud (*e.g.*, as illustrated in Figure 2E), and further analysis may be used to determined associated surfaces planes of the features and normal orthogonal directions from the planes.

In particular, information 255d1 illustrates features of the northeast portion of the living room that are visible in multiple target images, and information 255d2 further illustrates similar information about features in the northwest portion of the living room that are visible in the same or other target images, with various example features shown (*e.g.*, corners 195-1 and 195-2, windows 196-1 and 196-2, etc.). As part of the automated analysis of the target images (*e.g.,* using the SLAM and/or MVS and/or SfM techniques), information about planes 286e and 286f corresponding to portions of the northern wall of the living room may be determined from the features that are detected, and information 287e and 285f about portions of the east and west walls of the living room may be similarly determined from corresponding features identified in the images. In addition to identifying such surface plane information for detected features (*e.g.,* for each point in a determined sparse 3D point cloud from the image analysis), the techniques may further determine information about likely acquisition pose (locations and orientations/directions) 220 and 222 for the target image(s) (*e.g.,* pose location 220g and optionally direction 220e in information 255d1 for acquisition location 210x1, and corresponding pose location 220g and optionally direction 220f in information 255d2, and pose location 222g and optionally direction 222e in information 255d1 for acquisition location 210x2, and corresponding pose location 220g and optionally direction 222f in information 255d2). While only features for part of the living room are illustrated in information 255d1 and 255d2, it will be appreciated that the other portions of the images corresponding to other portions of the living room may be analyzed in a similar manner, in order to determine possible information about possible planes for the various walls of the room, as well as for other features (not shown) in the living room. In addition, similar analyses may be performed between some or all other images captured in the living room, resulting in a variety of determined feature planes from the various image analyses that may correspond to walls of the room.

Information 255d3 further illustrates information about a variety of determined feature planes that may correspond to the west and north walls of the living room, from analyses of images captured from at least locations 210x1 and 210x2, and optionally further from images captured at other locations . The illustrated plane information includes determined planes 286g near or at the northern wall (and thus corresponding possible locations of the northern wall), and determined planes 285g near or at the western wall (and thus corresponding possible locations of the western wall). In this example, there are a number of variations in different determined planes for the northern and western walls from different features detected in the analysis of the images, such as differences in position, angle and/or length, causing uncertainty as to the actual exact position and angle of each of the walls. While not illustrated in information 255d3, it will be appreciated that similar determined feature planes for the other walls of the living room may similarly be detected, along with determined feature planes corresponding to features that are not along the walls (*e.g.,* furniture). Information 255d4 further illustrates additional determined feature planes that may correspond to the west and north walls of the living room, from analyses of various other images captured at the image acquisition locations along the path 115 in the living room by the camera device and/or at the data capture locations along the path 116 in the living room by the mobile device - in this example, the analyses of the further images provides even greater variations in different determined planes for the northern and western walls in this example. The information 255d4 further illustrates additional determined information that is used to aggregate information about the various determined feature planes in order to identify likely locations 295a and 295b of the west and north walls, as illustrated in information 255d5. In particular, information 255d4 includes indications 291a of normal orthogonal directions for some of the determined feature planes corresponding to the west wall, along with additional information 290a about those determined feature planes. In the example embodiment, the determined feature planes are clustered to represent hypothesized wall locations of the west wall, and the information about the hypothesized wall locations is combined to determine the likely wall location 295a, such as by weighting information from the various clusters and/or the underlying determined feature planes. In at least some embodiments, the hypothesized wall locations and/or normal information are analyzed via use of machine learning techniques to determine the resulting likely wall location, optionally by further applying assumptions or other constraints (such as a 90° corner, as illustrated 282 in information 255d3, and/or having flat walls) as part of the machine learning analysis or to results of the analysis. Similar analysis may be performed for the north wall using information 290b about corresponding determined feature planes and additional information 291b about resulting normal orthogonal directions for at least some of those determined feature planes. The resulting likely wall locations 295a and 295b for the west and north walls of the living room, respectively, are shown in information 255d5.

While not illustrated in Figure 2D, similar analyses may be performed for the other walls and optionally the floor and/or ceiling of the living room, and similarly for each of the other rooms of the building, providing estimated room shapes of each of the rooms. Furthermore, while not illustrated in Figure 2D, the analysis of the visual data captured by the mobile computing device may be supplemented and/or replaced in some embodiments by analysis of depth data (not shown) captured by the mobile computing device in the living room, such as to directly generate an estimated 3D point cloud from the depth data that represents the walls and optionally ceiling and/or floor of the living room and/or to directly generate estimated planar surfaces from the depth data that represent the walls and optionally ceiling and/or floor of the living room. While also not illustrated in Figure 2D, other room shape estimation operations may be performed in at least some embodiments using only a single target panorama image, such as via an analysis of the visual data of that target panorama image by one or more trained neural networks, as discussed in greater detail elsewhere herein.

Figure 2E continues the examples of Figures 2A-2D, and illustrates information 255e about additional information that may be generated from one or more images in a room and used in one or more manners in at least some embodiments. In particular, images (*e.g.,* video frames) captured in the living room of the house 198 may be analyzed in order to determine an estimated 3D shape of the living room, such as from a 3D point cloud of features detected in the video frames (*e.g.,* using SLAM and/or SfM and/or MVS techniques, and optionally further based on IMU data captured by the mobile device 185). In this example, information 255e reflects an example portion of such a point cloud for the living room, such as in this example to correspond to a northwesterly portion of the living room (*e.g*., to include northwest corner 195-1 of the living room, as well as at least part of windows 196-1) in a manner similar to image 250c of Figure 2B. Such a point cloud may be further analyzed to determine planar areas, such as to correspond to walls, the ceiling, floor, etc., as well as in some cases to detect features such as windows, doorways and other inter-room openings, etc. - in this example, a first planar area 298 corresponding to the north wall of the living room is identified, with a second planar area 299 corresponding to at least part of windows 196-1 being further identified. It will be appreciated that in other embodiments such an estimated 3D shape of the living room may be determined by using depth data captured by the mobile device 185 in the living room, whether in addition to or instead of using visual data of one or more images captured by the camera device 184 and/or mobile computing device 185 in the living room. In addition, it will be appreciated that various other walls and other features may be similarity identified in the living room and in the other rooms of the house 198.

Figure 2F continues the examples of Figures 2A-2E, and illustrates further information 230f that shows the living room of the house 198 of Figure 1, and about additional second image 255f acquired at data capture location 216b by the mobile device 185. In this example, second image 255f is acquired at orientation direction 243b from location 216b, such as at the same time as the acquisition of the target image 255a (shown in Figure 2A) by the camera device at acquisition location 210B, and is a 180° panorama image (shown in a rectilinear perspective format), although in other situations may be a non-panoramic rectilinear perspective image (*e.g.,* example image 250d, which is shown as a subset of the image 255f in this example). As illustrated in example further image 255f, the visual data of the further image may include visible portions of some or all of the camera device 184. In this example, the mobile device further captures GPS coordinates of 47.56292, -122.11698 (using decimal degrees format) for the data capture location 216b, as shown in information 230f, and those absolute location data coordinates will subsequently be extended to determined refined GPS coordinates of 47.56294, -122.11697 for the image acquisition location 210B that reflect the offset distance 238f between them, as discussed further below.

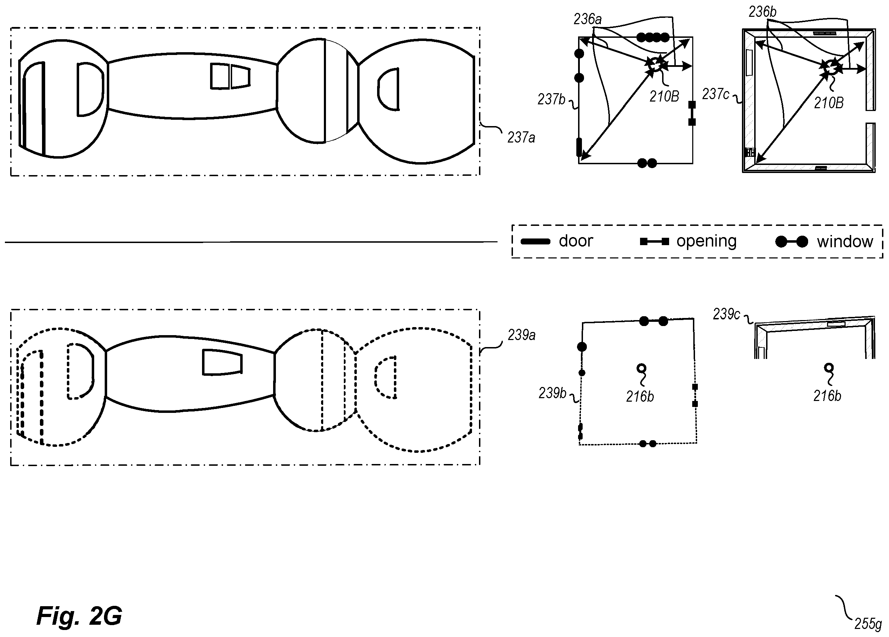

Figure 2G continues the examples of Figures 2A-2F, and includes information 255g that illustrates one or more types of estimated room shape information 237 for the living room based on an analysis by the BFPGLDP system of at least the visual data of the target image(s) captured by the camera device in the living room, such as target panorama image 255a captured from image acquisition location 210B, and optionally further based on visual of one or more second images captured by the mobile device in the living room. In particular, in this example, the estimated room shape information 237 includes information 237a about structural wall elements identified in the visual data (*e.g.,* wireframe lines of the room outline) of the target image(s), and/or information 237b to show a 2D estimated room shape for the living room from analysis of the visual data of the target image(s), and/or information 237c to show a 3D estimated room shape for the living room from analysis of the visual data of the target image(s). In this example, the locations of structural wall elements such as windows and doorways and other wall openings may be automatically identified and shown on the room shape information 237b and/or 237c - in addition, the position of the image acquisition location(s) of the target image(s) used in the room shape determination may be further determined within that room shape, as shown for image acquisition location 210B, such as with directions and distances 236a and/or 236b between that image acquisition location position to that of walls and/or other parts of the determined room shape(s). As discussed in greater detail elsewhere herein, the estimation of the room shape for the living room from the visual data of the target image may be performed in various manners.

Figure 2G further illustrates one or more additional types of estimated room shape information 239 for the living room based on an analysis by the BFPGLDP system of additional data captured by the mobile device that includes one or more additional second images captured at data capture location 216b (*e.g.,* second image 255f) in this example, although in some embodiments such visual data may not be captured by the mobile device or may not be used by the BFPGLDP system - in particular, in this example, the estimated room shape information 239 includes information 239a about structural wall elements identified from analysis of the visual data of the second image(s), and/or information 239b to show a 2D estimated room shape for the living room from analysis of the visual data of the second image(s), and/or information 239c to show a 3D estimated room shape for the living room from analysis of the visual data of the second image(s). In this example, the estimated room shape information 239a and 239b includes solid lines to correspond to the portion of the living room visible in the further image 255f of Figure 2F, while estimated room shape information 239c only includes information to correspond to that portion of the living room - however, if other further images (not shown) have visual data for other parts of the living room, then a combination of the visual data from the multiple further images may further include information shown in dotted lines in the estimated room shape information 239a and 239b, and may be used to add additional information to the estimated room shape information 239c. In this example, the locations of structural wall elements such as windows and doorways and other wall openings may be automatically identified and shown on the room shape information 239b and/or 239c - in addition, the position of the data capture location(s) of the additional second image(s) used in the room shape determination may be further determined within that room shape, as shown for data capture location 216b. It will be appreciated that the automated determination of the estimated room shape information 237 and 239 may not produce perfect room shapes, such that differences may exist between the estimated room shape information 237 and 239. In addition, while not illustrated with respect to information 239, the position of the data capture location(s) at which the second image(s) used in the room shape determination are acquired may be further determined within that room shape.

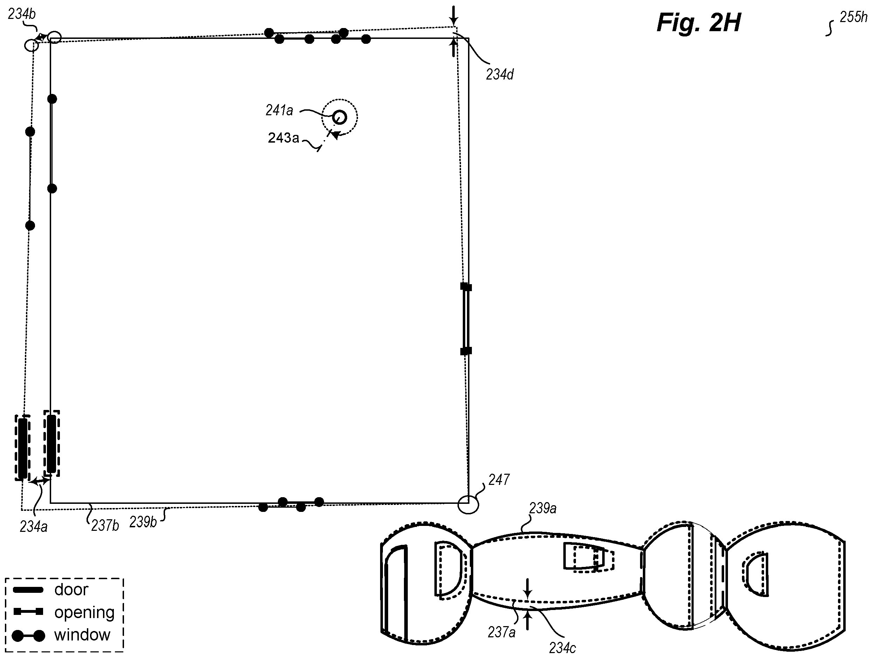

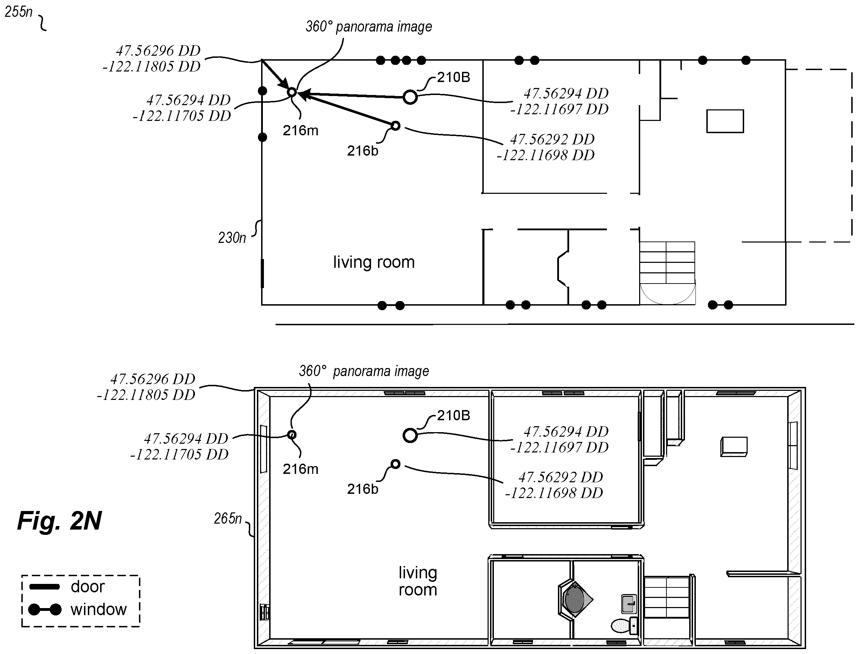

Figure 2H continues the examples of Figures 2A-2G, and includes information 255h that illustrates some of the further automated operations of the BFPGLDP system when comparing the multiple estimated room shapes 237 and 239 of Figure 2G, such as to combine information from analysis of one or more target images captured by the camera device (*e.g.,* target panorama image 255a from image acquisition location 210B, additional target panorama image from image acquisition location 210A, etc.), and optionally from analysis of one or more second images captured by the mobile device (*e.g.*, from data capture location 216b). As discussed in greater detail elsewhere herein, a variety of matching criteria may be used in determining a fit between two room shapes. As one example, lower right corners 247 may be initially matched, and distances between one or more (*e.g.,* all) matching corners of the estimated room shape and determined room shape may be measured, such as shown 234b for the two corners in the upper left (northwest) corners, with the smaller the distance reflecting the better the match (and in some embodiments, the higher the matching score) - while not shown for the other corners in this example, their distances for matching corners may be similarly measured and assessed. As another example, distances between one or more (*e.g.,* all) corresponding wireframe structural lines of the estimated room shape and determine room shape may be measured, such as shown 234c for the two wireframes corresponding to the border of the northern wall to the floor, with the smaller the distance reflecting the better the match (and in some embodiments, the higher the matching score) - while not shown for the other structural lines in this example, their distances between corresponding lines may be similarly measured and assessed. As yet another example, distances between one or more (*e.g.,* all) structural wall elements identified in the estimated room shape may be measured (*e.g.*, using corresponding 3D bounding boxes for those structural wall element objects), such as shown 234a for the two doorways at the lower left side of the rooms, and with the smaller the distance reflecting the better the match (and in some embodiments, the higher the matching score), although the entire bounding box areas may be compared in other embodiments (*e.g.,* using an intersection-over-union distance measurement) - while not shown for other structural element objects in this example, their distances between corresponding bounding box portions may be similarly measured and assessed. As another example, distances between one or more (*e.g.,* all) corresponding walls of the multiple room shapes may be measured, such as shown 234d for the two walls on the top side of the room shapes, with the smaller the distance reflecting the better the match (and in some embodiments, the higher the matching score) - while not shown for other walls in this example, their distances between corresponding walls may be similarly measured and assessed. Various other criteria may be accessed and used, whether in addition to or instead of some or all of the illustrated criteria, as discussed in greater detail elsewhere herein. The various distance offsets between the multiple room shapes may be combined and used to determine the position 241a of the target panorama image and optionally acquisition orientation 243a within the room shape information - it will be appreciated that while only two degrees of freedom are shown in Figure 2H for each of the acquisition location and orientation, the actual determined acquisition location and orientation information may be determined with three degrees of freedom for each of the acquisition location and orientation (*e.g.,* a height of the acquisition location above the floor, and an upward or downward angle from that acquisition location height for the acquisition position). In addition, once the acquisition position information is determined for such a target image, it may be shown on updated versions of the floor plan for the building, such as illustrated for updated floor plans 230n and 265n in information 255n of Figure 2N.

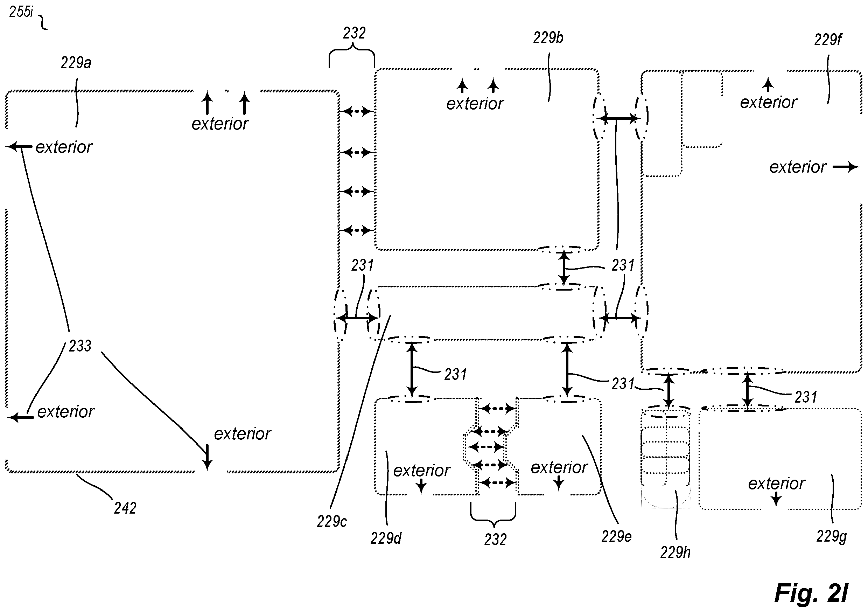

Figure 2I illustrates additional information 255i corresponding to, after estimated room shapes are determined for the rooms of the illustrated floor of the house 198, positioning the rooms' estimated room shapes 229a-229h relative to each other, based at least in part in this example on connecting inter-room passages between rooms and matching room shape information between adjoining rooms - in at least some embodiments, such information may be treated as constraints on the positioning of the rooms, and an optimal or otherwise preferred solution is determined for those constraints. Examples of such constraints in Figure 2I include matching 231 connecting passage information (*e.g.*, passages detected in the automated image analyses discussed with respect to Figures 2C-2E) for adjacent rooms so that the locations of those passages are co-located, and matching 232 shapes of adjacent rooms in order to connect those shapes (*e.g.*, as shown for rooms 229d and 229e, and for rooms 229a and 229b). Various other types of information may be used in other embodiments for room shape positions, whether in addition to or instead of passage-based constraints and/or room shape-based constraints, such as exact or approximate dimensions for an overall size of the house (*e.g.,* based on additional metadata available regarding the building, analysis of images from one or more image acquisition locations external to the building, etc.). House exterior information 233 may further be identified and used as constraints (*e.g.*, based at least in part of automated identification of passages and other features corresponding to the building exterior, such as windows), such as to prevent another room from being placed at a location that has been identified as the building's exterior.

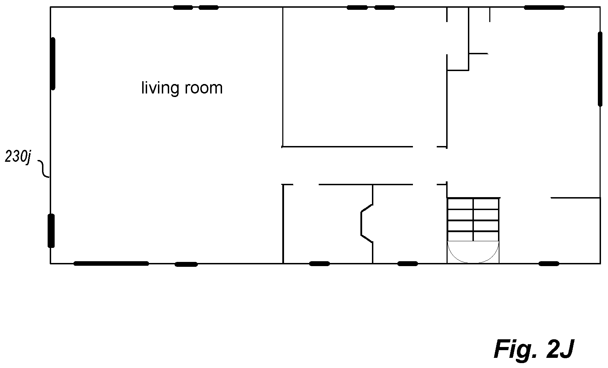

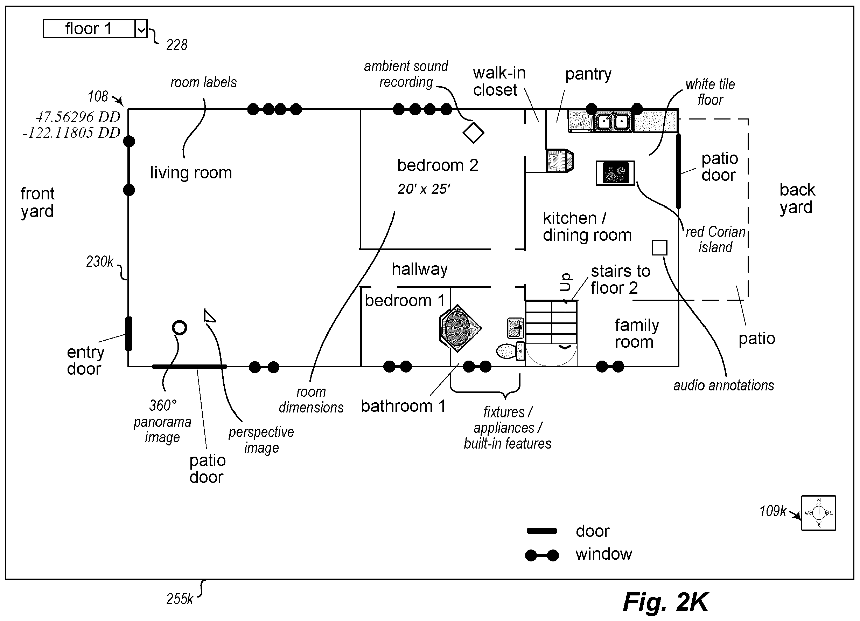

Figures 2J through 2L continue the examples of Figures 2A-2I, and illustrate mapping information that may be generated from the types of analyses discussed in Figures 2A-2I. In particular, Figure 2J illustrates an example floor plan model 230j that may be constructed based on the positioning of determined estimated room shapes, which in this example includes walls and indications of doorways and windows. In some embodiments, such a floor plan may have further information shown, such as about other features that are automatically detected by the analysis operations and/or that are subsequently added by one or more users. For example, Figure 2K illustrates a modified floor plan 230k that includes additional information of various types, such as may be automatically identified from analysis operations of visual data from images and/or from depth data, and added to the floor plan 230j, including one or more of the following types of information: room labels (*e.g.,* "living room" for the living room), room dimensions, visual indications of fixtures or appliances or other built-in features, visual indications of positions of additional types of associated and linked information (*e.g.,* of panorama images and/or perspective images acquired at specified acquisition positions, which an end user may select for further display; of audio annotations and/or sound recordings that an end user may select for further presentation; etc.), visual indications of doorways and windows, etc. - in other embodiments and situations, some or all such types of information may instead be provided by one or more MIGM system operator users and/or IDCA system operator users and/or BFPGLDP system operator users. In addition, when the floor plans 230j and/or 230k are displayed to an end user, one or more user-selectable controls may be added to provide interactive functionality as part of a GUI (graphical user interface) screen such as screen 255k, such as to indicate a current floor that is displayed, to allow the end user to select a different floor to be displayed, etc., with a corresponding example user-selectable control 228 added to the GUI in this example - in addition, in some embodiments, a change in floors or other levels may also be made directly from the displayed floor plan, such as via selection of a corresponding connecting passage (*e.g.,* a stairway to a different floor), and other visual changes may be made directly from the displayed floor plan by selecting corresponding displayed user-selectable controls (*e.g.*, to select a control corresponding to a particular image at a particular location, and to receive a display of that image, whether instead of or in addition to the previous display of the floor plan from which the image is selected). In other embodiments, information for some or all different floors may be displayed simultaneously, such as by displaying separate sub-floor plans for separate floors, or instead by integrating the room connection information for all rooms and floors into a single floor plan that is shown together at once. It will be appreciated that a variety of other types of information may be added in some embodiments, that some of the illustrated types of information may not be provided in some embodiments, and that visual indications of and user selections of linked and associated information may be displayed and selected in other manners in other embodiments.

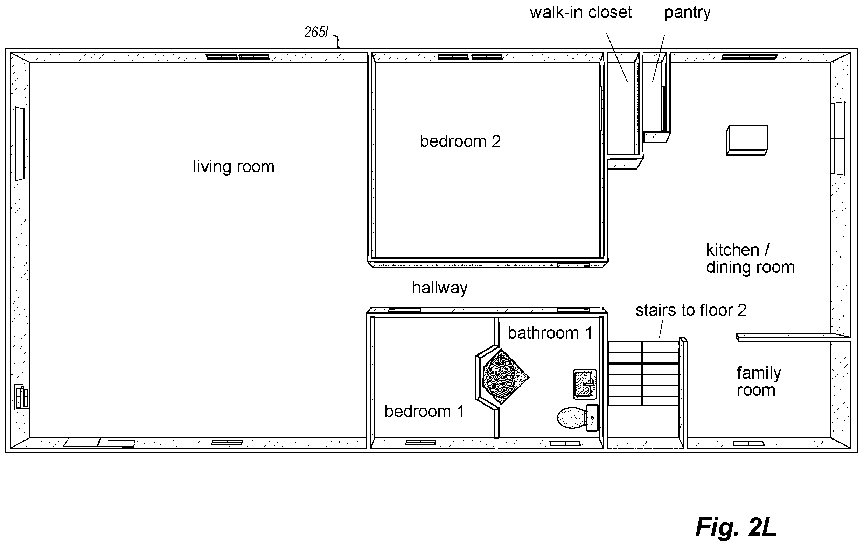

Figure 2L continues the examples of Figures 2A-2K, and illustrates additional information 265l that may be generated from the automated analysis techniques disclosed herein and displayed (*e.g.,* in a GUI similar to that of Figure 2K), which in this example is a 2.5D or 3D model floor plan of the house. Such a model 265l may be additional mapping-related information that is generated based on the floor plan 230j and/or 230k, with additional information about height shown in order to illustrate visual locations in walls of features such as windows and doors - while not illustrated in Figure 2L, some or all of the additional types of information shown in Figure 2K for a 2D floor plan model may be similarly shown in a 3D floor plan model such as is shown in Figure 2L. While also not illustrated in Figure 2L, additional information may be added to the displayed walls in some embodiments, such as from images taken during the video capture (*e.g.,* to 'texture map' walls by rendering and illustrating actual paint, wallpaper or other surfaces from the house on the rendered model 265), and/or may otherwise be used to add specified colors, textures or other visual information to walls and/or other surfaces.

Figure 2M continues the examples of Figures 2A-2L, and further illustrates information 255m about associating absolute location data with determined room shapes and corresponding generated floor plans. In particular, as discussed previously with respect to Figures 2C and 2F, GPS location data may be determined by the mobile device for multiple data capture locations, such as locations 216a and 216b, and may be extended to image acquisition locations, such as location 210B, such as shown in information 255m1. In addition, positions of such image acquisition locations within a corresponding determined room shape may be determined, such as distance and direction 238m1 to the northwest corner of the room (and also the northwest corner of the building in this example), as discussed with respect to Figure 2G - similar distance and direction information for data capture locations may be similarly determined in some embodiments and situations, such as if second images are captured from those data capture locations and used as part of the room shape determination and/or if depth data is captured from those data capture locations and used, such as for distances and directions 238m2 and 238m3 to the northwest corner of the room for data capture locations 216b and 216a, respectively. It will be appreciated that such extension of GPS location data or other absolute location data from an image acquisition location such as 210B to positions in a surrounding room shape may be performed for a variety of room shape positions (*e.g*., each corner, each wall midpoint, each window or doorway, etc.), and may be associated with corresponding locations on a resulting generated floor plan in a variety of manners.

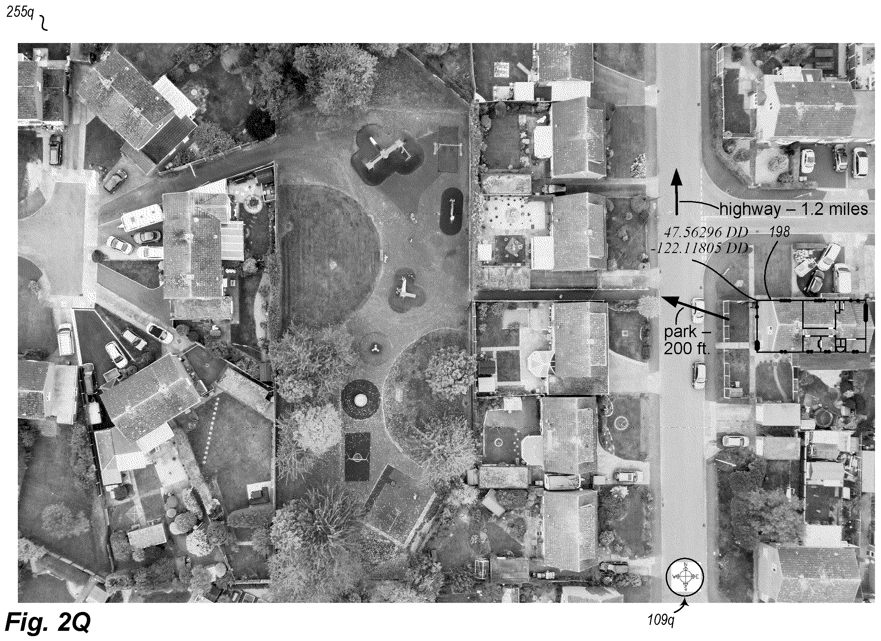

Figure 2M further illustrates information about using GPS location data (or other absolute location data) that is associated with a generated floor plan to indicate the position of the floor plan on a larger map, such as to overlay a visual representation of that associated absolute location data on the map (*e.g.,* as a dot or other visual indicator for one or more particular floor plan points; by showing the actual generated floor plan at its determined location; by showing one or more building images, such as an overhead image; etc.). In the example information of 255m2, the 2D floor plan for the building 198 is overlaid on or otherwise displayed as part of a larger map from an overhead view, and the example information of 255m3 similarly shows a 3D model of the first floor of building 198 on a map at a higher level of zoom. The information 255m2 and 255m3 further illustrates how geographical direction information associated with a floor plan may be further used, including with respect to the displayed geographical direction indicators 109m. It will be appreciated that such map displays may include a variety of other types of information and functionality, including those discussed further with respect to examples of Figures 2Q-2V. Such absolute location data and/or geographical direction data associated with a floor plan may be further used in various other manners in other embodiments.

Figure 2N continues the examples of Figures 2A-2M, and further illustrates information 255n about, after generating a building floor plan, determining an additional position and absolute location data for an additional image (not shown) that is acquired at a new acquisition location 216m in the living room of the house 198. In this example, visual data of the additional image may be analyzed in a manner similar to that discussed elsewhere herein to determine a relative position of the additional acquisition location, such as a relative position within a room shape of the living room and/or inter-location pose information between the additional acquisition location and a previous location in the room for which location data was determined (*e.g.,* image acquisition location 210B, data capture location 216b, etc.). The previously determined GPS location data for the room (in this example, for the northwest corner of the room) and/or for the previous location in the room for which location data was determined (in this example, one or both of locations 210B and 216b) may be used to extend the previously determined GPS location data to the new acquisition location 216m, and corresponding information may be displayed (*e.g.,* overlaid on a 2D floor plan 230m and/or on a 3D model 265m) in a manner similar to that illustrated in Figure 2N or otherwise provided to one or more recipients.

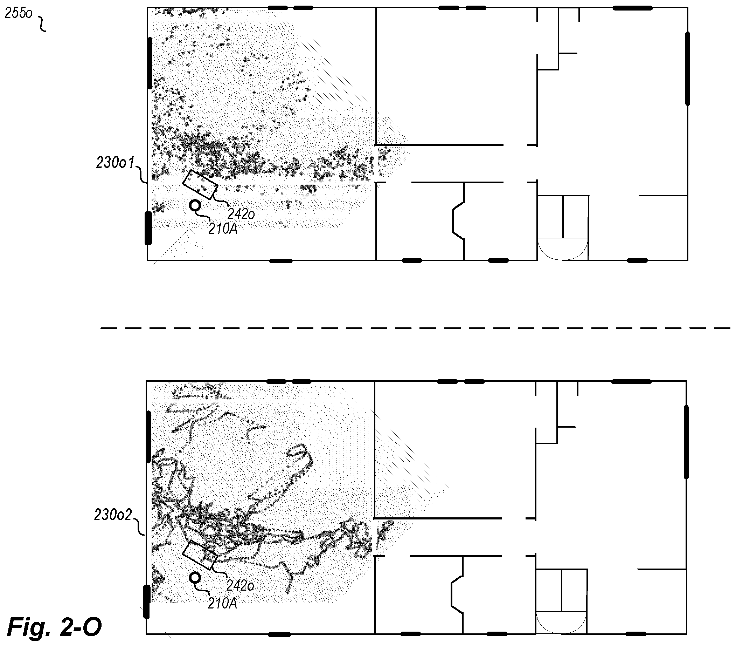

Figure 2O (referred to herein as "2-O" to prevent confusion with the numeral 20) continues the examples of Figures 2A-2N, and further illustrates information 255o to provide an example of smoothing operations for absolute location data points captured in the living room of the example house 198. In particular, information 230o1 shows original GPS data points as a mobile device moves around the living room, and information 230o2 shows revised GPS data point information after a smoothing operation is performed. As is apparent, the smoothed data better illustrates paths reflecting the movement of the mobile device as the GPS data points are captured, in addition to removing outlier data. In addition, a subset 242o of GPS data points are illustrated that are selected as being potentially associated with image acquisition location 210A, such as being acquired in a time window near the time of acquisition of the target image acquired for location 210A, for use in determining a representative GPS data point to associate with that target image. Additional details are included elsewhere herein regarding performing such smoothing operations.

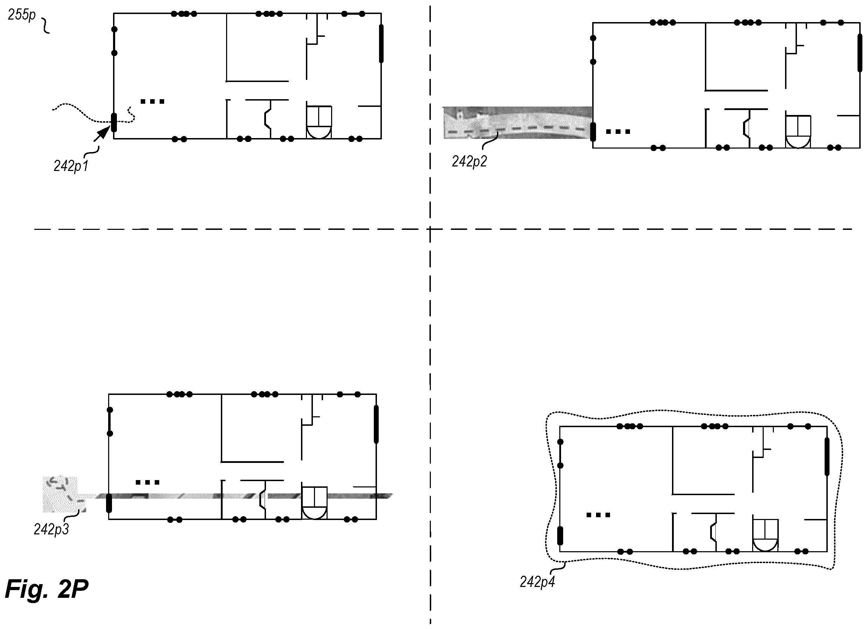

Figure 2P continues the examples of Figures 2A through 2-O, and further illustrates information 255p to provide an example of using additional data for the example house 198 to improve the accuracy of GPS data points in the interior of the house and/or to assist in determining structural information for the house such as an exterior boundary, an external door, a driveway or other walkway leading to the house, etc., such as based at least in part on additional GPS data points captured during a traversal of one or more external areas around the house (*e.g.,* on the property on which the house is located). In particular, information 242p1 illustrates an example of using captured absolute location data from a data capturing device (*e.g.*, detected motion trajectory information) for an external doorway of the house, such as to determine an absolute location of the external doorway based on identifying a transition from outside the house to inside the house (*e.g.,* from analysis of visual data being captured, from an input of a human operator at a time of the transition, etc.) and selecting associated absolute location data for that time - in this example, a series of captured absolute location data points from a mobile capturing device are illustrated to show a path approaching the external doorway and continuing on after passing through the external doorway. In addition, information 242p2 illustrates an example of using captured absolute location data from a data capturing device to detect and align linear exterior motion with external walkways or a driveway, such as to determine absolute locations of the external walkway or driveway - in this example, a series of captured absolute location data points are illustrated to show a path approaching the external doorway corresponding to a walkway to the front doorway of the house. Information 242p3 illustrates an example of using additional human operator activity data to improve GPS signal quality, such as to have the human operator user trace a specified external pattern before entering a building to improve GPS signal calibration that will improve the subsequent in-building GPS data points - in this example, a series of captured absolute location data points are illustrated to show a path external to the house before entering the house. Information 242p4 illustrates an example of using additional human operator activity data to have the human operator user trace some or all of the outer boundary of a building to enable matching the shape of the generated floor plan to that boundary - in this example, a series of captured absolute location data points are illustrated to show a path external to the house.

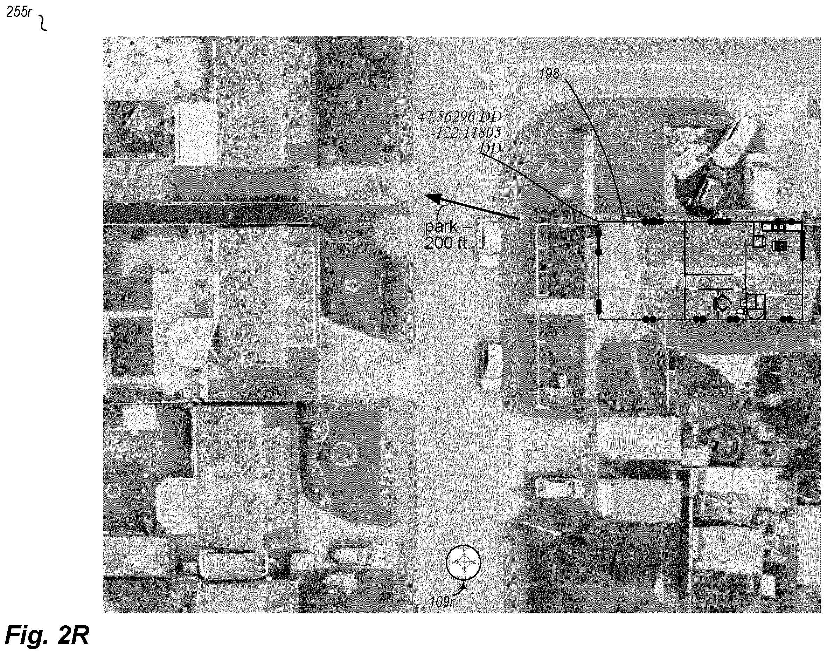

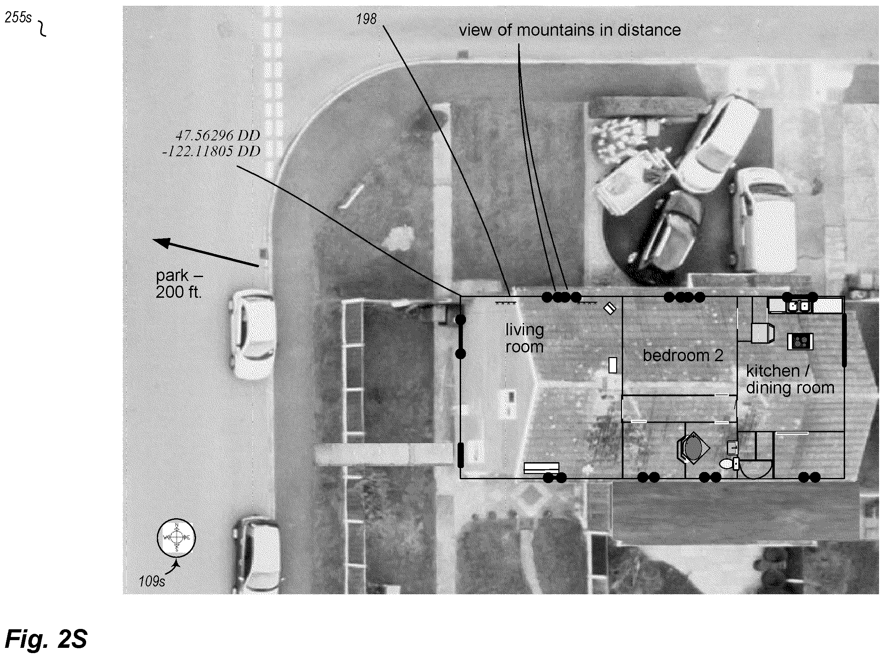

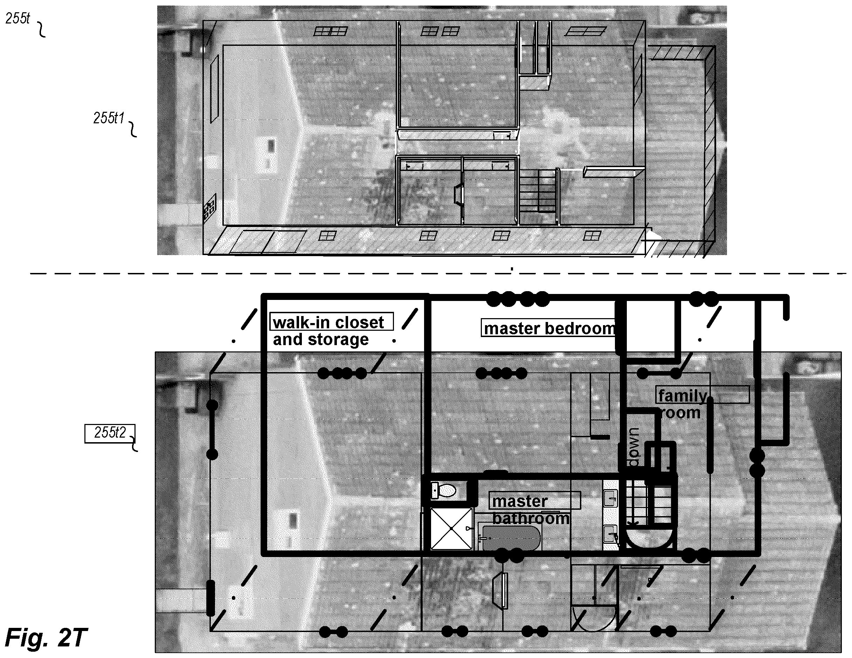

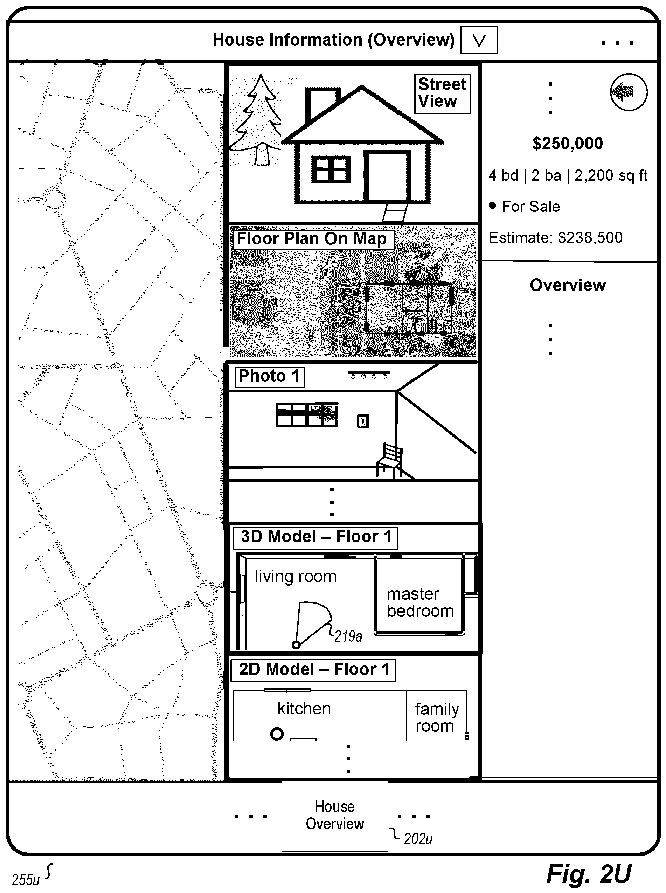

Figures 2Q-2V continue the examples of Figures 2A-2P, and further illustrate information to provide examples of automated operations of the BFPGLDP system to automatically present a building floor plan having associated absolute location data using surrounding real-world data for the associated absolute location(s) of the building floor plan, such as in a GUI that optionally contains various additional types of information and/or types of functionality. In particular, Figure 2Q shows information 255q that includes a map showing several houses in a neighborhood using an overhead image, including house 198 - in addition, part of a 2D floor plan model for the house is overlaid on the visual image of house 198. In this example, the overlaid 2D floor plan model includes only a single story of the house, and shows only structural elements of the house that include walls, doorways, windows and stairways. Figure 2Q further illustrates overlaying additional information on the map proximate to the visual representation of the building floor plan and to show nearby points of interest with information relative to the location of the building floor plan, such as a nearby park and a direction of the nearest highway, as well as directional information 109q and absolute location data for the northwest corner of the house 198, although in other embodiments and situations some or all such additional information may not be shown (*e.g.,* based on user selections and/or preferences), or instead may be overlaid on or otherwise included on the visual representation of the building floor plan. Figure 2R shows information 255r that is a zoomed-in version of the map of Figure 2Q, and in which additional elements of the 2D floor plan model are displayed - in particular, at the illustrated level of zoom, built-in structures and some fixtures and appliances are illustrated, such as in the bathroom and kitchen, in a manner similar to Figure 2K. Figure 2R further illustrates overlaying additional information on the map to show nearby points of interest in a manner similar to Figure 2Q, such as a direction to a nearby park, as well as directional information 109r and absolute location data for the northwest corner of the house 198, although in other embodiments and situations some or all such additional information may not be shown (*e.g.,* based on user selections and/or preferences). Figure 2S shows information 255s that is a further zoomed-in version of the map of Figure 2Q, and in which further elements of the 2D floor plan model are displayed - in particular, at the illustrated level of zoom, in addition to the built-in structures and some fixtures and appliances, furniture and other built-in fixtures (*e.g.,* track lighting) and labels are illustrated, such as in the living room. In addition, Figure 2S further illustrates adding additional information about the surrounding area, such as to provide information about the view from the north windows in the living room, as well as additional information on the map to show nearby points of interest in a manner similar to Figure 2Q, such as a direction to a nearby park, as well as directional information 109s and absolute location data for the northwest corner of the house 198, although in other embodiments and situations some or all such additional information may not be shown (*e.g.,* based on user selections and/or preferences). Figure 2T shows information 255t that illustrates further alternatives for presenting floor plan information overlaid on an overhead image of the house, and in other embodiments and situations similar floor plan information may be overlaid on a street-level image of a front of the house. In these examples, information 255t1 shows an example of overlaying a 3D floor plan model of a first story of the house on the overhead image of the house, and information 255t2 shows an example of overlaying 2D floor plan information for multiple stories on the overhead image of the house, with a second story emphasized in this example using heavier lines for walls and additional types of information displayed (*e.g.,* room labels), as well as using different colors for the structural elements of the different stories in this example. Figure 2U illustrates an alternative view in which information 255u about a house floor plan overlaid on a map is illustrated as part of a group of information displayed about the house, such as the house floor plan overlaid on a map being shown in conjunction with multiple types of information in a GUI, corresponding to selection of control 202u by an end user. In this example, the displayed information includes an array of images captured for the house (*e.g.,* photo 1, etc.) and other types of building information, that in this example include a street view of the house, a 3D computer model of the house (in this example indicating the acquisition location and orientation 219a of an acquired image), a 2D floor map model of the house, etc. - it will be appreciated that other types of building information may similarly be shown, such as an interactive tour, videos, animations, non-visual data (*e.g.,* audio recordings), etc. In this example, each image or other type of building information shown in the array may be selectable by the user, such as for that selected building information type to become the primary (or only) type of information shown in an updated GUI display. It will be appreciated that various other types of information may similarly be available via such an interface of Figure 2U, such as textual information (*e.g.,* facts about the building; a larger map of the surrounding area; an asking price for a building that is available for sell or other type of possible acquisition, such as rental; an estimated value for a building for a sale or other type of possible acquisition, such as based on an automated determination using a comparison to data about other similar buildings or in another manner; etc.).

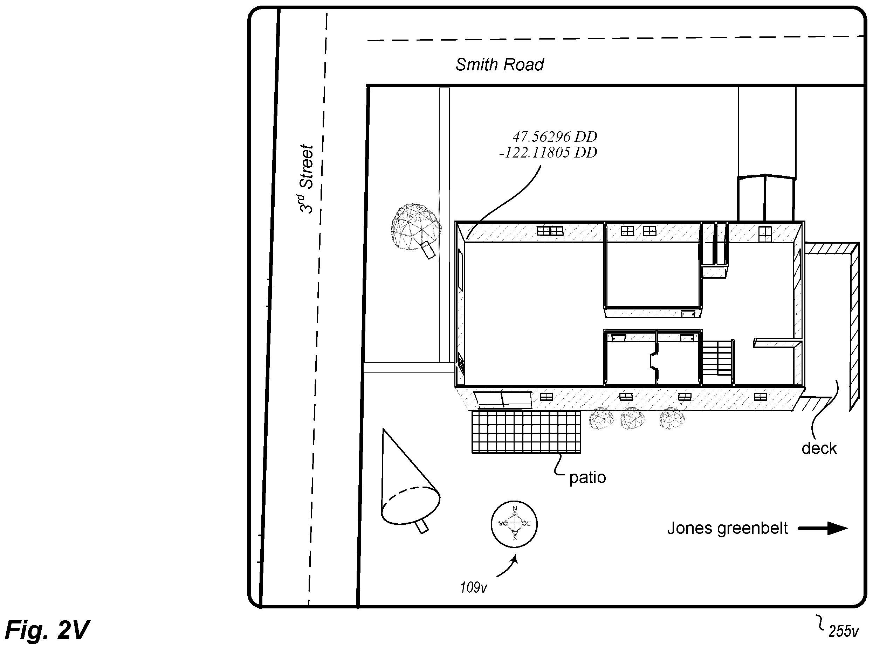

Figure 2V illustrates an alternative view in which information 255v about a house floor plan model is displayed with information about one or more features external to the house, such as to provide a 'site-plan' visualization of the property on which the house is located. In this example, a visual representation of the floor plan is shown (in this case, the first story of a 3D model) along with information about the property on which the house is located, as well as the adjacent roads, with information about the property including visual representations of vegetation, walkways and other paved or covered or finished surfaces (*e.g.,* a patio on a south side of the house, a deck on the east side of the house, etc.), information about adjacent features (*e.g.,* a greenbelt to the east of the property), an attached garage and optionally other structures (not shown), etc. - in this example, various of the external features are shown using geometric shapes or other abstractions, but in other embodiments may be shown in other manners, such as using actual images of the individual features and/or of all of the property. It will be appreciated that a variety of other types of external features may be shown, and that additional types of information about a property or other site may be included in some embodiments and situations.

Various details have been provided with respect to Figures 2A-2V, but it will be appreciated that the provided details are non-exclusive examples included for illustrative purposes, and other embodiments may be performed in other manners without some or all such details.

Figure 3 is a block diagram illustrating an embodiment of one or more computing systems 180 executing an implementation of a BFPGLDP system 140 (*e.g.*, in a manner analogous to that of Figure 1), and one or more server computing systems 380 executing an implementation of an IDCA system 150 and an MIGM system 160 - the computing system(s) 180 and BFPGLDP system, and/or computing system(s) 380 and/or IDCA and MIGM systems, may be implemented using a plurality of hardware components that form electronic circuits suitable for and configured to, when in combined operation, perform at least some of the techniques described herein. Mobile data capture devices 185 may each be executing one or more client applications and/or other programs 154, and one or more other computing systems and devices may optionally be executing a BFPGLDP system client application and/or other building information viewer system 396 (such as each mobile device 175) and/or optional other programs 335 and 383 (such as server computing system(s) 180 and 380, respectively, in this example). In the illustrated embodiment, each server computing system 180 includes one or more hardware central processing units ("CPUs") or other hardware processors 305, various input/output ("I/O") components 310, storage 320, and memory 330, with the illustrated I/O components including a display 311, a network connection 312, a computer-readable media drive 313, and other I/O devices 315 (e.g., keyboards, mice or other pointing devices, microphones, speakers, GPS receivers, etc.). Each server computing system 380 may have similar components, although only one or more hardware processors 381, memory 385, storage 384 and I/O components 382 are illustrated in this example for the sake of brevity.

The server computing system(s) 180 and executing BFPGLDP system 140, and server computing system(s) 380 and executing IDCA and MIGM systems 150 and 160, and data capture devices 185 and executing software 154, and mobile devices 175 and executing software 396 may communicate with each other and with other computing systems and devices in this illustrated embodiment, such as via one or more networks 199 (e.g., the Internet, one or more cellular telephone networks, etc.), including to interact with optional other navigable devices 395 that receive and use floor plans and optionally other generated information for navigation purposes (e.g., for use by semi-autonomous or fully autonomous vehicles or other devices), and for capture devices 185 to communicate with building devices, not shown (e.g., using communication and/or sensor components to receive transmissions from transmitter devices and/or to otherwise communicate with other building devices, such as electronic lockboxes or locks, smart home devices, etc.). The mobile devices 175 in this example embodiment are illustrated as including one or more displays 392 on which to present provide building information from the BFPGLDP system, and optionally other components 394 (*e.g*., computing resources, I/O components, sensors, etc.). Some of the described functionality may be combined in less computing systems in other embodiments, such as to combine some or all of the BFPGLDP system 140 with a building information viewer system 396 in a single system or device (e.g., a mobile device 175), to combine the BFPGLDP system 140 and the data capture functionality of device(s) 185 in a single system or device, to combine the IDCA and MIGM systems 150 and 160 and the data capture functionality of device(s) 185 in a single system or device, to combine the BFPGLDP system 140 and one or both of the IDCA and MIGM systems 150 and 160 in a single system or device, to combine the BFPGLDP system 140 and the IDCA and MIGM systems 150 and 160 and the data capture functionality of device(s) 185 in a single system or device, etc.

In the illustrated embodiment, an embodiment of the BFPGLDP system 140 executes in memory 330 of the server computing system(s) 180 in order to perform at least some of the described techniques, such as by using the processor(s) 305 to execute software instructions of the system 140 in a manner that configures the processor(s) 305 and computing system 180 to perform automated operations that implement those described techniques. The illustrated embodiment of the BFPGLDP system may include one or more components (not shown), such as to each perform portions of the functionality of the BFPGLDP system, and the memory may further optionally execute one or more other programs 335 - as one specific example, a copy of the IDCA and/or MIGM systems may execute as one of the other programs 335 in at least some embodiments, such as instead of or in addition to the IDCA and/or MIGM systems 150 and 160 on the server computing system(s) 380, and/or a copy of a building information viewer system may execute as one of the other programs 335 (*e.g*., if the computing system(s) 180 are the same as a mobile device 175). The BFPGLDP system 140 may further, during its operation, store and/or retrieve various types of data on storage 320 (*e.g*., in one or more databases or other data structures), such as acquired images/data 155, building floor plans and determined room shapes and associated wall element information 165, acquired absolute location data 156, data 157 and 158 about image acquisition locations and data capture locations (including inter-location pose data), generated floor plans and/or other mapping information and associated absolute location data 159 (e.g., generated and saved 2.5D and/or 3D models, building and room dimensions for use with associated floor plans, additional images and/or annotation information, etc.), and/or various types of optional other information 329 (e.g., various analytical information related to presentation or other use of one or more building interiors or other environments).

In addition, embodiments of the IDCA and MIGM systems 150 and 160 execute in memory 385 of the server computing system(s) 380 in the illustrated embodiment in order to perform techniques related to generating panorama images and floor plans for buildings, such as by using the processor(s) 381 to execute software instructions of the systems 150 and/or 160 in a manner that configures the processor(s) 381 and computing system(s) 380 to perform automated operations that implement those techniques. The illustrated embodiment of the IDCA and MIGM systems may include one or more components, not shown, to each perform portions of the functionality of the IDCA and MIGM systems, respectively, and the memory may further optionally execute one or more other programs 383. The IDCA and/or MIGM systems 150 and 160 may further, during operation, store and/or retrieve various types of data on storage 384 (*e.g*., in one or more databases or other data structures), such as video and/or image information 155 acquired for one or more buildings (*e.g*., 360° video or images for analysis to generate floor plans, to provide to users of client computing devices 370 for display, etc.), floor plans and/or other generated mapping information 165, and optionally other information 387 (*e.g*., additional images and/or annotation information for use with associated floor plans, building and room dimensions for use with associated floor plans, various analytical information related to presentation or other use of one or more building interiors or other environments, etc.), as well as optionally interact with or use information from one or more I/O components 362 - while not illustrated in Figure 3, the IDCA and/or MIGM systems may further store and use additional types of information, such as about other types of building information to be analyzed and/or provided to the BFPGLDP system, about IDCA and/or MIGM system operator users and/or end-users, etc.

Some or all of the mobile devices 175, mobile data capture devices 185, optional other navigable devices 395, other client devices 105 and other computing systems (not shown) may similarly include some or all of the same types of components illustrated for server computing system 180. As one nonlimiting example, the mobile data capture devices 185 are each shown to include one or more hardware CPU(s) 132, memory 367, storage 365, one or more GPS receiver sensors 134, one or more imaging systems 135 e.g., for use in acquisition of video and/or images), optionally IMU hardware sensors 148 (e.g., for use in acquisition of associated device movement data, etc.), optionally one or more depth sensors 136, and optionally other components (not shown). In the illustrated example, zero or one or more client applications 154 (e.g., an application specific to the IDCA system and/or to the MIGM system and/or to the BFPGLDP system) and/or other programs 154 are executing in memory 367, such as to participate in communication with the BFPGLDP system 140, IDCA system 150, MIGM system 160 and/or other computing systems. While particular components are not illustrated for the other navigable devices 395 or other computing devices/systems 105, it will be appreciated that they may include similar and/or additional components.

It will also be appreciated that computing systems/devices 180 and 185 and 380 and 175 and the other systems and devices included within Figure 3 are merely illustrative and are not intended to limit the scope of the present invention. The systems and/or devices may instead each include multiple interacting computing systems or devices, and may be connected to other devices that are not specifically illustrated, including via Bluetooth communication or other direct communication, through one or more networks such as the Internet, via the Web, or via one or more private networks (*e.g*., mobile communication networks, etc.). More generally, a device or other computing system may comprise any combination of hardware that may interact and perform the described types of functionality, optionally when programmed or otherwise configured with particular software instructions and/or data structures, including without limitation desktop or other computers (e.g., tablets, slates, etc.), database servers, network storage devices and other network devices, smartphones and other cell phones, consumer electronics, wearable devices, digital music player devices, handheld gaming devices, PDAs, wireless phones, Internet appliances, and various other consumer products that include appropriate communication capabilities. In addition, the functionality provided by the illustrated BFPGLDP system 140 may in some embodiments be distributed in various components, some of the described functionality of the BFPGLDP system 140 may not be provided, and/or other additional functionality may be provided.

It will also be appreciated that, while various items are illustrated as being stored in memory or on storage while being used, these items or portions of them may be transferred between memory and other storage devices for purposes of memory management and data integrity. Alternatively, in other embodiments some or all of the software components and/or systems may execute in memory on another device and communicate with the illustrated computing systems via inter-computer communication. Thus, in some embodiments, some or all of the described techniques may be performed by hardware means that include one or more processors and/or memory and/or storage when configured by one or more software programs (*e.g*., by the BFPGLDP system 140 executing on server computing systems 180, by a BFPGLDP client application or other building information viewer system executing on mobile devices 175 or other computing systems/devices, etc.) and/or data structures, such as by execution of software instructions of the one or more software programs and/or by storage of such software instructions and/or data structures, and such as to perform algorithms as described in the flow charts and other disclosure herein. Furthermore, in some embodiments, some or all of the systems and/or components may be implemented or provided in other manners, such as by consisting of one or more means that are implemented partially or fully in firmware and/or hardware (*e.g*., rather than as a means implemented in whole or in part by software instructions that configure a particular CPU or other processor), including, but not limited to, one or more application-specific integrated circuits (ASICs), standard integrated circuits, controllers (*e.g*., by executing appropriate instructions, and including microcontrollers and/or embedded controllers), field-programmable gate arrays (FPGAs), complex programmable logic devices (CPLDs), etc. Some or all of the components, systems and data structures may also be stored (*e.g*., as software instructions or structured data) on a non-transitory computer-readable storage mediums, such as a hard disk or flash drive or other non-volatile storage device, volatile or non-volatile memory (*e.g*., RAM or flash RAM), a network storage device, or a portable media article *(e.g*., a DVD disk, a CD disk, an optical disk, a flash memory device, etc.) to be read by an appropriate drive or via an appropriate connection. The systems, components and data structures may also in some embodiments be transmitted via generated data signals (*e.g.*, as part of a carrier wave or other analog or digital propagated signal) on a variety of computer-readable transmission mediums, including wireless-based and wired/cable-based mediums, and may take a variety of forms (*e.g*., as part of a single or multiplexed analog signal, or as multiple discrete digital packets or frames). Such computer program products may also take other forms in other embodiments. Accordingly, embodiments of the present disclosure may be practiced with other computer system configurations.

Figures 4A-4B illustrate an example embodiment of a flow diagram for a Building Floor Plan Generator and Location Determiner and Presenter (BFPGLDP) system routine in accordance with an embodiment of the present disclosure. The routine may be performed by, for example, execution of the BFPGLDP system 140 of Figures 1 and/or 3, and/or a BFPGLDP system as described with respect to Figures 2A-2V and elsewhere herein, such as to perform automated operations related to automatically generating building floor plans and determining associated absolute locations for the generated floor plans using visual data of images and additional data captured in building interiors and optionally building exteriors by multiple data capture devices, automatically associating absolute location data points from data capture locations of the mobile device with acquisition locations of images in order to extend the absolute location data from the image acquisition locations of the camera device to surrounding room shapes determined from the visual data of the images and optionally to further floor plan locations (e.g., exterior corners of the building), and optionally using the associated absolute location data for a floor plan to overlay a visual representation of the floor plan on an associated map. In the example embodiment of Figures 4A-4B, the indicated buildings may be houses or other types of buildings, and various types of information may be provided or otherwise used in particular manners, but in other embodiments, other types of buildings and information uses may be provided and used, as discussed elsewhere herein.

The illustrated embodiment of the routine begins at block 405, where instructions or information are received. The routine continues to block 407, where it determines if the instructions or other information received in block 405 indicate to associate absolute location data with one or more devices at a building and/or other objects (*e.g*., objects inside the building, such as beacons or other wireless transmitters, visual markers, etc.; objects outside the building and visible from the building; etc.), and if so continues to block 409, where it determines or otherwise obtains absolute location data for such devices and/or objects, and stores them for later use. Such absolute location data may be automatically determined in various manners, such as based on public data sources (*e.g*., for objects outside the building), data captured during installation and/or placement of devices and/or objects (*e.g*., for objects inside a building, such as a visual marker), based on a mesh network of multiple such devices with associated transmitter and receiver capabilities and absolute location data for at least one such device, etc.

After block 409, or if it is instead determined in block 407 that the instructions or other information received in block 405 are not to associate absolute location data with devices and/or objects, the routine continues to block 410, where it determines if the instructions or information received in block 405 are to associate absolute location data with a floor plan and/or other building information for use with an indicated building, optionally after generating the floor plan and/or other building information, and if not continues to block 490. Otherwise, the routine continues to block 415 to retrieve, if available, one or more images with visual data and optionally acquisition metadata (*e.g.*, orientation data and other pose data) for the building and other absolute location data (*e.g*., GPS data points for data capture locations) for the building, and to otherwise perform the IDCA system routine to acquire the image(s) and optionally acquisition metadata and other absolute location data for the building and to receive the results from the routine - one example of such an IDCA system routine is discussed further with respect to Figure 5. After block 415, the routine continues to block 420 to retrieve, if available, at least partial floor plan information and additional information about the building and its attributes, and to otherwise perform the MIGM system routine to determine the floor plan and additional information about the building and its attributes (*e.g*., based at least in part on the data acquired by the IDCA system routine) and to receive the results from the routine - one example of such an MIGM system routine is discussed further with respect to Figures 6A-6B.

After block 420, the routine continues to block 425, where it optionally performs initial smoothing operations (*e.g*., removing outliers) on absolute location data points. In block 430, the routine then determines whether to determine further absolute location data for one or more data capture locations using visual data and/or other data acquired at those data capture locations that is not absolute location data points, such as data capture locations for which GPS location data was not previously captured or otherwise determined, all data capture locations for which visual data and/or other data was acquired, etc. If so, the routine continues to block 435 to, for each such data capture location, analyze the visual data of any second images acquired from that data capture location to attempt to identify one or more visible objects with associated absolute locations and/or to use other captured data (*e.g*., transmissions received from an in-building device having a known absolute location) to identify other locations with known absolute location data, and to determine corresponding absolute location data for the data capture location by extending the known absolute location data from the identified objects or other locations. In embodiments in which a data capture location has associated GPS location data captured at that data capture location, such additional location data determined in block 435 may in some embodiments be used to supplement the captured GPS location data, such as in situations in which the GPS signal received by the mobile device at that data capture location was sufficiently weak to introduce uncertainty in the captured GPS location data.

After block 435, or if it was instead determined in block 430 to not determine further absolute location data for any data capture locations (*e.g*., to instead use the retrieved GPS location data or other absolute location data from block 415), the routine continues to block 440 to, for each acquired image, determine a representative GPS data point or other absolute location data point to pair with the image and its acquisition location (*e.g*., using a position of the acquisition location in a local coordinate system for the floor plan), such as to select a best match data point (*e.g*., based on the same or similar acquisition times, such as an absolute location data point with a closest acquisition time), to select multiple data points (*e.g*., with acquisition times in a time window around an acquisition time of the image) and generate a representative data point from them, etc. In block 445, the routine then determines a global transformation for pairs of data in first and second data sets, with the first data set including images' positions in the floor plan's local coordinate system and the second data set including associated absolute location data points, such as a best-fit transformation that maps positions in the floor plan's local coordinate system to associated absolute location data points, and optionally using additional information (*e.g*., compass headings associated with images) if available to orient acquired images, such as using an algorithm that solves Wahba's problem and/or using point-set registration techniques and/or using a trained machine learning model, and optionally including performing refinement using iterative closest point or another refinement technique. In block 475, the routine then uses the resulting global transformation to determine absolute location data points for some or all of the floor plan (*e.g*., for one or more floor plan points representing one or more external walls of the building), such as by determining revised absolute location data points for the images' acquisition locations and extending the absolute location data from the image acquisition locations to positions of corresponding room shapes in the floor plan (*e.g*., using the positions in the room shapes of the image acquisition locations) and to other information (if any) having associated positions on the floor plan (*e.g*., other media captured at particular capture locations), including to optionally determine absolute location data for one or more points on external boundary of building (*e.g*., corners), and to optionally include geographical direction information (*e.g*., at least a north heading) with the floor plan.

After block 475, the routine continues to block 480 to determine whether to use absolute location data associated with one or more points of a floor plan to associate the floor plan with a map, such as based on instructions or other information received in block 405, and if so continues to block 485 to perform such a map association, including to overlay or otherwise include a visual representation of the floor plan on the map at its associated absolute locations, optionally fitting the visual representation to an existing visual representation of the building on the map (e.g., as part of an image that is part of the map or is otherwise overlaid on the map), and optionally associating additional related information for the building on the map (*e.g*., neighborhood information, directions to points of interest, etc.) - as discussed in greater detail elsewhere herein, various types of floor plan information may be rendered or otherwise made visible based on a variety of factors (*e.g*., zoom level of the map, size of the visual representation of the building floor plan, user selections and/or preferences, etc.). After block 485, or if it is instead determined in block 480 to not perform such map information association at the current time, the routine continues to block 489, where it optionally provides some or all of the determined and/or generated information for the routine to one or more recipients (e.g., to provide the map with the overlaid information of block 485 for display on one or more client devices).

If it is determined in block 410 that the instructions or other information received in block 405 are not to generate building information, the routine continues instead to block 490 to perform one or more other indicated operations as appropriate. Such other indicated operations may include, for example, one or more of the following non-exclusive examples: receiving and storing (or otherwise determining) information about known absolute locations of particular devices and/or objects; receiving and storing information about buildings and/or capture devices and/or companion devices and/or users for later use; retrieving and providing information from a BFPGLDP system account for a user device and/or associated user to that device or user; etc.

After blocks 489 or 490, the routine continues to block 495 to determine whether to continue, such as until an explicit indication to terminate is received, or instead only if an explicit indication to continue is received. If it is determined to continue, the routine returns to block 405 to await additional instructions or other information, and otherwise continues to block 499 and ends.

While not illustrated with respect to the automated operations shown in the example embodiment of Figures 4A-4B, in some embodiments human users may further assist in facilitating some of the operations of the BFPGLDP system, such as for operator users and/or end-users of the BFPGLDP system to provide input of one or more types that is further used in subsequent automated operations. As non-exclusive examples, such human users may provide input of one or more types, with non-exclusive examples including the following: to provide input related to locations of devices and/or objects that are installed or otherwise placed at building locations; to assist with the identification of objects and/or other attributes from analysis of images, floor plans and/or other building information; to assist with the association of absolute data location data with image acquisition locations and/or room shapes and/or floor plans; etc. Additional details are included elsewhere herein regarding embodiments in which human user(s) provide input used in additional automated operations of the BFPGLDP system.

Figure 5 illustrates an example flow diagram of an embodiment of an IDCA (Image Capture & Analysis) system routine 500. The routine may be performed by, for example, the IDCA system 150 of Figures 1 and 3, and/or an IDCA system as described with respect to Figures 2A-2B and elsewhere herein, such as to use one or more camera devices to acquire 360° panorama images and/or other images at image acquisition locations within buildings or other structures, and/or to use one or more other mobile devices to acquire other data (e.g., GPS location data, other additional images, etc.) at other data capture locations within the buildings or other structures, such as for use in subsequent generation of related floor plans and/or other mapping information. While portions of the example routine 500 are discussed with respect to acquiring particular types of images and other data at particular locations, it will be appreciated that this or a similar routine may be used to acquire video (with video frame images) and/or other data (e.g., audio), whether instead of or in addition to such panorama images or other perspective images and other data. In addition, while the illustrated embodiment acquires and uses information from the interior of a target building, it will be appreciated that other embodiments may perform similar techniques in other situations, including for non-building structures and/or for information external to one or more target buildings of interest (e.g., on a property on which a target building is located, such as to show yards, decks, patios, accessory structures, etc.). Furthermore, some or all of the routine may be executed on a mobile device used by a user to acquire image information, and/or by a system remote from such a mobile device. In at least some embodiments, the routine 500 may be invoked from block 415 of routine 400 of Figures 4A-4B, with corresponding information from routine 500 provided to routine 400 as part of implementation of that block 415, and with processing control returned to routine 400 at block 599 and/or after blocks 577 or 590 in such situations - in other embodiments, the routine 400 may proceed with additional operations in an asynchronous manner without waiting for such processing control to be returned (e.g., to proceed with other processing activities while waiting for the corresponding information from the routine 500 to be provided to routine 400).

The illustrated embodiment of the routine begins at block 505, where instructions or information are received. At block 510, the routine determines whether the received instructions or information indicate to perform directed acquisition of visual data and/or other data representing a building (e.g., in accordance with supplied information about one or more acquisition locations and/or other guidance acquisition instructions), and if not continues to block 590 to perform one or more other indicated operations, including in some embodiments and situations to receive one or more target images captured by one or more camera devices without directed acquisition and/or other data captured by one or more other mobile devices without directed acquisition. Otherwise, the routine proceeds to block 511 to optionally provide instructions or other information to one or more human operator users involved in performing image acquisition and/or capture of absolute location data points, such as information to improve the capture of GPS data points or other absolute location data points (e.g., to perform initial movement activities to improve GPS calibration before entering a building, to gather GPS data points for particular locations such as an entry doorway and/or some/all of the building exterior boundary and/or an external walkway or other external areas, etc.). In block 512, the routine then receives an indication to begin the image acquisition process by a camera device at a first image acquisition location in or around the building (e.g., from a human operator user of a camera device that will perform the target image acquisition) and/or to begin the capture of other data by a mobile device at a first data capture location (e.g., from a human operator user of a mobile data capture device that will perform the data capture process, whether the same or a different user than operating the camera device). After block 512, the routine proceeds to block 515 in order to perform image acquisition activities for acquiring a 360° panorama image for the image acquisition location at the target building of interest using the camera device (e.g., via one or more fisheye lenses and/or non-fisheye rectilinear lenses on the mobile device and to provide horizontal coverage of at least 360° around a vertical axis, although in other embodiments other types of images and/or other types of data may be acquired), and/or to perform data capture activities for acquiring other data at the data capture location by the mobile device (*e.g*., to capture GPS location data and optionally one or more additional second images, and to optionally obtain IMU data and/or other acquisition metadata during the image acquisition activities), such as to concurrently capture data by both devices at locations that are proximate to each other (*e.g*., within visual range of each other or otherwise having overlapping visual data). As one non-exclusive example, the camera device may be a rotating (scanning) panorama camera equipped with a fisheye lens (*e.g*., with 180° of horizontal coverage) and/or other lens (*e.g*., with less than 180° of horizontal coverage, such as a regular lens or wide-angle lens or ultrawide lens or macro lens). The routine may also optionally obtain annotation and/or other information from one or more users of the camera device and/or the mobile device regarding the respective image acquisition location and/or data capture location and optionally a surrounding environment, such as for later use in presentation of information regarding the location(s) and/or surrounding environment.

After block 515 is completed, the routine continues to block 520 to determine if there are more image acquisition locations at which to acquire target images using the camera device and/or more data capture locations at which to acquire other data using the mobile device, such as based on corresponding information provided by one or more users of the device(s) and/or received in block 505 - in some embodiments, the IDCA routine will acquire only one or more target images captured by the camera device at a single image acquisition location and/or other data captured at a single data capture location, and then proceed to block 577 to provide those target image(s) and/or other data and optionally corresponding information (*e.g*., to the BFPGLDP system and/or MIGM system for further use before receiving additional instructions or information to acquire one or more next images at one or more next image acquisition locations and/or one or more other groups of data at one or more next data capture locations). If there are more image acquisition locations at which to acquire additional images from the camera device at the current time and/or more data capture locations at which to acquire other data from the mobile device at the current time, the routine continues to block 522 to optionally initiate the acquisition of linking information (*e.g*., acceleration data, visual data, etc.) during movement of the device(s) along travel path(s) away from the current location(s) and towards next location(s) at the building. The acquired linking information may include additional sensor data (*e.g*., from one or more IMU, or inertial measurement units, on the mobile device or otherwise carried by the user) and/or additional visual information (*e.g*., images, video, etc.) recorded during such movement. Initiating the acquisition of such linking information may be performed in response to an explicit indication from a user of a device or based on one or more automated analyses of information recorded from a device. In addition, the routine may further optionally monitor the motion of a device in some embodiments during movement to the next acquisition location, and provide one or more guidance cues (*e.g*., to the user) regarding the motion of the device, quality of the sensor data and/or visual information being acquired, associated lighting/environmental conditions, advisability of acquiring images and/or other data at a next location, and any other suitable aspects of acquiring the linking information. Similarly, the routine may optionally obtain annotation and/or other information from the user(s) regarding the travel path(s), such as for later use in presentation of information regarding a travel path or a resulting inter-location connection. In block 524, the routine determines that the camera device has arrived at the next image acquisition location and/or that the mobile device has arrived at the next data capture location (*e.g*., based on an indication from a user, based on forward movement of the device stopping for at least a predefined amount of time, based on an amount of time passing since a last image acquisition and/or data capture, based on an amount of distance having been moved since a last image acquisition and/or data capture, etc.), for use as the new current image acquisition location and/or data capture location, respectively, and returns to block 515 to perform further target image acquisition activities for the new current image acquisition location and/or further capture of other data for the new current data capture location.

If it is instead determined in block 520 that there are not any more image acquisition locations at which to acquire additional target images for the current building or other structure at the current time and not any more data capture locations at which to acquire additional other data for the current building or other structure at the current time, the routine proceeds to block 545 to optionally preprocess acquired 360° target panorama images and/or other acquired data before subsequent use (*e.g*., for generating related mapping information, for providing information about structural elements or other objects of rooms or other enclosing areas, etc.), such as to produce images of a particular type and/or in a particular format (*e.g*., to perform an equirectangular projection for each such image, with straight vertical data such as the sides of a typical rectangular door frame or a typical border between 2 adjacent walls remaining straight, and with straight horizontal data such as the top of a typical rectangular door frame or a border between a wall and a floor remaining straight at a horizontal midline of the image but being increasingly curved in the equirectangular projection image in a convex manner relative to the horizontal midline as the distance increases in the image from the horizontal midline and/or as the distance to the acquisition location decreases). In block 577, the images and other captured data and any associated generated or obtained information is stored for later use, and optionally provided to one or more recipients (e.g., to block 415 of routine 400 if invoked from that block) - Figures 6A-6B illustrate one example of a routine for generating a floor plan representation of a building interior from the captured images and other data.

If it is instead determined in block 510 that the instructions or other information received in block 505 are not to acquire images and other data representing a building interior using directed capture, the routine continues instead to block 590 to perform any other indicated operations as appropriate, such as to receive one or more target images captured by one or more camera devices at one or more image acquisition locations without directed acquisition, to receive other data captured by one or more other mobile devices at one or more data capture locations without directed acquisition, to respond to requests for generated and stored information (*e.g*., to identify one or more panorama images that match one or more specified search criteria, etc.), to obtain and store other information about users of the system, to configure parameters to be used in various operations of the system (*e.g*., based at least in part on information specified by a user of the system, such as a user of a mobile device who acquires one or more building interiors, an operator user of the IDCA system, etc.), to perform any housekeeping tasks, etc.

Following blocks 577 or 590, the routine proceeds to block 595 to determine whether to continue, such as until an explicit indication to terminate is received, or instead only if an explicit indication to continue is received. If it is determined to continue, the routine returns to block 505 to await additional instructions or information, and if not proceeds to block 599 and ends.

While not illustrated with respect to the automated operations shown in the example embodiment of Figure 5, in some embodiments human users may further assist in facilitating some of the operations of the IDCA system, such as for operator users and/or end-users of the IDCA system to provide input of one or more types that is further used in subsequent automated operations. As non-exclusive examples, such human users may provide input of one or more types as follows: to provide input to assist with determination of acquisition locations, such as to provide input in blocks 512 and/or 524 that is used as part of the automated operations for that block; to perform activities in block 515 related to image acquisition (*e.g*., to participate in the image acquisition, such as to activate the shutter, implement settings on the camera device and/or associated sensor or component, rotate the camera device as part of acquiring a panorama image, etc.; to set the location and/or orientation of the camera device and/or associated sensors or components; etc.); to perform activities in block 515 related to other data capture (*e.g*., to participate in the capture of the other data); to provide input in blocks 515 and/or 522 that is used as part of subsequent automated operations, such as labels, annotations or other descriptive information with respect to particular images, surrounding rooms and/or objects in the rooms; etc. Additional details are included elsewhere herein regarding embodiments in which one or more human users provide input that is further used in additional automated operations of the IDCA system.

Figures 6A-6B illustrate an example embodiment of a flow diagram for a MIGM (Mapping Information Generation Manager) system routine 600. The routine may be performed by, for example, execution of the MIGM system 160 of Figures 1 and 3, and/or a MIGM system as described with respect to Figures 2A-2V and elsewhere herein, such as to determine a room shape for a room (or other defined area) by analyzing information from one or more images acquired in the room (e.g., one or more 360° target panorama images, one or more additional second images, etc.), to generate a partial or complete floor plan for a building or other defined area based at least in part on one or more images of the area and optionally additional data acquired by a mobile computing device and using determined room shapes, and/or to generate other mapping information for a building or other defined area based at least in part on one or more images of the area and optionally additional data acquired by a mobile computing device. In the example of Figures 6A-6B, the determined room shape for a room may be a 2D room shape to represent the locations of the walls of the room or a 3D fully closed combination of planar surfaces to represent the locations of walls and ceiling and floor of the room or a 2.5D combination of planar surfaces to represent the locations of at least the walls of the room without complete ceiling and/or floor data, and the generated mapping information for a building (*e.g*., a house) may include a 2D floor plan and/or 3D computer model floor plan and/or 2.5D computer model floor plan, but in other embodiments, other types of room shapes and/or mapping information may be generated and used in other manners, including for other types of structures and defined areas, as discussed elsewhere herein. In at least some embodiments, the routine 600 may be invoked from block 420 of routine 400 of Figures 4A-4B, with corresponding information from routine 600 provided to routine 400 as part of implementation of that block 420, and with processing control returned to routine 400 at block 699 or after blocks 688 and/or 699 in such situations - in other embodiments, the routine 400 may proceed with additional operations in an asynchronous manner without waiting for such processing control to be returned (*e.g*., to wait to proceed once the corresponding information from routine 600 is provided to routine 400, to proceed with other processing activities while waiting for the corresponding information from the routine 600 to be provided to routine 400, etc.).

The illustrated embodiment of the routine begins at block 605, where information or instructions are received. The routine continues to block 610 to determine whether image information and optionally other captured data is already available to be analyzed for one or more rooms (*e.g*., for some or all of an indicated building, such as based on one or more such images received in block 605 as previously generated by the IDCA routine), or if such image information instead is to be currently acquired. If it is determined in block 610 to currently acquire some or all of the image information, the routine continues to block 612 to acquire such information, optionally waiting for one or more users or devices to move throughout one or more rooms of a building and acquire panoramas or other target images at one or more image acquisition locations in one or more of the rooms or other areas (*e.*g., at multiple acquisition locations in each room of the building) and/or to acquire other second images and optionally other data at one or more data capture locations in the one or more rooms or other areas (*e.g.*, at multiple data capture locations in each room of the building), optionally along with metadata information regarding the acquisition and/or interconnection linking information related to movement between acquisition locations, as discussed in greater detail elsewhere herein - implementation of block 612 may, for example, include invoking an IDCA system routine to perform such activities, with Figure 5 providing one example embodiment of an IDCA system routine for performing such image acquisition. If it is instead determined in block 610 not to currently acquire the images and optional other data, the routine continues instead to block 615 to obtain one or more existing panoramas or other target images from one or more image acquisition locations in one or more rooms or other areas (*e.g*., multiple images acquired at multiple acquisition locations that include at least one image and acquisition location in each room of a building) and to obtain existing other data captured at one or more data capture locations in the one or more rooms or other areas, optionally along with metadata information regarding the acquisition and/or interconnection linking information related to movement between the acquisition locations, and optionally along with determined positions of acquisition locations, such as may have been supplied in block 605 along with the corresponding instructions in some situations.

After blocks 612 or 615, the routine continues to block 620, where it determines whether to generate mapping information that includes an inter-linked set of target panorama images (or other images) for a building or other group of rooms (referred to at times as a 'virtual tour', such as to enable an end-user to move from any one of the images of the linked set to one or more other images to which that starting current image is linked, including in some embodiments via selection of a user-selectable control for each such other linked image that is displayed along with a current image, optionally by overlaying visual representations of such user-selectable controls and corresponding inter-image directions on the visual data of the current image, and to similarly move from that next image to one or more additional images to which that next image is linked, etc.), and if so continues to block 625. The routine in block 625 selects pairs of at least some of the images (*e.g*., based on the images of a pair having overlapping visual content), and if acquisition location position information is not already determined and provided, determines, for each pair, relative directions between the images of the pair based on shared visual content and/or on other acquired linking interconnection information (*e.g*., movement information) related to the images of the pair (whether movement directly from the location at which one image of a pair was acquired to the location at which the other image of the pair was acquired, or instead movement between those starting and ending locations via one or more other intermediary locations of other images) - if acquisition location position information is already determined and provided, that information may be used to determine the relative direction information between pairs of images, whether instead of or in addition to the visual data analysis. The routine in block 625 may further optionally use at least the relative direction information for the pairs of images to determine global relative positions of some or all of the images to each other in a common coordinate system, and/or generate the inter-image links and corresponding user-selectable controls as noted above. Additional details are included elsewhere herein regarding creating such a linked set of images.

After block 625, or if it is instead determined in block 620 that the instructions or other information received in block 605 are not to determine a linked set of images, the routine continues to block 635 to determine whether the instructions received in block 605 indicate to generate other mapping information for an indicated building (*e.g*., a floor plan), and if so the routine continues to perform some or all of blocks 637-685 to do so, and otherwise continues to block 690. In block 637, the routine optionally obtains additional information about the building, such as from activities performed during acquisition and optionally analysis of the images, and/or from one or more external sources (*e.g*., online databases, information provided by one or more end-users, etc.) - such additional information may include, for example, exterior dimensions and/or shape of the building, additional images and/or annotation information acquired corresponding to particular locations external to the building (*e.g*., surrounding the building and/or for other structures on the same property, from one or more overhead locations, etc.), additional images and/or annotation information acquired corresponding to particular locations within the building (optionally for locations different from acquisition locations of the acquired panorama images or other images), determined acquisition location position information, etc.

After block 637, the routine continues to block 640 to select the next room (beginning with the first) for which one or more images (*e.g*., 360° target panorama images, other target images, other second images, etc.) acquired in the room are available, and to analyze the visual data of the image(s) for the room to determine a room shape (*e.g*., by determining at least wall locations), optionally along with determining uncertainty information about walls and/or other parts of the room shape, and optionally including identifying other wall and floor and ceiling elements (*e.g*., wall structural elements/objects, such as windows, doorways and stairways and other inter-room wall openings and connecting passages, wall borders between a wall and another wall and/or ceiling and/or floor, etc.) and their positions within the determined room shape of the room - if acquisition location position information is already determined and provided, that information may be used as part of determining the room shape information, whether instead of or in addition to the visual data analysis. In some embodiments, the room shape determination may include using boundaries of the walls with each other and at least one of the floor or ceiling to determine a 2D room shape (*e.g*., using one or trained machine learning models), while in other embodiments the room shape determination may be performed in other manners (e.g., by generating a 3D point cloud of some or all of the room walls and optionally the ceiling and/or floor, such as by analyzing at least visual data of the panorama image and optionally additional data acquired by an mobile data capture device or associated mobile computing device, optionally using one or more of SfM (Structure from Motion) or SLAM (Simultaneous Location And Mapping) or MVS (Multi-View Stereo) analysis). In addition, the activities of block 645 may further optionally determine and use acquisition location position information for each of the analyzed images (*e.g*., within a corresponding determined room shape), and/or obtain and use additional metadata for each panorama image (*e.g*., acquisition height information of the camera device or other mobile data capture device used to acquire a panorama image relative to the floor and/or the ceiling). Additional details are included elsewhere herein regarding determining room shapes and identifying additional information for the rooms. After block 640, the routine continues to block 645, where it determines whether there are more rooms for which to determine room shapes based on images acquired in those rooms, and if so returns to block 640 to select the next such room for which to determine a room shape.

If it is instead determined in block 645 that there are not more rooms for which to generate room shapes, the routine continues to block 660 to determine whether to further generate at least a partial floor plan for the building (e.g., based at least in part on the determined room shape(s) from block 640 and on determined acquisition location position information if available, and optionally further information regarding how to position the determined room shapes relative to each other). If not, such as when determining only one or more room shapes without generating further mapping information for a building (e.g., to determine the room shape for a single room based on one or more images acquired in the room by the IDCA system), the routine continues to block 688. Otherwise, the routine continues to block 665 to retrieve one or more room shapes (e.g., room shapes generated in block 645) or otherwise obtain one or more room shapes (*e.g*., based on human-supplied input) for rooms of the building, whether 2D or 3D room shapes, and then continues to block 670. In block 670, the routine uses the one or more room shapes to create an initial floor plan (*e.g*., an initial 2D floor plan using 2D room shapes and/or an initial 3D floor plan using 3D room shapes), such as a partial floor plan that includes one or more room shapes but less than all room shapes for the building, or a complete floor plan that includes all room shapes for the building. If there are multiple room shapes, the routine in block 670 further determines positioning of the room shapes relative to each other, such as by using visual overlap between images from multiple acquisition locations to determine relative positions of those acquisition locations and of the room shapes surrounding those acquisition locations, and/or by using other types of information (*e.g*., using connecting inter-room passages between rooms, optionally applying one or more constraints or optimizations; using determined acquisition location position information; etc.). In at least some embodiments, the routine in block 670 further refines some or all of the room shapes by generating a binary segmentation mask that covers the relatively positioned room shape(s), extracting a polygon representing the outline or contour of the segmentation mask, and separating the polygon into the refined room shape(s). Such a floor plan may include, for example, relative position and shape information for the various rooms without providing any actual dimension information for the individual rooms or building as a whole, and may further include multiple linked or associated sub-maps (*e.g*., to reflect different stories, levels, sections, etc.) of the building. The routine further optionally associates positions of the doors, wall openings and other identified wall elements on the floor plan.

After block 670, the routine optionally performs one or more steps 680-685 to determine and associate additional information with the floor plan. In block 680, the routine optionally estimates the dimensions of some or all of the rooms, such as from analysis of images and/or their acquisition metadata or from overall dimension information obtained for the exterior of the building, and associates the estimated dimensions with the floor plan - it will be appreciated that if sufficiently detailed dimension information were available, architectural drawings, blueprints, etc. may be generated from the floor plan. After block 680, the routine continues to block 683 to optionally associate further information with the floor plan (*e.g*., with particular rooms or other locations within the building), such as additional existing images with specified positions and/or annotation information. In block 685, if the room shapes from block 645 are not 3D room shapes, the routine further optionally estimates heights of walls in some or all rooms, such as from analysis of images and optionally sizes of known objects in the images, as well as height information about a camera when the images were acquired, and uses that height information to generate 3D room shapes for the rooms. The routine further optionally uses the 3D room shapes (whether from block 640 or block 685) to generate a 3D computer model floor plan of the building, with the 2D and 3D floor plans being associated with each other - in other embodiments, only a 3D computer model floor plan may be generated and used (including to provide a visual representation of a 2D floor plan if so desired by using a horizontal slice of the 3D computer model floor plan).

After block 685, or if it is instead determined in block 660 not to determine a floor plan, the routine continues to block 688 to store the determined room shape(s) and/or generated mapping information and/or other generated information, to optionally provide some or all of that information to one or more recipients (*e.g*., to block 420 of routine 400 if invoked from that block), and to optionally further use some or all of the determined and generated information, such as to provide the generated 2D floor plan and/or 3D computer model floor plan for display on one or more client devices and/or to one or more other devices for use in automating navigation of those devices and/or associated vehicles or other entities, to similarly provide and use information about determined room shapes and/or a linked set of images and/or about additional information determined about contents of rooms and/or passages between rooms, etc.

If it is instead determined in block 635 that the information or instructions received in block 605 are not to generate mapping information for an indicated building, the routine continues instead to block 690 to perform one or more other indicated operations as appropriate. Such other operations may include, for example, receiving and responding to requests for previously generated floor plans and/or previously determined room shapes and/or other generated information (*e.g*., requests for such information for display on one or more client devices, requests for such information to provide it to one or more other devices for use in automated navigation, etc.), obtaining and storing information about buildings for use in later operations (*e.g*., information about dimensions, numbers or types of rooms, total square footage, adjacent or nearby other buildings, adjacent or nearby vegetation, exterior images, etc.), etc.

After blocks 688 or 690, the routine continues to block 695 to determine whether to continue, such as until an explicit indication to terminate is received, or instead only if an explicit indication to continue is received. If it is determined to continue, the routine returns to block 605 to wait for and receive additional instructions or information, and otherwise continues to block 699 and ends.

While not illustrated with respect to the automated operations shown in the example embodiment of Figures 6A-6B, in some embodiments human users may further assist in facilitating some of the operations of the MIGM system, such as for operator users and/or end-users of the MIGM system to provide input of one or more types that is further used in subsequent automated operations. As non-exclusive examples, such human users may provide input of one or more types as follows: to provide input to assist with the linking of a set of images, such as to provide input in block 625 that is used as part of the automated operations for that block (*e.g*., to specify or adjust initial automatically determined directions between one or more pairs of images, to specify or adjust initial automatically determined final global positions of some or all of the images relative to each other, etc.); to provide input in block 637 that is used as part of subsequent automated operations, such as one or more of the illustrated types of information about the building; to provide input with respect to block 640 that is used as part of subsequent automated operations, such as to specify or adjust initial automatically determined element locations and/or estimated room shapes and/or to manually combine information from multiple estimated room shapes for a room (*e.g.*, separate room shape estimates from different images acquired in the room) to create a final room shape for the room and/or to specify or adjust initial automatically determined information about a final room shape, etc.; to provide input with respect to block 670, that is used as part of subsequent operations, such as to specify or adjust initial automatically determined positions of room shapes within a floor plan being generated and/or to specify or adjust initial automatically determined room shapes themselves within such a floor plan; to provide input with respect to one or more of blocks 680 and 683 and 685 that is used as part of subsequent operations, such as to specify or adjust initial automatically determined information of one or more types discussed with respect to those blocks; and/or to specify or adjust initial automatically determined pose information (whether initial pose information or subsequent updated pose information) for one or more of the panorama images; etc. Additional details are included elsewhere herein regarding embodiments in which human user(s) provide input that is further used in additional automated operations of the MIGM system.

Figures 7A-7B illustrate an example embodiment of a flow diagram for a Building Information Viewer system routine 700, such as may be implemented by an embodiment of the BFPGLDP client application in some embodiments and situations (e.g., to provide feedback to a user of a capture device). The routine may be performed by, for example, execution of a BFPGLDP client application 154 of mobile device 185 of Figure 3 and/or of such a client application or other building information viewer system otherwise executing on a mobile device 175 and/or other computing system or device as described elsewhere herein, such as to receive and present building information (*e.g*., individual images; floor plans and/or other mapping-related information, such as determined room structural layouts/shapes, a virtual tour of inter-linked images, etc.; generated building description information; videos; etc.). In the example of Figures 7A-7B, the presented information is for one or more buildings (such as an interior of a house), but in other embodiments, other types of mapping information may be presented for other types of buildings or environments and used in other manners, as discussed elsewhere herein.

The illustrated embodiment of the routine begins at block 705, where instructions or information are received. At block 710, the routine determines whether the received instructions or information in block 705 are to present determined information for one or more target buildings, and if so continues to block 715 to determine whether the received instructions or information in block 705 are to select one or more target buildings using specified criteria (*e.g.*, based at least in part on an indicated building), and if not continues to block 720 to obtain an indication of a target building to use from the user (*e.g*., based on a current user selection, such as from a displayed list or other user selection mechanism; based on information received in block 705; etc.). Otherwise, if it is determined in block 715 to select one or more target buildings from specified criteria, the routine continues instead to block 725, where it obtains indications of one or more search criteria to use, such as from current user selections or as indicated in the information or instructions received in block 705, and then searches stored information about buildings (*e.g*., floor plans, videos, generated textual descriptions, etc.) to determine one or more of the buildings that satisfy the search criteria or otherwise obtains indications of one or more such matching target buildings, such as information that is currently or previously generated by the BFPGLDP system (with one example of operations of such a system being further discussed with respect to Figures 4A-4B, and with the BFPGLDP system optionally invoked in block 720 to obtain such information). In the illustrated embodiment, the routine then further optionally selects a best match target building from the one or more determined target buildings (*e.g.,* the target building with the highest similarity or other matching rating for the specified criteria, or using another selection technique indicated in the instructions or other information received in block 705), while in other embodiments the routine may instead present information for multiple target buildings that satisfy the search criteria (*e.g*., in a ranked order based on degree of match; in a sequential manner, such as to present one or more videos for each of multiple buildings in a sequence; in a simultaneous manner, such as on a map of a surrounding area; etc.) and receive a user selection of the best match target building from the multiple candidate target buildings.

After blocks 720 or 725, the routine continues to block 730 to determine whether the instructions or other information received in block 705 indicate to present one or more maps with one or more visual indicators for each of one or more target buildings, and if so continues to block 771 to do so, including to retrieve information about the target building(s) that includes a generated floor plan model for each target building along with associated absolute location data for each floor plan. After block 771, the routine continues to block 773 to retrieve or otherwise generate information about one or more maps for one or more areas that include the location(s) of the target building(s) (*e.g.*, one or more maps that match criteria specified in the information of block 705 or are otherwise determined, such as with respect to zoom level and/or map size, and optionally using preference information or other information specific to a recipient), and to optionally include one or more images having visual data for at least some of an area covered by the map(s) if available (*e.g*., a satellite image or other overhead image(s), a street-level image of the target building(s), etc.). After block 773, the routine continues to block 775 to determine, for each target building, an area on the map corresponding to the target building's floor plan's absolute location data, and to overlay each target building's floor plan on the corresponding map area, including to fit the floor plan to a visible representation of the target building if one is present on an image whose visual data includes that map area) - in some embodiments and situations, the routine may further determine what types of information associated with the floor plan to include in the overlaid visual representation of the floor plan, such as based at least in part on a zoom level of the map and/or on a size of the floor plan's overlaid visual representation, and optionally using preference information or other information specific to a user recipient (e.g., based on one or more prior selections). In block 777, the routine selects a current view of the map that includes the overlaid floor plan visual representation(s) (*e.g*., to select a zoom level, subset of the map, etc.), and continues to block 779 to display or otherwise present the map with the overlaid floor plan visual representation in a GUI. The routine then waits in block 781 for a user selection (or optionally a timeout), and if it is determined in block 783 that the user selection corresponds to adjusting the current view for the current map, the routine continues to block 785 to update the current view in accordance with the user selection, and then returns to block 779 to update the displayed or otherwise presented information accordingly. The user selection and corresponding updating of the current view may include, for example, displaying or otherwise presenting a piece of associated linked information that the user selects (*e.g*., additional or different building information of one or more types for one or more target buildings, such as in response to a user selection of a visual representation of a particular target building and/or the selection of one or more other user controls; additional or different neighborhood or other surroundings information of one or more types with respect to one or more target buildings, such as in response to a user selection of a visual representation of a particular target building and/or the selection of one or more other user controls; etc.), and/or changing how the current view is displayed (*e.g*., zooming in or out; rotating and/or translating an area of the map that is displayed; etc.). If it is instead determined in block 783 that the user selection is not to display further information for the current target building and/or map (*e.g*., to display information for another building and/or map, to end the current display operations, etc.) or if the wait in block 781 has a timer expiration, the routine continues instead to block 795, and returns to block 705 to perform operations for the user selection if the user selection involves such further operations.

If it is instead determined in block 730 that the instructions or other information received in block 705 do not indicate to present one or more building floor plans on a map, the routine continues to block 735 to retrieve information for the target building for display (*e.g*., a floor plan; other generated mapping information for the building, such as a group of inter-linked images for use as part of a virtual tour; generated building description information; etc.), and optionally indications of associated linked information for the building interior and/or a surrounding location external to the building, and/or information about one or more generated explanations or other descriptions of the target building, and selects an initial view of the retrieved information (*e.g.*, a view of the floor plan, a particular room shape, a particular image, some or all of the generated building description information, etc.). In block 740, the routine then displays or otherwise presents the current view of the retrieved information in a GUI, and waits in block 745 for a user selection (or optionally a timeout). After a user selection in block 745, if it is determined in block 750 that the user selection corresponds to adjusting the current view for the current target building (*e.g*., to change one or more aspects of the current view), the routine continues to block 755 to update the current view in accordance with the user selection, and then returns to block 740 to update the displayed or otherwise presented information accordingly. The user selection and corresponding updating of the current view may include, for example, displaying or otherwise presenting a piece of associated linked information that the user selects (*e.g*., a particular image associated with a displayed visual indication of a determined acquisition location, such as to overlay the associated linked information over at least some of the previous display; a particular other image linked to a current image and selected from the current image using a user-selectable control overlaid on the current image to represent that other image; etc.), and/or changing how the current view is displayed (*e.g*., zooming in or out; rotating information if appropriate; selecting a new portion of the floor plan to be displayed or otherwise presented, such as with some or all of the new portion not being previously visible, or instead with the new portion being a subset of the previously visible information; etc.). If it is instead determined in block 750 that the user selection is not to display further information for the current target building (*e.g.,* to display information for another building, to end the current display operations, etc.) or if the wait in block 745 has a timer expiration, the routine continues instead to block 795, and returns to block 705 to perform operations for the user selection if the user selection involves such further operations.

If it is instead determined in block 710 that the instructions or other information received in block 705 are not to present information representing a building, the routine continues instead to block 760 to determine whether the instructions or other information received in block 705 indicate to identify other images (if any) corresponding to one or more indicated target images, and if so continues to blocks 762-764 to perform such activities. In particular, the routine in block 762 receives the indications of the one or more target images for the matching (such as from information received in block 705 or based on one or more current interactions with a user) along with one or more matching criteria (*e.g*., an amount of visual overlap), and in block 764 identifies one or more other images (if any) that match the indicated target image(s), such as by interacting with the IDCA and/or MIGM systems to obtain the other image(s). The routine then displays or otherwise provides information in block 764 about the identified other image(s), such as to provide information about them as part of search results, to display one or more of the identified other image(s) in a GUI, etc. If it is instead determined in block 760 that the instructions or other information received in block 705 are not to identify other images corresponding to one or more indicated target images, the routine continues instead to block 766 to determine whether the instructions or other information received in block 705 correspond to obtaining and providing guidance acquisition instructions during an image acquisition session with respect to one or more indicated target images (e.g., a most recently acquired image), and if so continues to block 768, and otherwise continues to block 790. In block 768, the routine obtains information about guidance acquisition instructions of one or more types, such as by interacting with the IDCA system, and displays or otherwise provides information in block 768 about the guidance acquisition instructions in a GUI, such as by overlaying the guidance acquisition instructions on a partial floor plan and/or recently acquired image in manners discussed in greater detail elsewhere herein.

In block 790, the routine continues instead to perform other indicated operations as appropriate, such as to configure parameters to be used in various operations of the system (*e.g.*, based at least in part on information specified by a user of the system, such as a user of a mobile device who acquires one or more building interiors, an operator user of the BFPGLDP and/or MIGM systems, etc., including for use in personalizing information display for a particular recipient user in accordance with his/her preferences or other information specific to that recipient), to obtain and store other information about users of the system (*e.g.*, preferences or other information specific to that user), to respond to requests for generated and stored information, to perform any housekeeping tasks, etc.

Following blocks 764 or 768 or 790, or if it is determined in block 750 that the user selection does not correspond to the current building (or a timeout occurs) or in block 783 that the user selection does not correspond to the current map (or a timeout occurs), the routine proceeds to block 795 to determine whether to continue, such as until an explicit indication to terminate is received, or instead only if an explicit indication to continue is received. If it is determined to continue (including if the user made a selection in block 745 related to a new building to present), the routine returns to block 705 to await additional instructions or information (or to continue directly on to block 730 if the user made a selection in block 745 related to a new building to present), and if not proceeds to step 799 and ends.

Non-exclusive example embodiments described herein are further described in the following clauses.
A01. A computer-implemented method for one or more computing devices to perform automated operations comprising:
   obtaining, by the one or more computing devices during an acquisition session for a house that has multiple rooms, and for each of the multiple rooms:
      a first panorama image captured by a camera device that is moved by a first user and that lacks any GPS (global positioning system) receivers, the first panorama image captured at a first acquisition location in that room and having first visual data with 360 degrees of horizontal visual coverage showing walls of that room, and
      second data concurrently captured by a mobile capture device that is moved independently from the camera device by a second user, the second data including multiple GPS location data points for multiple second capture locations in that room;
   determining, by the one or more computing devices, a floor plan for the house with associated GPS location data based at least in part on combining the second data captured at the multiple second capture locations in each of the multiple rooms with information about that room determined from analysis of the first visual data of the first panorama image captured in that room, including:
      analyzing, by the one or more computing devices and for each of the multiple rooms, the first visual data of the first panorama image captured in that room to determine a three-dimensional ("3D") room shape of that room that models at least some of the walls of that room as planar surfaces, and a position within that determined 3D room shape of the first acquisition location in that room;
      determining, by the one or more computing devices and for each of the multiple rooms, a representative GPS location data point associated with the first acquisition location in that room, including identifying two or more candidate GPS location data points from the multiple GPS location data points captured in that room using capture times of the two or more candidate GPS location data points, and using the two or more candidate GPS location data points to produce the representative GPS location data point for the first acquisition location in that room;
      generating, by the one or more computing devices, the floor plan for the house, including positioning the determined 3D room shapes of the multiple rooms relative to each other, and determining a position in the floor plan, using a local coordinate system for the floor plan, of the first acquisition location in each of the multiple rooms;
      determining, by the one or more computing devices, a global transformation that maps data in a first data set to data in a second data set, the first data set including the positions in the floor plan of the first acquisition locations of the multiple rooms using the local coordinate system for the floor plan, and the second data set including the representative GPS location data points associated with the first acquisition locations;
      determining, by the one or more computing devices and for each of the multiple rooms, GPS location data for the at least some walls of the determined 3D room shape of that room by using the global transformation to combine the determined GPS location data for the first acquisition location in that room with the determined position within that determined 3D room shape of the first acquisition location in that room; and
      identifying, by the one or more computing devices, at least one exterior wall of the house represented on the floor plan, and using the GPS location data for the at least some walls of the determined 3D room shapes of the multiple rooms to determine associated GPS location data for the at least one exterior wall; and
   displaying, by the one or more computing devices and using the associated GPS location for the at least one exterior wall of the floor plan, the generated floor plan for the house positioned on a map of an area that surrounds a property on which the house is located.
A02. A computer-implemented method for one or more computing devices to perform automated operations comprising:
   obtaining, by the one or more computing devices, a plurality of images and a plurality of GPS (global positioning system) location data points in multiple rooms of a building, including, for each of the multiple rooms, one or more images of the plurality of images that are acquired by a camera device at a first acquisition location in that room and have visual coverage of walls of that room, and multiple GPS location data points of the plurality of GPS location data points that are concurrently captured at multiple second capture locations in that room by a mobile capture device moved independently from the camera device;
   obtaining, by the one or more computing devices and based on visual data of the plurality of images, a floor plan for the building and information about positions on the floor plan of the first acquisition locations that use a coordinate system local to the floor plan, including determining, for each of the multiple rooms, a room shape of that room including at least some of the walls of that room and a position within that room shape of the first acquisition location in that room, and further including positioning the room shapes of the multiple rooms relative to each other;
   determining, by the one or more computing devices and for each of the multiple rooms, a representative GPS location data point associated with the first acquisition location in that room, including identifying two or more candidate GPS location data points from the multiple GPS location data points captured in that room using capture times of the two or more candidate GPS location data points, and using the two or more candidate GPS location data points to produce the representative GPS location data point for the first acquisition location in that room;
   determining, by the one or more computing devices, a global transformation that maps data in a first data set to data in a second data set, the first data set including the positions in the floor plan of the first acquisition locations using the coordinate system local to the floor plan, and the second data set including the representative GPS location data points associated with the first acquisition locations;
   determining, by the one or more computing devices, one or more GPS location data points for one or more positions on the floor plan corresponding to one or more locations on external walls of the building, including using the global transformation to convert, for the one or more positions on the one or more external walls, local coordinates in the coordinate system local to the floor plan for the one or more positions to the one or more GPS location data points; and
   providing, by the one or more computing devices, a visual representation of the floor plan for the building that is overlaid on a map at map locations corresponding to the determined one or more GPS location data points for the one or more positions on the one or more external walls of the building.
A03. A computer-implemented method for one or more computing devices to perform automated operations comprising:
   obtaining, by the one or more computing devices and after obtaining a plurality of images and a plurality of GPS (global positioning system) location data points in multiple rooms of a building, at least a partial floor plan for the building that is based at least in part on visual data of the plurality of images, wherein the plurality of images includes, for each of the multiple rooms, an image of the plurality of images that is acquired by a camera device at a first acquisition location in that room and has visual coverage of at least some walls of that room, wherein the plurality of GPS location data points includes, for each of the multiple rooms, multiple GPS location data points of the plurality of GPS location data points that are captured at multiple second capture locations in that room separately from acquisition of the image in that room and within a defined amount of time of acquisition of the image in that room, wherein the at least partial floor plan includes determined room shapes for the multiple rooms positioned relative to each other, each room shape for a room including representations of the at least some of the walls of that room, and wherein the at least partial floor plan includes information about positions on the at least partial floor plan of the first acquisition locations that use a coordinate system local to the at least partial floor plan;
   determining, by the one or more computing devices, and for each of the multiple rooms by using the multiple GPS location data points captured at the multiple second capture locations in that room, a representative GPS location data point associated with the first acquisition location in that room;
   determining, by the one or more computing devices, one or more GPS location data points for one or more positions on the at least partial floor plan, including converting, for local coordinates for the one or more positions that are in the coordinate system local to the at least partial floor plan, those local coordinates to the one or more GPS location data points; and
   providing, by the one or more computing devices, a visual representation of the at least partial floor plan for the building for inclusion on a map at one or more map locations corresponding to the determined one or more GPS location data points for the one or more positions.
A04. A computer-implemented method for one or more computing devices to perform automated operations comprising:
   obtaining a plurality of images and a plurality of absolute location data points in one or more rooms of a building, including, for each of the one or more rooms, an image of the plurality of images that is acquired by a camera device at each of one or more first acquisition locations in that room and has visual coverage of at least some walls of that room, and multiple absolute location data points of the plurality of absolute location data points that are captured at multiple second capture locations in that room by a mobile capture device that is movable independently from the camera device;
   obtaining, based at least in part on visual data of the plurality of images and for each of the one or more rooms, a room shape for that room and information about a position in the room shape of each of the one or more first acquisition locations in that room that use a coordinate system local to that room shape, the room shape for a room including representations of the at least some of the walls of that room;
   determining, for each of the one or more rooms and by using the multiple absolute location data points captured at the multiple second capture locations in that room, a representative absolute location data point associated with each of the one or more first acquisition locations in that room;
   determining a global transformation that maps data in a first data set to data in a second data set, the first data set including, for each of the one or more rooms, the positions in that room of the one or more first acquisition locations in that room using the coordinate system local to the room shape of the room, and the second data set including the representative GPS location data points associated with the first acquisition locations;
   determining, for each of at least one room shape for the one or more rooms, one or more absolute location data points for one or more positions on that room shape, including using the global transformation to convert, for local coordinates for the one or more positions that are in the coordinate system local to that room shape, those local coordinates to the one or more absolute location data points; and
   providing a visual representation of the at least one room shape using the determined one or more absolute location data points for each of the at least one room shapes.
A05. The computer-implemented method of any one of clauses A01-A04 wherein the two or more candidate GPS location data points associated with the first acquisition location in one of the multiple rooms are captured at multiple times and at multiple capture locations and are a subset of the multiple GPS location data points captured in the one room after performing smoothing operations that remove outlier data points, wherein the one or more computing devices include the mobile capture device, and wherein the determining of the representative GPS location data point associated with the first acquisition location in the one room includes:
   retrieving, by the one or more computing devices, an acquisition time of the first panorama image acquired at the first acquisition location in the one room;
   determining, by the one or more computing devices, the two or more candidate GPS location data points associated with the first acquisition location in the one room based at least in part on the two or more candidate GPS location data points having capture times that are within a defined time window around the retrieved acquisition time; and
   generating, by the one or more computing devices, the representative GPS location data point associated with the first acquisition location in the one room based at least in part on averaging location data for the multiple capture locations of the two or more candidate GPS location data points associated with the first acquisition location in the one room.
A06. The computer-implemented method of any one of clauses A01-A05 wherein the determining of the GPS location data for the at least some walls of the determined 3D room shape for each of the multiple rooms includes, by the one or more computing devices and for each of at least some of the first acquisition locations, determining a revised representative GPS location data point for that first acquisition location based on the global transformation, and further includes extending GPS location data from each of one or more of the first acquisition locations to the at least some walls of the determined 3D room shape for the room in which that first acquisition location is positioned, wherein walls to which the GPS location data is extended include the at least one exterior wall.
A07. The computer-implemented method of any one of clauses A01-A06 wherein the determining of the global transformation includes at least one of:
   determining, by the one or more computing devices, a rigid transformation between the first and second data sets using Kabsch algorithm; or
   determining, by the one or more computing devices, a rigid transformation between the first and second data sets using Quaternion estimation algorithm; or
   determining, by the one or more computing devices, a rigid transformation between the first and second data sets using an algorithm that can solve Wahba's problem; or
   determining, by the one or more computing devices, the global transformation using point-set registration techniques; or
   determining, by the one or more computing devices, the global transformation using a trained machine learning model that takes as input at least the first and second data sets and that produces the global transformation as an output.
A08. The computer-implemented method of any one of clauses A01-A07 wherein the two or more candidate GPS location data points associated with the first acquisition location in one of the multiple rooms are captured at multiple times and at multiple capture locations and are a subset of the multiple GPS location data points captured in the one room after performing smoothing operations that remove outlier data points, wherein the camera device lacks any GPS receivers, and wherein the determining of the representative GPS location data point associated with the first acquisition location in the one room includes:
   retrieving, by the one or more computing devices, an acquisition time of one of the images acquired at the first acquisition location in the one room;
   determining, by the one or more computing devices, the two or more candidate GPS location data points associated with the first acquisition location in the one room based at least in part on the two or more candidate GPS location data points having capture times that are within a defined time window around the retrieved acquisition time; and
   generating, by the one or more computing devices, the representative GPS location data point associated with the first acquisition location in the one room based at least in part on averaging location data for the multiple capture locations of the two or more candidate GPS location data points associated with the first acquisition location in the one room.
A09. The computer-implemented method of any one of clauses A01-A08 wherein the determining of the one or more GPS location data points for the one or more positions on the floor plan corresponding to the one or more locations on the external walls of the building includes, by the one or more computing devices, determining a revised representative GPS location data point for each of at least some of the first acquisition locations based on the global transformation, and extending GPS location data from each of one or more of the first acquisition locations to one or more walls of the room shape of the room in which that first acquisition location is positioned, wherein walls to which the GPS location data is extended include the one or more external walls.
A10. The computer-implemented method of any one of clauses A01-A09 wherein the determining of the global transformation includes at least one of:
   determining, by the one or more computing devices, a rigid transformation between the first and second data sets using Kabsch algorithm; or
   determining, by the one or more computing devices, a rigid transformation between the first and second data sets using Quaternion estimation algorithm; or
   determining, by the one or more computing devices, a rigid transformation between the first and second data sets using an algorithm that can solve Wahba's problem; or
   determining, by the one or more computing devices, the global transformation using point-set registration techniques; or
   determining, by the one or more computing devices, the global transformation using a trained machine learning model that takes as input at least the first and second data sets and that produces the global transformation as an output.
A11. The computer-implemented method of any one of clauses A01-A10 wherein the stored contents include software instructions that, when executed by the one or more computing devices, cause the one or more computing devices to perform further automated operations including determining, by the one or more computing devices, a global transformation that maps data in a first data set to data in a second data set, the first data set including the positions in the at least partial floor plan of the first acquisition locations using the coordinate system local to the at least partial floor plan, and the second data set including the representative GPS location data points associated with the first acquisition locations, and wherein the converting of the local coordinates in the coordinate system local to the at least partial floor plan to the one or more GPS location data points includes using the global transformation.
A12. The computer-implemented method of clause A11 wherein the determining of the global transformation includes at least one of:
   determining, by the one or more computing devices, a first rigid transformation between the first and second data sets using Kabsch algorithm; or
   determining, by the one or more computing devices, a second rigid transformation between the first and second data sets using Quaternion estimation algorithm; or
   determining, by the one or more computing devices, a third rigid transformation between the first and second data sets using an algorithm that solves Wahba's problem; or
   determining, by the one or more computing devices, the global transformation using point-set registration techniques; or
   determining, by the one or more computing devices, the global transformation using a trained machine learning model that takes as input at least the first and second data sets and that produces the global transformation as an output.
A13. The computer-implemented method of any one of clauses A01-A12 wherein the stored contents include software instructions that, when executed by the one or more computing devices, cause the one or more computing devices to perform further automated operations including determining, by the one or more computing devices, a global transformation that maps data in a first data set to data in a second data set, the first data set including the positions in the at least partial floor plan of the first acquisition locations using the coordinate system local to the at least partial floor plan, and the second data set including the representative GPS location data points associated with the first acquisition locations, and wherein the converting of the local coordinates in the coordinate system local to the at least partial floor plan to the one or more GPS location data points includes:
   determining, by the one or more computing devices, a revised representative GPS location data point for each of at least some of the first acquisition locations based on the global transformation; and
   extending, by the one or more computing devices, GPS location data from each of one or more of the at least some first acquisition locations to one or more walls of the room shape of the room in which that first acquisition location is positioned, wherein walls to which the GPS location data is extended include one or more external walls of the building that have the one or more positions on the at least partial floor plan.
A14. The computer-implemented method of any one of clauses A01-A13 wherein the visual representation of the at least partial floor plan is at least one of a two-dimensional floor plan model or a three-dimensional floor plan model, and wherein the determining of the one or more GPS location data points for the one or more positions on the at least partial floor plan includes determining the one or more GPS location data points for one or more positions corresponding to one or more external walls of the building.
A15. The computer-implemented method of any one of clauses A01-A14 wherein capturing of the multiple GPS location data points at the multiple second locations in one of the multiple rooms is performed by a mobile capture device that moves independently from the camera devices and includes capturing additional GPS location data points in the one room at additional times, and wherein the automated operations further include selecting the multiple GPS location data points for the determining of the representative GPS location data for the first acquisition location in the one room based at least in part on the multiple GPS location data points being captured within the defined amount of time of the acquisition of the image in the one room.
A16. The computer-implemented method of clause A15 wherein the camera device lacks any GPS receivers, wherein the automated operations further include, before the selecting of the multiple GPS location data points, performing smoothing operations on the additional GPS location data points that includes removing one or more of the additional GPS location data points that is determined to be an outlier, and wherein the determining of the representative GPS location data point associated with the first acquisition location in the one room includes:
   retrieving, by the one or more computing devices, the time of acquisition of the image acquired at the first acquisition location in the one room;
   selecting, by the one or more computing devices, the multiple GPS location data points associated with the first acquisition location in the one room based at least in part on the multiple GPS location data points having capture times that are within a defined time window around the retrieved acquisition time, the defined time window being based on the defined amount of time; and
   generating, by the one or more computing devices, the representative GPS location data point associated with the first acquisition location in the one room based at least in part on combining location data of the multiple GPS location data points for the multiple second capture locations in the one room.
A17. The computer-implemented method of any one of clauses A01-A16 wherein the determining of the representative GPS location data point associated with the first acquisition location in one of the multiple rooms includes selecting, by the one or more computing devices, one of the multiple GPS location data points captured in the one room to use as the representative GPS location data point associated with the first acquisition location in the one room, the selecting being based at least in part on time of capture of the one GPS location data point and on time of the acquisition of the image in the one room.
A18. The computer-implemented method of any one of clauses A01-A17 wherein capturing of the multiple GPS location data points at the multiple second capture locations in one of the multiple rooms is performed by the camera device and includes capturing additional GPS location data points in the one room at additional times, and wherein the automated operations further include selecting the multiple GPS location data points for the determining of the representative GPS location data for the first acquisition location in the one room based at least in part on the multiple GPS location data points being captured within the defined amount of time of the acquisition of the image in the one room.
A19. The computer-implemented method of any one of clauses A01-A18 wherein the obtaining of the at least partial floor plan includes determining, for each of the multiple rooms, a room shape of that room including at least some of the walls of that room and a position within that room shape of the first acquisition location in that room, and further includes positioning the room shapes of the multiple rooms relative to each other.
A20. The computer-implemented method of any one of clauses A01-A19 wherein the providing of the visual representation of the at least partial floor plan for the building includes overlaying, by the one or more computing devices, the visual representation of the at least partial floor plan on the map at the one or more map locations corresponding to the determined one or more GPS location data points for the one or more positions, the map covering an area larger than a property on which the building is located, and further includes transmitting the map with the overlaid visual representation to a client device for display.
A21. The computer-implemented method of any one of clauses A01-A20 wherein the automated operations further include:
   obtaining, by the one or more computing devices, a plurality of additional GPS location data points that are external to the building and are captured by a data capture device on a property on which the building is located; and
   determining, by the one or more computing devices, at least one of the plurality of additional GPS location data points to represent an external doorway of the building, the determining based on at least one of analyzing additional visual data of one or more additional acquired images that includes the external doorway to determine when the data capture device is proximate to the external doorway, or receiving input from an operator user of the data capture device related to a positioning of the data capture device proximate to the external doorway,
   and wherein at least one of the determining of the one or more GPS location data points for the one or more positions on the at least partial floor plan, or positioning of the visual representation of the at least partial floor plan for the building on the map, is further based in part on the determined at least one additional GPS location data point to represent the external doorway.
A22. The computer-implemented method of any one of clauses A01-A21 wherein the automated operations further include:
   obtaining, by the one or more computing devices, a plurality of additional GPS location data points that are external to the building and are captured by a data capture device on a property on which the building is located, wherein the plurality of the additional GPS location data points are captured during a traversal of an exterior boundary of the building; and
   determining, by the one or more computing devices, at least one of a shape or a position of the exterior boundary of the building based at least in part on the plurality of additional GPS location data points,
   and wherein at least one of the determining of the one or more GPS location data points for the one or more positions on the at least partial floor plan, or positioning of the visual representation of the at least partial floor plan for the building on the map, is further based in part on the determined at least one of the shape or the position of the exterior boundary.
A23. The computer-implemented method of any one of clauses A01-A22 wherein the automated operations further include:
   obtaining, by the one or more computing devices, a plurality of additional GPS location data points that are external to the building and are captured by a data capture device on a property on which the building is located, wherein the plurality of the additional GPS location data points are captured during a traversal of an exterior walkway to the building and correspond to a substantially straight line; and
   determining, by the one or more computing devices, a position of the exterior walkway based at least in part on the plurality of additional GPS location data points,
   and wherein at least one of the determining of the one or more GPS location data points for the one or more positions on the at least partial floor plan, or positioning of the visual representation of the at least partial floor plan for the building on the map, is further based in part on the determined position of the exterior walkway.
A24. The computer-implemented method of any one of clauses A01-A23 wherein the plurality of GPS location data points are captured in the multiple rooms by a data capture device, and wherein the automated operations further include, before the obtaining of the plurality of GPS location data points in the multiple rooms:
   providing, by the one or more computing device , instructions related to a movement pattern of the data capture device externally to the building to enable an improved accuracy of the plurality of GPS location data points in the multiple rooms during their subsequent capture; and
   obtaining, by the one or more computing devices, a plurality of additional GPS location data points that are captured by the data capture device corresponding to the movement pattern of the data capture device externally to the building.
A25. The computer-implemented method of any one of clauses A01-A24 wherein the automated operations further include obtaining, by the one or more computing devices, at least one of additional geographical directional data for at least one location at the building, or additional absolute location data for the at least one location that is not GPS location data, and wherein positioning of the visual representation of the at least partial floor plan for the building on the map is based in part on the at least one of the additional geographical directional data or the additional absolute location data.
A26. The computer-implemented method of any one of clauses A01-A25 wherein the images acquired in the multiple rooms each includes 360 degrees of horizontal visual coverage around a vertical axis, and wherein determining of room shapes of the multiple rooms is performed without using any depth information from any depth-sensing sensors for distances to surrounding surfaces from locations of the camera device in the multiple rooms.
A27. The computer-implemented method of any one of clauses A01-A26 wherein the absolute location data points are GPS (global positioning system) data points, and wherein the one or more positions on each of the at least one room shapes include one or more positions corresponding to one or more external walls of the building.
A28. The computer-implemented method of any one of clauses A01-A27 wherein the plurality of images and plurality of absolute location data points include images and absolute location data points from multiple rooms of the building, and wherein the obtaining of the room shape for each of the one or more rooms includes:
   determining, for each of the multiple rooms, a room shape of that room including at least some of the walls of that room and a position within that room shape of a first acquisition location in that room;
   positioning the room shapes of the multiple rooms relative to each other to form at least a partial floor plan for the building,
   and wherein the provided visual representation of the at least one room shape is a visual representation of the at least partial floor plan, and wherein the coordinate system local to the room shape of each of the one or more rooms is a coordinate system local to the at least partial floor plan.
A29. The computer-implemented method of clause A28 wherein providing of the visual representation of the at least one room shape for the building includes overlaying the visual representation of the at least partial floor plan on a map at the one or more map locations corresponding to the determined one or more absolute location data points for each of the at least one room shapes, the map covering an area larger than a property on which the building is located, and further includes transmitting the map with the overlaid visual representation to a client device for display.
A30. The computer-implemented method of any one of clauses A01-A29 wherein the camera device lacks any GPS receivers, and wherein the determining of the representative absolute location data point associated with a first acquisition location in a room includes:
   determining a time of acquisition of the image acquired at that first acquisition location;
   selecting two or more of the multiple absolute location data points acquired in that room based at least in part on the two or more absolute location data points having capture times that are within a defined amount of time of the determined time of acquisition; and
   generating the representative absolute location data point associated with that first acquisition location based at least in part on combining location data of the two or more absolute location data points.
A31. A computer-implemented method comprising multiple steps to perform automated operations that implement described techniques substantially as disclosed herein.
B01. A non-transitory computer-readable medium having stored executable software instructions and/or other stored contents that cause one or more computing systems to perform automated operations that implement the method of any of clauses A01-A31.
B02. A non-transitory computer-readable medium having stored executable software instructions and/or other stored contents that cause one or more computing systems to perform automated operations that implement described techniques substantially as disclosed herein.
C01. One or more computing systems comprising one or more hardware processors and one or more memories with stored instructions that, when executed by at least one of the one or more hardware processors, cause the one or more computing systems to perform automated operations that implement the method of any of clauses A01-A31.
C02. One or more computing systems comprising one or more hardware processors and one or more memories with stored instructions that, when executed by at least one of the one or more hardware processors, cause the one or more computing systems to perform automated operations that implement described techniques substantially as disclosed herein.
D01. A computer program adapted to perform the method of any of clauses A01-A31 when the computer program is run on a computer.
E01. A computer-implemented method for one or more computing devices to perform automated operations comprising:
   obtaining, by the one or more computing devices during an acquisition session for a house that has multiple rooms, and for each of the multiple rooms:
      a first panorama image captured by a camera device that is moved by a first user and that lacks any GPS (global positioning system) receivers, the first panorama image captured at a first acquisition location in that room and having first visual data with 360 degrees of horizontal visual coverage showing walls of that room, and
      second data concurrently captured by a mobile capture device that is moved independently from the camera device, the second data including multiple GPS location data points for multiple second capture locations in that room;
   determining, by the one or more computing devices, a floor plan for the house with associated GPS location data based at least in part on combining the second data captured at the multiple second capture locations in each of the multiple rooms with information about that room determined from analysis of the first visual data of the first panorama image captured in that room, including:
      analyzing, by the one or more computing devices and for each of the multiple rooms, the first visual data of the first panorama image captured in that room to determine a three-dimensional ("3D") room shape of that room that models at least some of the walls of that room as planar surfaces, and a position within that determined 3D room shape of the first acquisition location in that room;
      determining, by the one or more computing devices and for each of the multiple rooms, a representative GPS location data point associated with the first acquisition location in that room, including identifying two or more candidate GPS location data points from the multiple GPS location data points captured in that room using capture times of the two or more candidate GPS location data points, and using the two or more candidate GPS location data points to produce the representative GPS location data point for the first acquisition location in that room;
      generating, by the one or more computing devices, the floor plan for the house, including positioning the determined 3D room shapes of the multiple rooms relative to each other, and determining a position in the floor plan, using a local coordinate system for the floor plan, of the first acquisition location in each of the multiple rooms;
      determining, by the one or more computing devices and for each of the multiple rooms, GPS location data for the at least some walls of the determined 3D room shape of that room by combining the determined GPS location data for the first acquisition location in that room with the determined position within that determined 3D room shape of the first acquisition location in that room; and
      identifying, by the one or more computing devices, at least one exterior wall of the house represented on the floor plan, and using the GPS location data for the at least some walls of the determined 3D room shapes of the multiple rooms to determine associated GPS location data for the at least one exterior wall;
   determining, by the one or more computing devices and based at least in part on the determined associated GPS location data for the at least one exterior wall, positions on a map of an area including the building that correspond to the floor plan;
   determining, by the one or more computing devices and based at least in part on the determined positions on the map, one or more levels of detail for interior portions of the building to display on the map for each of one or more stories of the building; and
   presenting, by the one or more computing devices and as part of a graphical user interface (GUI), the map with a visual representation of the floor plan, including overlaying the visual representation of the floor plan on the map at the determined positions and fitting exterior boundaries of the building on the floor plan to an existing visual representation of the building on the map before the overlaying, and wherein the overlaid visual representation includes visual indications for the interior portions of the building with the determined one or more levels of detail and including at least interior walls of the multiple rooms.
E02. A computer-implemented method for one or more computing devices to perform automated operations comprising:
   obtaining, by the one or more computing devices, a floor plan for a building with multiple rooms and information about a plurality of GPS (global positioning system) location data points captured during traversal of an interior of the multiple rooms, the floor plan including room shapes of the multiple rooms positioned relative to each other;
   determining, by the one or more computing devices and based at least in part on the plurality of GPS location data points, one or more GPS location data points for one or more locations on the floor plan corresponding to at least one external wall of the building, including extending one or more of the captured GPS data points from the interior of the multiple rooms to the at least one external wall of the building;
   determining, by the one or more computing devices and based at least in part on the determined one or more GPS location data points for the one or more locations on the floor plan, positions on a map of an area including the building that correspond to the floor plan;
   determining, by the one or more computing devices and based at least in part on the determined positions on the map, one or more levels of detail for interior portions of the building to display on the map for each of one or more stories of the building; and
   presenting, by the one or more computing devices and as part of a graphical user interface (GUI), the map with a visual representation of the floor plan that is overlaid on the map at the determined positions and that includes visual indications for the interior portions of the building with the determined one or more levels of detail and including at least interior walls of the multiple rooms.
E03. A computer-implemented method for one or more computing devices to perform automated operations comprising:
   obtaining, by the one or more computing devices, a floor plan for a building with multiple rooms and information about a plurality of GPS (global positioning system) location data points captured during traversal of the multiple rooms, the floor plan including room shapes of the multiple rooms positioned relative to each other;
   determining, by the one or more computing devices and based at least in part on the plurality of GPS location data points, one or more GPS location data points for one or more locations on the floor plan corresponding to at least one external wall of the building;
   determining, by the one or more computing devices and based at least in part on the determined one or more GPS location data points for the one or more locations on the floor plan, positions on a map of an area including the building that correspond to the floor plan;
   retrieving, by the one or more computing devices, additional information about the building of multiple types; and
   presenting, by the one or more computing devices and as part of a graphical user interface (GUI), the map with a visual representation of the floor plan that is overlaid at the determined positions in a first section of the GUI, and additional sections of the GUI that each includes at least some additional information for a respective one of the multiple types.
E04. A computer-implemented method for one or more computing devices to perform automated operations comprising:
   obtaining, for a building with multiple rooms, at least a partial floor plan for the building that includes room shapes for one or more rooms of the multiple rooms, and information about a plurality of absolute location data points captured in the one or more rooms;
   determining, based at least in part on the plurality of absolute location data points, one or more absolute location data points for one or more locations on the at least partial floor plan;
   determining, based at least in part on the determined one or more absolute location data points for the one or more locations on the at least partial floor plan, positions on a map of an area including the building that correspond to the at least partial floor plan;
   determining one or more levels of detail for interior portions of the building to display on the map for each of one or more stories of the building; and
   presenting the map with a visual representation of the at least partial floor plan that is shown at the determined positions on the map and that includes data corresponding to the determined one or more levels of detail for the interior portions of the building.
E05. A computer-implemented method for one or more computing devices to perform automated operations comprising:
   obtaining, by the one or more computing devices and for a building on a property, at least a partial floor plan for the building that includes room shapes for one or more rooms of the building, and first information about a plurality of absolute location data points captured in the one or more rooms, and second information about one or more external features on the property and outside of the building;
   determining, by the one or more computing devices and based at least in part on the plurality of absolute location data points, one or more absolute location data points for one or more locations on the at least partial floor plan;
   determining, by the one or more computing devices and based at least in part on the determined one or more absolute location data points for the one or more locations on the at least partial floor plan, positions that correspond to the at least partial floor plan on a map including the property;
   determining, by the one or more computing devices and for each of the one or more external features, a location on the property of that external feature; and
   presenting, by the one or more computing devices, the map with a visual representation of the at least partial floor plan that is shown at the determined positions on the map, and further with, for each of the one or more external features, an additional visual representation of that external feature at the determined location on the property of that external feature.
E06. The computer-implemented method of any one of clauses E01-E05 wherein the at least partial floor plan includes multiple room shapes of two or more of the multiple rooms positioned relative to each other, and wherein the presenting of the visual representation of the at least partial floor plan includes presenting, in a graphical user interface, the visual representation of the at least partial floor plan overlaid on the map and with visual indications of interior walls of the two or more rooms.
E07. The computer-implemented method of clause E06 wherein the obtaining of the at least partial floor plan and the information about the plurality of absolute location data points includes:
   obtaining a plurality of images captured in the two or more rooms of the building, including, for each of the one or two or more rooms, one or more images of the plurality of images that are acquired by a camera device at one or more first acquisition locations in that room and have visual coverage of at least some walls of that room, and wherein multiple absolute location data points of the plurality of absolute location data points are captured at multiple second capture locations in that room by a mobile capture device that is movable independently from the camera device;
   determining, for each of the two or more rooms and based on the visual data of the one or more images captured in that room, a room shape of that room including the at least some of the walls of that room; and
   generating the at least partial floor plan by positioning the room shapes of the two or more rooms relative to each other.
E08. The computer-implemented method of any one of clauses E01-E07 wherein the determining of the one or more levels of detail for the interior portions of the building to display on the map for each of the one or more stories of the building includes determining a size on the map at which the visual representation of the floor plan will be shown based on at least one of the determined positions on the map or a zoom level of the map, and selecting multiple levels of detail to display for the interior portions of the building based at least in part on the determined size.
E09. The computer-implemented method of clause E08 wherein the multiple levels of detail include two or more of interior walls of the at least partial floor plan, or one or more types of appliances at indicated positions within the interior walls, or one or more types of fixtures at indicated positions on or within the interior walls, or one or more types of built-in structural elements at indicated positions on or within the interior walls, or one or more types of installed elements at indicated positions on or within the interior walls, or one or more types of furniture at indicated positions within the interior walls.
E10. The computer-implemented method of any one of clauses E08-E09 wherein the selecting of the multiple levels of detail to display for the interior portions of the building is further based at least in part on information specific to a user to whom the map is presented.
E11. The computer-implemented method of any one of clauses E08-E10 wherein the building has multiple stories, wherein the visual presentation of the at least partial floor plan includes a room shape of at least one room on each of the multiple stories, and wherein the method further comprises:
   receiving, after the presenting of the map with the visual representation of the at least partial floor plan including the room shape of the at least one room on each of the multiple stories, one or more user interactions with the presented map; and
   updating, in response to the one or more user interactions, the presented map to show an updated visual presentation of the at least partial floor plan that includes information for only a single story of the multiple stories.
E12. The computer-implemented method of clause E11 wherein the one or more user interactions include changing a zoom level of the map, and the updating of the presented map includes selecting the single story based at least in part on the changed zoom level of the map.
E13. The computer-implemented method of any one of clauses E08-E12 wherein the building has multiple stories, wherein the determining of the one or more levels of detail for the interior portions of the building to display on the map for each of the one or more stories of the building further includes selecting one of the multiple stories, wherein the visual presentation of the at least partial floor plan includes a room shape of at least one room on the selected one story, and wherein the automated operations further include:
   receiving, after the presenting of the map with the visual representation of the at least partial floor plan including the room shape of the at least one room on the selected one story, one or more user interactions with the presented map; and
   updating, in response to the one or more user interactions, the presented map to show an updated visual presentation of the at least partial floor plan that includes an additional room shape of at least one additional room on an additional story of the multiple stories that is different from the selected one story.
E14. The computer-implemented method of any one of clauses E01-E13 wherein the one or more user interactions include changing a zoom level of the map, and the updating of the presented map includes determining to add visual information for the additional story in combination with visual information for the selected one story based at least in part on the changed zoom level of the map.
E15. The computer-implemented method of any one of clauses E01-E14 wherein the automated operations further include, before the presenting of the map with the visual representation, gathering data about surroundings of the building, and generating the visual representation of the at least partial floor plan to include at least some of the gathered data as part of the visual representation.
E16. The computer-implemented method of any one of clauses E01-E15 wherein the automated operations further include, before the presenting of the map with the visual representation, gathering data about surroundings of the building, and wherein the presenting of the map includes overlaying additional information on the map proximate to the visual representation to provide visual indications of at least some of the gathered data in a manner relative to the presented visual representation on the map.
E17. The computer-implemented method of any one of clauses E01-E16 wherein the automated operations further include, before the presenting of the map with the visual representation, obtaining information about one or more additional buildings located proximate to the building, and wherein at least one of the determining of the positions on the map or the presenting of the map with the visual representation includes positioning the visual representation relative to locations on the map of the one or more additional buildings.
E18. The computer-implemented method of any one of clauses E01-E17 wherein the presenting of the map with the visual representation includes overlaying the visual representation of the at least partial floor plan on the map using the determined positions on the map and further overlaying at least one additional visual indication of at least one geographical direction, the visual representation being at least one of a two-dimensional floor plan model or a three-dimensional floor plan model, and further includes transmitting the map with the overlaid visual representation to a client device for display, the area of the map being larger than a property on which the building is located.
E19. The computer-implemented method of any one of clauses E01-E18 wherein the map includes an existing visual representation of the building before the overlaying of the visual representation of the at least partial floor plan, and wherein the overlaying of the visual representation of the at least partial floor plan includes fitting exterior boundaries of the building on the at least partial floor plan to the existing visual representation of the building.
E20. The computer-implemented method of any one of clauses E01-E19 wherein the method further comprises determining, by the one or more computing devices and based at least in part on the determined positions on the map, one or more levels of detail for interior portions of the building to display on the map for each of one or more stories of the building, and wherein the presenting of the map with the visual representation of the floor plan includes overlaying the visual representation at the determined positions and that includes visual indications for interior portions of the building with the determined one or more levels of detail and including at least interior walls of the multiple rooms.
E21. The computer-implemented method of any one of clauses E01-E20 wherein the plurality of the GPS location data points are captured during traversal of an interior of the multiple rooms, and wherein the determining of the one or more GPS location data points for the one or more locations on the floor plan corresponding to the at least one external wall of the building includes extending one or more of the captured GPS data points from the interior of the multiple rooms to the at least one external wall of the building.
E22. The computer-implemented method of any one of clauses E01-E21 wherein the multiple types of the additional information include two or more of an image of an interior of the building, or a video of the interior of the building, or a textual description of the building, or a street-level view of an exterior of the building, or an overview view of an exterior of the building.
E23. The computer-implemented method of any one of clauses E01-E22 wherein the determining of the one or more levels of detail for the interior portions of the building to display on the map for each of the one or more stories of the building includes determining a size on the map at which the visual representation of the floor plan will be shown based on at least one of the determined positions on the map or a zoom level of the map, and selecting multiple levels of detail to display for the interior portions of the building based at least in part on the determined size.
E24. The computer-implemented method of clause E23 wherein the multiple levels of detail include two or more of interior walls of the floor plan, or one or more types of appliances at indicated positions within the interior walls, or one or more types of fixtures at indicated positions on or within the interior walls, or one or more types of built-in structural elements at indicated positions on or within the interior walls, or one or more types of installed elements at indicated positions on or within the interior walls, or one or more types of furniture at indicated positions within the interior walls, wherein the presenting of the map with the visual representation includes overlaying the visual representation of the floor plan on the map at the determined positions and fitting exterior boundaries of the building on the floor plan to an existing visual representation of the building on the map before the overlaying, and wherein the overlaid visual representation includes visual indications for interior portions of the building with the multiple levels of detail.
E25. The computer-implemented method of any one of clauses E01-E24 wherein the building has multiple stories, and wherein the method further comprises at least one of:
   receiving, after the presenting of the map with the visual representation of the floor plan, one or more user interactions with the presented map, the visual representation including a room shape of at least one room on each of the multiple stories, and updating, in response to the one or more user interactions, the presented map to show an updated visual presentation of the floor plan that includes information for only a single story of the multiple stories; or
   receiving, after the presenting of the map with the visual representation of the floor plan, one or more user interactions with the presented map, the visual representation including a room shape of at least one room on a selected one story of the multiple stories, and updating, in response to the one or more user interactions, the presented map to show an updated visual presentation of the floor plan that includes an additional room shape of at least one additional room on an additional story of the multiple stories that is different from the selected one story.
E26. The computer-implemented method of any one of clauses E24-E25 wherein the one or more user interactions include changing a zoom level of the map, and the updating of the presented map is performed based at least in part on the changed zoom level of the map.
E27. The computer-implemented method of clause E26 wherein the determining of the one or more levels of detail for the interior portions of the building to display on the map for each of the one or more stories of the building includes determining a size on the map at which the visual representation of the floor plan will be shown based on at least one of the determined positions on the map or a zoom level of the map, and selecting multiple levels of detail to display for the interior portions of the building based at least in part on the determined size.
E28. The computer-implemented method of clause E27 wherein the multiple levels of detail include two or more of interior walls of the floor plan, or one or more types of appliances at indicated positions within the interior walls, or one or more types of fixtures at indicated positions on or within the interior walls, or one or more types of built-in structural elements at indicated positions on or within the interior walls, or one or more types of installed elements at indicated positions on or within the interior walls, or one or more types of furniture at indicated positions within the interior walls.
E29. The computer-implemented method of any one of clauses E01-E28 wherein the building has multiple stories, and wherein the method further comprises at least one of:
   receiving, after the presenting of the map with the visual representation of the floor plan, one or more user interactions with the presented map, the visual representation including a room shape of at least one room on each of the multiple stories, and updating, in response to the one or more user interactions, the presented map to show an updated visual presentation of the floor plan that includes information for only a single story of the multiple stories; or
   receiving, after the presenting of the map with the visual representation of the floor plan, one or more user interactions with the presented map, the visual representation including a room shape of at least one room on a selected one story of the multiple stories, and updating, in response to the one or more user interactions, the presented map to show an updated visual presentation of the floor plan that includes an additional room shape of at least one additional room on an additional story of the multiple stories that is different from the selected one story.
E30. The computer-implemented method of any one of clauses E01-E29 wherein the one or more user interactions include changing a zoom level of the map, and the updating of the presented map is performed based at least in part on the changed zoom level of the map.
E31. The computer-implemented method of any one of clauses E01-E30 wherein the absolute location data points include GPS (global positioning system) data points captured during traversal of an interior of the one or more rooms, wherein the one or more locations on the at least partial floor plan correspond to one or more external walls of the building, and wherein the determining of the one or more absolute location data points for the one or more locations on the at least partial floor plan include extending one or more of the captured GPS data points from the interior of the one or more rooms to the one or more external walls of the building.
E32. The computer-implemented method of any one of clauses E01-E31 wherein the automated operations further include:
   obtaining information about one or more external objects that are on a property including the building and that are external to the building;
   and wherein the presenting of the map with the visual representation of the at least partial floor plan includes displaying, for each of the one or more external objects, an additional visual representation of that external object at an additional position on the map corresponding to a location of that external object on the property.
E33. The computer-implemented method of any one of clauses E01-E32 wherein the automated operations further include:
   obtaining, by the one or more computing devices, information about one or more external objects that are on a property including the building and that are external to the building;
   and wherein the presenting of the map with the visual representation of the floor plan includes displaying, for each of the one or more external objects, an additional visual representation of that external object at an additional position on the map corresponding to a location of that external object on the property.
E34. The computer-implemented method of any one of clauses E01-E33 wherein the external features are each an object on the property outside of the building, and wherein the determining of a location on the property for an external feature includes at least one of analyzing visual data of an image that includes that external feature and has associated absolute location data, or retrieving information about that external feature from one or more public data sources.
E35. The computer-implemented method of any one of clauses E01-E34 wherein the at least partial floor plan includes multiple room shapes of two or more of the multiple rooms positioned relative to each other, wherein the absolute location data points include GPS (global positioning system) data points captured during traversal of an interior of the one or more rooms, wherein the one or more locations on the at least partial floor plan correspond to one or more external walls of the building, wherein the determining of the one or more absolute location data points for the one or more locations on the at least partial floor plan include extending one or more of the captured GPS data points from the interior of the one or more rooms to the one or more external walls of the building, and wherein the presenting of the map includes presenting, in a graphical user interface, the visual representation of the at least partial floor plan overlaid on the map and with visual indications of interior walls of the two or more rooms, and further includes presenting one or more areas on the map separate from the property.
E36. A computer-implemented method comprising multiple steps to perform automated operations that implement described techniques substantially as disclosed herein.
F01. A non-transitory computer-readable medium having stored executable software instructions and/or other stored contents that cause one or more computing systems to perform automated operations that implement the method of any of clauses E01-E36.
F02. A non-transitory computer-readable medium having stored executable software instructions and/or other stored contents that cause one or more computing systems to perform automated operations that implement described techniques substantially as disclosed herein.
G01. One or more computing systems comprising one or more hardware processors and one or more memories with stored instructions that, when executed by at least one of the one or more hardware processors, cause the one or more computing systems to perform automated operations that implement the method of any of clauses E01-E36.
G02. One or more computing systems comprising one or more hardware processors and one or more memories with stored instructions that, when executed by at least one of the one or more hardware processors, cause the one or more computing systems to perform automated operations that implement described techniques substantially as disclosed herein.
H01. A computer program adapted to perform the method of any of clauses E01-E36 when the computer program is run on a computer.

Aspects of the present disclosure are described herein with reference to flowchart illustrations and/or block diagrams of methods, apparatus (systems), and computer program products according to embodiments of the present disclosure. It will be appreciated that each block of the flowchart illustrations and/or block diagrams, and combinations of blocks in the flowchart illustrations and/or block diagrams, can be implemented by computer readable program instructions. It will be further appreciated that in some implementations the functionality provided by the routines discussed above may be provided in alternative ways, such as being split among more routines or consolidated into fewer routines. Similarly, in some implementations illustrated routines may provide more or less functionality than is described, such as when other illustrated routines instead lack or include such functionality respectively, or when the amount of functionality that is provided is altered. In addition, while various operations may be illustrated as being performed in a particular manner (e.g., in serial or in parallel, or synchronous or asynchronous) and/or in a particular order, in other implementations the operations may be performed in other orders and in other manners. Any data structures discussed above may also be structured in different manners, such as by having a single data structure split into multiple data structures and/or by having multiple data structures consolidated into a single data structure. Similarly, in some implementations illustrated data structures may store more or less information than is described, such as when other illustrated data structures instead lack or include such information respectively, or when the amount or types of information that is stored is altered.

From the foregoing it will be appreciated that, although specific embodiments have been described herein for purposes of illustration, various modifications may be made without deviating from the spirit and scope of the invention. Accordingly, the invention is not limited except as by corresponding claims and the elements recited by those claims. In addition, while certain aspects of the invention may be presented in certain claim forms at certain times, the inventors contemplate the various aspects of the invention in any available claim form. For example, while only some aspects of the invention may be recited as being embodied in a computer-readable medium at particular times, other aspects may likewise be so embodied.

## Claims

1. A non-transitory computer-readable medium having stored contents that cause one or more computing devices to perform automated operations including at least:
obtaining, by the one or more computing devices and after obtaining a plurality of images and a plurality of GPS (global positioning system) location data points in multiple rooms of a building, at least a partial floor plan for the building that is based at least in part on visual data of the plurality of images, wherein the plurality of images includes, for each of the multiple rooms, an image of the plurality of images that is acquired by a camera device at a first acquisition location in that room and has visual coverage of at least some walls of that room, wherein the plurality of GPS location data points includes, for each of the multiple rooms, multiple GPS location data points of the plurality of GPS location data points that are captured at multiple second capture locations in that room by a mobile capture device moved independently from the camera device and within a defined amount of time of acquisition of the image in that room, wherein the at least partial floor plan includes determined room shapes for the multiple rooms positioned relative to each other, each room shape for a room including representations of the at least some of the walls of that room, and wherein the at least partial floor plan includes information about positions on the at least partial floor plan of the first acquisition locations that use a coordinate system local to the at least partial floor plan;
determining, by the one or more computing devices, and for each of the multiple rooms by using the multiple GPS location data points captured at the multiple second capture locations in that room, a representative GPS location data point associated with the first acquisition location in that room;
determining, by the one or more computing devices, one or more GPS location data points for one or more positions on the at least partial floor plan, including converting, for local coordinates for the one or more positions that are in the coordinate system local to the at least partial floor plan, those local coordinates to the one or more GPS location data points; and
providing, by the one or more computing devices, a visual representation of the at least partial floor plan for the building for inclusion on a map at one or more map locations corresponding to the determined one or more GPS location data points for the one or more positions.

2. The non-transitory computer-readable medium of claim 1 wherein the stored contents include software instructions that, when executed by the one or more computing devices, cause the one or more computing devices to perform further automated operations including determining, by the one or more computing devices, a global transformation that maps data in a first data set to data in a second data set, the first data set including the positions in the at least partial floor plan of the first acquisition locations using the coordinate system local to the at least partial floor plan, and the second data set including the representative GPS location data points associated with the first acquisition locations, and wherein the converting of the local coordinates in the coordinate system local to the at least partial floor plan to the one or more GPS location data points includes using the global transformation.

3. The non-transitory computer-readable medium of claim 1 wherein the stored contents include software instructions that, when executed by the one or more computing devices, cause the one or more computing devices to perform further automated operations including determining, by the one or more computing devices, a global transformation that maps data in a first data set to data in a second data set, the first data set including the positions in the at least partial floor plan of the first acquisition locations using the coordinate system local to the at least partial floor plan, and the second data set including the representative GPS location data points associated with the first acquisition locations, and wherein the converting of the local coordinates in the coordinate system local to the at least partial floor plan to the one or more GPS location data points includes:
determining, by the one or more computing devices, a revised representative GPS location data point for each of at least some of the first acquisition locations based on the global transformation; and
extending, by the one or more computing devices, GPS location data from each of one or more of the at least some first acquisition locations to one or more walls of the room shape of the room in which that first acquisition location is positioned, wherein walls to which the GPS location data is extended include one or more external walls of the building that have the one or more positions on the at least partial floor plan.

4. The non-transitory computer-readable medium of claim 1 wherein the visual representation of the at least partial floor plan is at least one of a twodimensional floor plan model or a three-dimensional floor plan model, and wherein the determining of the one or more GPS location data points for the one or more positions on the at least partial floor plan includes determining the one or more GPS location data points for one or more positions corresponding to one or more external walls of the building.

5. The non-transitory computer-readable medium of claim 1 wherein capturing of the multiple GPS location data points at the multiple second locations by the mobile capture device includes capturing additional GPS location data points in the one room at additional times, and wherein the automated operations further include selecting the multiple GPS location data points for the determining of the representative GPS location data for the first acquisition location in the one room based at least in part on the multiple GPS location data points being captured within the defined amount of time of the acquisition of the image in the one room.

6. The non-transitory computer-readable medium of claim 5 wherein the camera device lacks any GPS receivers, wherein the automated operations further include, before the selecting of the multiple GPS location data points, performing smoothing operations on the additional GPS location data points that include removing one or more of the additional GPS location data points that each is determined to be an outlier, and wherein the determining of the representative GPS location data point associated with the first acquisition location in the one room includes:
retrieving, by the one or more computing devices, the time of acquisition of the image acquired at the first acquisition location in the one room;
selecting, by the one or more computing devices, the multiple GPS location data points associated with the first acquisition location in the one room based at least in part on the multiple GPS location data points having capture times that are within a defined time window around the retrieved acquisition time, the defined time window being based on the defined amount of time; and
generating, by the one or more computing devices, the representative GPS location data point associated with the first acquisition location in the one room based at least in part on combining location data of the multiple GPS location data points for the multiple second capture locations in the one room.

7. The non-transitory computer-readable medium of claim 1 wherein the determining of the representative GPS location data point associated with the first acquisition location in one of the multiple rooms includes selecting, by the one or more computing devices, one of the multiple GPS location data points captured in the one room to use as the representative GPS location data point associated with the first acquisition location in the one room, the selecting being based at least in part on time of capture of the one GPS location data point and on time of the acquisition of the image in the one room.

8. The non-transitory computer-readable medium of claim 1 wherein the obtaining of the at least partial floor plan includes determining, for each of the multiple rooms, a room shape of that room including at least some of the walls of that room and a position within that room shape of the first acquisition location in that room, and further includes positioning the room shapes of the multiple rooms relative to each other.

9. The non-transitory computer-readable medium of claim 1 wherein the providing of the visual representation of the at least partial floor plan for the building includes overlaying, by the one or more computing devices, the visual representation of the at least partial floor plan on the map at the one or more map locations corresponding to the determined one or more GPS location data points for the one or more positions, the map covering an area larger than a property on which the building is located, and further includes transmitting the map with the overlaid visual representation to a client device for display.

10. The non-transitory computer-readable medium of claim 1 wherein the automated operations further include:
obtaining, by the one or more computing devices, a plurality of additional GPS location data points that are external to the building and are captured by the mobile capture device on a property on which the building is located; and
determining, by the one or more computing devices, at least one of the plurality of additional GPS location data points to represent an external doorway of the building, the determining based on analyzing additional visual data of one or more additional acquired images that includes the external doorway to determine when the mobile capture device is proximate to the external doorway,
and wherein at least one of the determining of the one or more GPS location data points for the one or more positions on the at least partial floor plan, or positioning of the visual representation of the at least partial floor plan for the building on the map, is further based in part on the determined at least one additional GPS location data point to represent the external doorway.

11. The non-transitory computer-readable medium of claim 1 wherein the automated operations further include:
obtaining, by the one or more computing devices, a plurality of additional GPS location data points that are external to the building and are captured by the mobile capture device on a property on which the building is located, wherein the plurality of the additional GPS location data points are captured during a traversal of an exterior boundary of the building; and
determining, by the one or more computing devices, at least one of a shape or a position of the exterior boundary of the building based at least in part on the plurality of additional GPS location data points,
and wherein at least one of the determining of the one or more GPS location data points for the one or more positions on the at least partial floor plan, or positioning of the visual representation of the at least partial floor plan for the building on the map, is further based in part on the determined at least one of the shape or the position of the exterior boundary.

12. The non-transitory computer-readable medium of claim 1 wherein the automated operations further include:
obtaining, by the one or more computing devices, a plurality of additional GPS location data points that are external to the building and are captured by the mobile capture device on a property on which the building is located, wherein the plurality of the additional GPS location data points are captured during a traversal of an exterior walkway to the building and correspond to a substantially straight line; and
determining, by the one or more computing devices, a position of the exterior walkway based at least in part on the plurality of additional GPS location data points,
and wherein at least one of the determining of the one or more GPS location data points for the one or more positions on the at least partial floor plan, or positioning of the visual representation of the at least partial floor plan for the building on the map, is further based in part on the determined position of the exterior walkway.

13. The non-transitory computer-readable medium of claim 1 wherein the automated operations further include, before the obtaining of the plurality of GPS location data points in the multiple rooms:
providing, by the one or more computing devices, instructions related to a movement pattern of the mobile capture device externally to the building to enable an improved accuracy of the plurality of GPS location data points in the multiple rooms during their subsequent capture; and
obtaining, by the one or more computing devices, a plurality of additional GPS location data points that are captured by the mobile capture device corresponding to the movement pattern of the mobile capture device externally to the building.

14. A computer-implemented method comprising:
obtaining, by one or more computing devices, a plurality of images and a plurality of GPS (global positioning system) location data points in multiple rooms of a building, including, for each of the multiple rooms, one or more images of the plurality of images that are acquired by a camera device at a first acquisition location in that room and have visual coverage of walls of that room, and multiple GPS location data points of the plurality of GPS location data points that are concurrently captured at multiple second capture locations in that room by a mobile capture device moved independently from the camera device;
obtaining, by the one or more computing devices and based on visual data of the plurality of images, a floor plan for the building and information about positions on the floor plan of the first acquisition locations that use a coordinate system local to the floor plan, including determining, for each of the multiple rooms, a room shape of that room including at least some of the walls of that room and a position within that room shape of the first acquisition location in that room, and further including positioning the room shapes of the multiple rooms relative to each other;
determining, by the one or more computing devices and for each of the multiple rooms, a representative GPS location data point associated with the first acquisition location in that room, including identifying two or more candidate GPS location data points from the multiple GPS location data points captured in that room using capture times of the two or more candidate GPS location data points, and using the two or more candidate GPS location data points to produce the representative GPS location data point for the first acquisition location in that room;
determining, by the one or more computing devices, a global transformation that maps data in a first data set to data in a second data set, the first data set including the positions in the floor plan of the first acquisition locations using the coordinate system local to the floor plan, and the second data set including the representative GPS location data points associated with the first acquisition locations;
determining, by the one or more computing devices, one or more GPS location data points for one or more positions on the floor plan corresponding to one or more locations on external walls of the building, including using the global transformation to convert, for the one or more positions on the one or more external walls, local coordinates in the coordinate system local to the floor plan for the one or more positions to the one or more GPS location data points; and
providing, by the one or more computing devices, a visual representation of the floor plan for the building that is overlaid on a map at map locations corresponding to the determined one or more GPS location data points for the one or more positions on the one or more external walls of the building.

15. A system comprising:
one or more hardware processors of one or more computing devices; and
one or more memories with stored instructions that, when executed by at least one of the one or more hardware processors, cause at least one of the one or more computing devices to perform the automated operations of any one of claims 1-13.

16. A computer-implemented method comprising:
obtaining, by one or more computing devices, a floor plan for a building with multiple rooms and information about a plurality of GPS (global positioning system) location data points captured during traversal of an interior of the multiple rooms, the floor plan including room shapes of the multiple rooms positioned relative to each other;
determining, by the one or more computing devices and based at least in part on the plurality of GPS location data points, one or more GPS location data points for one or more locations on the floor plan corresponding to at least one external wall of the building, including extending one or more of the captured GPS data points from the interior of the multiple rooms to the at least one external wall of the building;
determining, by the one or more computing devices and based at least in part on the determined one or more GPS location data points for the one or more locations on the floor plan, positions that correspond to the floor plan on a map of an area including the building;
determining, by the one or more computing devices and based at least in part on the determined positions on the map, one or more levels of detail for interior portions of the building to display on the map for each of one or more stories of the building; and
presenting, by the one or more computing devices and as part of a graphical user interface (GUI), the map with a visual representation of the floor plan that is overlaid on the map at the determined positions and that includes visual indications for the interior portions of the building with the determined one or more levels of detail and including at least interior walls of the multiple rooms.

17. A system comprising:
one or more hardware processors of one or more computing devices; and
one or more memories with stored instructions that, when executed by at least one of the one or more hardware processors, cause at least one of the one or more computing devices to perform automated operations including at least:
obtaining, for a building with multiple rooms, at least a partial floor plan for the building that includes room shapes for one or more rooms of the multiple rooms, and information about a plurality of absolute location data points captured in the one or more rooms;
determining, based at least in part on the plurality of absolute location data points, one or more absolute location data points for one or more locations on the at least partial floor plan;
determining, based at least in part on the determined one or more absolute location data points for the one or more locations on the at least partial floor plan, positions that correspond to the at least partial floor plan on a map of an area including the building;
determining one or more levels of detail for interior portions of the building to display on the map for each of one or more stories of the building; and
presenting the map with a visual representation of the at least partial floor plan that is shown at the determined positions on the map and that includes data corresponding to the determined one or more levels of detail for the interior portions of the building.

18. A non-transitory computer-readable medium having stored contents that cause one or more computing devices to perform automated operations including at least:
obtaining, by one or more computing devices, a floor plan for a building with multiple rooms and information about a plurality of GPS (global positioning system) location data points captured during traversal of the multiple rooms, the floor plan including room shapes of the multiple rooms positioned relative to each other;
determining, by the one or more computing devices and based at least in part on the plurality of GPS location data points, one or more GPS location data points for one or more locations on the floor plan corresponding to at least one external wall of the building;
determining, by the one or more computing devices and based at least in part on the determined one or more GPS location data points for the one or more locations on the floor plan, positions that correspond to the floor plan on a map of an area including the building;
retrieving, by the one or more computing devices, additional information about the building of multiple types; and
presenting, by the one or more computing devices and as part of a graphical user interface (GUI), the map with a visual representation of the floor plan that is overlaid at the determined positions in a first section of the GUI, and additional sections of the GUI that each includes at least some additional information for a respective one of the multiple types.

19. A computer-implemented method comprising:
obtaining, by one or more computing devices and for a building on a property, at least a partial floor plan for the building that includes room shapes for one or more rooms of the building, and first information about a plurality of absolute location data points captured in the one or more rooms, and second information about one or more external features on the property and outside of the building;
determining, by the one or more computing devices and based at least in part on the plurality of absolute location data points, one or more absolute location data points for one or more locations on the at least partial floor plan;
determining, by the one or more computing devices and based at least in part on the determined one or more absolute location data points for the one or more locations on the at least partial floor plan, positions that correspond to the at least partial floor plan on a map including the property;
determining, by the one or more computing devices and for each of the one or more external features, a location on the property of that external feature; and
presenting, by the one or more computing devices, the map with a visual representation of the at least partial floor plan that is shown at the determined positions on the map, and further with, for each of the one or more external features, an additional visual representation of that external feature at the determined location on the property of that external feature.
